(19) Europäisches Patentamt
European Patent Office
Office européen des brevets

(11) **EP 2 777 164 B1**

(12) **EUROPEAN PATENT SPECIFICATION**

(45) Date of publication and mention of the grant of the patent:
**17.10.2018 Bulletin 2018/42**

(51) Int Cl.:
*H03M 13/11* *(2006.01)*

(21) Application number: **12848353.4**

(22) Date of filing: **09.11.2012**

(86) International application number:
**PCT/KR2012/009466**

(87) International publication number:
**WO 2013/070022 (16.05.2013 Gazette 2013/20)**

(54) **Generation of a low-density parity check matrix from a base matrix by lifting, scaling and row separation**

Erzeugung einer low-density Prüfmatrix aus einer Basismatrix durch Anhebung, Skalierung und Zeilenteilung

Génération d'une matrice de contrôle de parité à faible densité à partir d'une matrice de base par levage, mise à l'échelle et séparation des rangées

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.11.2011 KR 20110117855**
**08.10.2012 KR 20120111459**

(43) Date of publication of application:
**17.09.2014 Bulletin 2014/38**

(73) Proprietor: **Samsung Electronics Co., Ltd.**
**Suwon-si, Gyeonggi-do 443-742 (KR)**

(72) Inventors:
• **YANG, Hyun-Koo**
  **Gyeonggi-do 443-742 (KR)**
• **HWANG, Sung-Hee**
  **Gyeonggi-do 443-742 (KR)**
• **MYUNG, Seho**
  **Gyeonggi-do 443-742 (KR)**

(74) Representative: **Nederlandsch Octrooibureau**
**P.O. Box 29720**
**2502 LS The Hague (NL)**

(56) References cited:
**WO-A1-2006/057879     WO-A1-2010/022602**
**CN-A- 101 753 149      KR-A- 20090 093 778**
**US-A1- 2010 023 838**

• **HYEONG-GUN JOO ET AL: "New Construction of Rate-Compatible Block-Type Low-Density Parity-Check Codes Using Splitting", PROC. IEEE 17TH INTERNATIONAL SYMPOSIUM ON PERSONAL, INDOOR AND MOBILE RADIO COMMUNICATIONS 2006, 1 September 2006 (2006-09-01), pages 1-5, XP031023722, ISBN: 978-1-4244-0329-5**
• **JONG-EE OH ET AL: "Row-splitting design of Low-Density Parity-Check Codes for Gbps wireless transmission", PROC. 2ND INTERNATIONAL CONFERENCE ON WIRELESS BROADBAND AND ULTRA WIDEBAND COMMUNICATIONS 2007, 1 August 2007 (2007-08-01), pages 1-5, XP031132761, ISBN: 978-0-7695-2842-7**
• **NICOLA MOSCHINI ET AL: "STMicroelectronics LDPCC Proposal for 802.11n CFP", INTERNET CITATION, 13 August 2004 (2004-08-13), pages 1-30, XP002696798, Retrieved from the Internet: URL:https://mentor.ieee.org/802.11/dcn/04/11-04-0900-01-000n-stmicro-ldpcc-partial-p roposal-presentation.ppt [retrieved on 2013-05-10]**

EP 2 777 164 B1

• **VILA CASADO A I ET AL: "Multiple rate low-density parity-check codes with constant blocklength", CONFERENCE RECORD OF THE THIRTY- EIGHTH ASILOMAR CONFERENCE ON SIGNALS, SYSTEMS AND COMPUTERS, PACIFIC GROVE, CA, USA NOV. 7-10, 2004, PISCATAWAY, NJ, USA,IEEE, vol. 2, 7 November 2004 (2004-11-07), pages 2010-2014, XP010781157, DOI: 10.1109/ACSSC.2004.1399517 ISBN: 978-0-7803-8622-8**

## Description

### Technical Field

The present invention relates to an apparatus and method for transmitting and receiving a quasi-cyclic Low Density Parity Check (LDPC) code in a multimedia communication system, and more particularly to a quasi-cyclic LDPC code transmission and reception apparatus and method that support various codeword lengths and code rates.

### Background Art

A multimedia communication system, for example, a Moving Picture Experts Group (MPEG) Media Transport (MMT) system provides various large-capacity content, such as High Definition (HD) content, Ultra High Definition (UHD) content, etc. Further, according to a diversification of this content and especially increases in large-capacity content, data congestion has become a more serious issue. As a result of the data congestion, content transmitted by a signal transmission device is not always completely transferred to a signal reception device, and some of the content is lost en route.

In general, data is transmitted on a packet basis, and accordingly, data loss is generated on a transmission packet basis. For example, if the transmission packet is lost on a network, the signal reception device cannot receive the lost transmission packet, and thus, cannot know the data within the lost transmission packet. As a result, user inconvenience occurs, such as audio quality deterioration, video quality deterioration, video break, caption omissions, file loss, etc.

Therefore, the MMT system may enhance system reliability using various error-control schemes in order to reduce information data loss that is often caused by an error that occurs on a network according to channel status. A typical example of an error-control scheme is an Application Layer-Forward Error Correction (AL-FEC) scheme.

However, a multimedia communication system, such as an MMT system, requires usage of a Forward Error Correction (FEC) code supporting a codeword length and a code rate, which vary according to a code rate and delay time required by a service.

Further, when a conventional AL-FEC scheme is used, a signal transmission and reception apparatus should use different FEC codes according to a codeword length and a code rate, thereby increasing the complexity of the MMT system.

Consequently, it is difficult to implement an MMT system due to this increased complexity.

HYEONG-GUN JOO ET AL: "New Construction of Rate-Compatible Block-Type Low-Density Parity-Check Codes Using Splitting", PROC. IEEE 17TH INTERNATIONAL SYMPOSIUM ON PERSONAL, INDOOR AND MOBILE RADIO COMMUNICATIONS 2006, 1 September 2006, discloses a system using block-type LDPC codes obtained by splitting rows of a parity check matrix.

JONG-EE OH ET AL: "Row-splitting design of Low-Density Parity-Check Codes for Gbps wireless transmission", PROC. 2ND INTERNATIONAL CONFERENCE ON WIRELESS BROADBAND AND ULTRA WIDEBAND COMMUNICATIONS 2007, 1 August 2007, discloses LDPC codes that use row splitting and shortening techniques.

NICOLA MOSCHINI ET AL: "STMicroelectronics LDPCC Proposal for 802.1 In CFP", INTERNET CITATION, 13 August 2004, discloses rate-compatible LDPC codes.

VILA CASADO A I ET AL: "Multiple rate low-density parity-check codes with constant blocklength", CONFERENCE RECORD OF THE THIRTY- EIGHTH ASILOMAR CONFERENCE ON SIGNALS, SYSTEMS AND COMPUTERS, PACIFIC GROVE, CA, USA NOV. 7-10, 2004, PISCATAWAY, NJ, USA, IEEE, vol. 2, 7 November 2004, discloses LDPC codes that use combinations of the parity check matrix rows for the lowest rate code.

### Disclosure of invention

### Technical Problem

Accordingly, the present invention is designed to address at least the problems and/or disadvantages described above and to provide at least the advantages described below.

An aspect of the present invention is to provide an apparatus and method for transmitting and receiving a quasi-cyclic LDPC code in a multimedia communication system.

Another aspect of the present invention is to provide a quasi-cyclic LDPC code transmission and reception apparatus and method that support various codeword lengths in a multimedia communication system.

Another aspect of the present invention is to provide a quasi-cyclic LDPC code transmission and reception apparatus and method that support various code rates in a multimedia communication system.

Another aspect of the present invention is to provide a quasi-cyclic LDPC code transmission and reception apparatus and method that support various codeword lengths using a scaling scheme.

Another aspect of the present invention is to provide a quasi-cyclic LDPC code transmission/reception apparatus and method that support various code rates using a row separation scheme and a puncturing scheme in a multimedia communication system.

## Solution to problem

The invention provides a method for transmitting a low density parity check (LDPC) codeword as defined in the attached claims 1 and 2. The invention further provides a method for receiving an LDPC codeword as defined in the attached claims 3 and 4. The invention also provides a signal transmission and a signal reception apparatus as defined in claims 5 and 6, respectively.

## Advantageous Effects of Invention

As is apparent from the foregoing description, various embodiments of the present invention provide quasi-cyclic LDPC code transmission and reception supporting various codeword lengths and code rates in a multimedia communication system. Further, the above-described embodiments of the present invention provide quasi-cyclic LDPC code encoding and decoding that support various codeword lengths using a scaling scheme and a shortening scheme in a multimedia communication system, and support various code rates using a row separation scheme or a row merge scheme, and a puncturing scheme in a multimedia communication system.

## Brief Description of Drawings

The above and other aspects, features, and advantages of certain embodiments of the present invention will be more apparent from the following detailed description taken in conjunction with the accompanying drawings, in which:

FIG. 1 is a block diagram illustrating a quasi-cyclic LDPC code generator included in a signal transmission apparatus in an MMT system according to an embodiment of the present invention;
FIG. 2 is a block diagram illustrating a parity check matrix generator according to an embodiment of the present invention ;
FIG. 3 schematically illustrates a row separation process according to an embodiment of the present invention;
FIG. 4 schematically illustrates a row merge process according to an embodiment of the present invention;
FIG. 5 is a block diagram illustrating a quasi-cyclic LDPC encoder according to an embodiment of the present invention;
FIG. 6 is a block diagram illustrating a quasi-cyclic LDPC code decoder included in a signal reception apparatus in an MMT system according to an embodiment of the present invention;
FIG. 7 is a flowchart illustrating an operation process of a quasi-cyclic LDPC code generator included in a signal transmission apparatus in an MMT system according to an embodiment of the present invention; and
FIG. 8 a flowchart illustrating an operation process of a quasi-cyclic LDPC code decoder included in a signal reception apparatus in an MMT system according to an embodiment of the present invention.

Throughout the drawings, the same drawing reference numerals will be understood to refer to the same elements, features and structures.

## Best Mode for Carrying out the Invention

Various embodiments of the present invention will now be described in detail with reference to the accompanying drawings. In the following description, specific details such as detailed configuration and components are merely provided to assist the overall understanding of these embodiments of the present invention. Therefore, it should be apparent to those skilled in the art that various changes and modifications of the embodiments described herein can be made without departing from the scope and spirit of the present invention. In addition, descriptions of well-known functions and constructions are omitted for clarity and conciseness.

Although embodiments of the present invention will be described below with reference to an MPEG MMT system, it will be understood by those of ordinary skill in the art that the present invention is also applicable to any one of a Long-Term Evolution (LTE) mobile communication system, a Long-Term Evolution Advanced (LTE-A) mobile communication system, and an Institute of Electrical and Electronics Engineers (IEEE) 802.16m communication system.

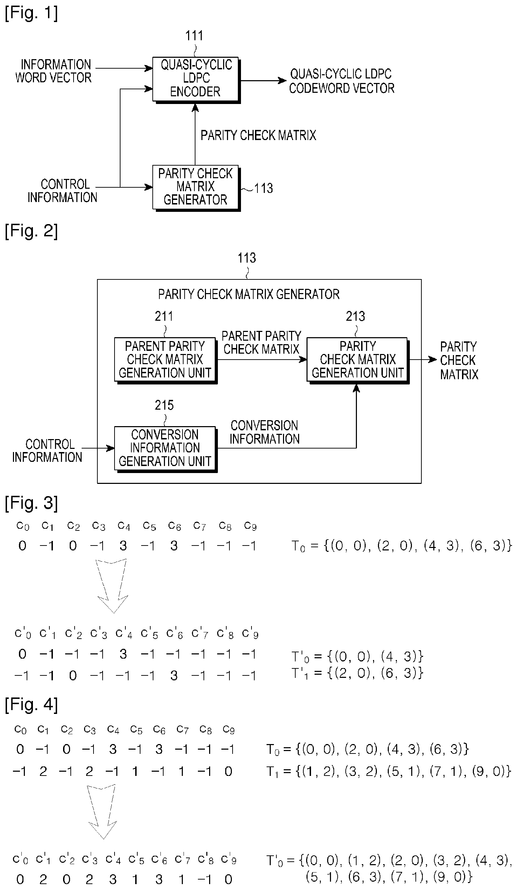

FIG. 1 is a block diagram illustrating a quasi-cyclic LDPC code generator included in a signal transmission apparatus in an MMT system according to an embodiment of the present invention.

Referring to FIG. 1, a quasi-cyclic LDPC code generator includes a quasi-cyclic LDPC encoder 111 and a parity check matrix generator 113. An information word vector is input to the quasi-cyclic LDPC encoder 111. The information word vector includes k information symbols. Additionally, control information including includes (k,n,m) information is input to the quasi-cyclic LDPC encoder 111, where k denotes a number of information word symbols included in the information word vector, n denotes a number of codeword symbols, i.e., quasi-cyclic LDPC codeword symbols, included in a codeword vector, i.e., a quasi-cyclic LDPC codeword vector, and m denotes a number of parity symbols included in a parity vector.

The parity check matrix generator 113 also receives the control information, converts a prestored base matrix into a parity check matrix, based on the control information, and outputs the converted parity check matrix to the quasi-cyclic LDPC encoder 111.

The quasi-cyclic LDPC encoder 111 generates a quasi-cyclic LDPC codeword vector by quasi-cyclic LDPC encoding the information word vector using the received control information and converted parity check matrix.

Although FIG. 1 illustrates the parity check matrix generator 113 generating the parity check matrix and outputting the parity check matrix to the quasi-cyclic LDPC encoder 111, alternatively, the quasi-cyclic LDPC encoder 111 may prestore the parity check matrix, and in this case, the parity check matrix generator 113 is not utilized.

Additionally, although FIG. 1 illustrates the control information being input from the outside to the quasi-cyclic LDPC encoder 111 and the parity check matrix generator 113, alternatively, the quasi-cyclic LDPC encoder 111 and the parity check matrix generator 113 may prestore the control information, and in this case, need not receive the control information from the outside.

Further, although FIG. 1 illustrates the quasi-cyclic LDPC encoder 111 and the parity check matrix generator 113 are shown in FIG. 1 as separate units, the quasi-cyclic LDPC encoder 111 and the parity check matrix generator 113 may also be incorporated into a single unit.

Although not illustrated, a signal transmission apparatus includes the quasi-cyclic LDPC code generator and a transmitter, and the quasi-cyclic LDPC code generator and the transmitter may be incorporated into a single unit.

FIG. 2 is a block diagram illustrating a parity check matrix generator according to an embodiment of the present invention.

Referring to FIG. 2, a parity check matrix generator 113 includes a parent parity check matrix generation unit 211, a parity check matrix generation unit 213, and a conversion information generation unit 215. The parent parity check matrix generation unit 211 reads a parent parity check matrix from an internal storage unit, or generates the parent parity check matrix using a preset scheme, and outputs the parent parity check matrix to the parity check matrix generation unit 213.

In accordance with an embodiment of the present invention, a parent parity check matrix Q is generated using a base matrix B, which includes K columns and M rows, and each of K columns maps to an information symbol block. Each element included in the base matrix B has a value of 0 or 1, and locations of elements with a value of 1 in each of the M rows may be expressed as a sequence, as shown in Equation (1).

$$R_i = \{j \mid 0 \leq j < K, B_{i,j} = 1\} = \{r_{i,0}, r_{i,1}, ..., r_{i,Di-1}\} \quad \dots (1)$$

In Equation (1), j denotes a column index, i denotes a row index, $R_i$ denotes a sequence indicating locations on which elements have value 1 on the base matrix B, $B_{i,j}$ denotes elements included in the base matrix B, and $r_{i,Di-1}$ denotes elements included in the $R_i$. The $D_i$ denotes a degree of the ith row.

For a base matrix B including 10 columns and 4 rows, the base matrix B may be expressed as shown in Equation (2).

$$\begin{bmatrix} 1 & 0 & 1 & 0 & 1 & 0 & 1 & 0 & 0 & 0 \\ 0 & 1 & 0 & 1 & 0 & 1 & 0 & 1 & 0 & 1 \\ 0 & 1 & 1 & 0 & 1 & 0 & 0 & 1 & 1 & 0 \\ 1 & 0 & 0 & 0 & 0 & 1 & 1 & 0 & 0 & 1 \end{bmatrix} \quad \dots (2)$$

Each of $R_0$ to $R_3$ in Equation (2) is expressed as shown in Equation (3).

$$R_0 = \{0, 2, 4, 6\} \quad \cdots (3)$$
$$R_1 = \{1, 3, 5, 7, 9\}$$
$$R_2 = \{1, 2, 4, 7, 8\}$$
$$R_3 = \{0, 5, 6, 9\}$$

The parent parity check matrix Q includes K x L columns and M x L rows, and is generated by substituting one of an L x L permutation matrix and an L x L zero matrix for each element $B_{i,j}$ included in the base matrix B. The L x L permutation matrix is expressed as shown in Equation (4), and the L x L zero matrix is expressed as shown in Equation (5).

$$Q_{i,j} = \begin{bmatrix} 0 & 1 & 0 & \cdots & 0 \\ 0 & 0 & 1 & \cdots & 0 \\ \vdots & \vdots & \vdots & \ddots & \vdots \\ 0 & 0 & 0 & \cdots & 1 \\ 1 & 0 & 0 & \cdots & 0 \end{bmatrix}^P \quad \cdots (4)$$

In Equation (4), P denotes an exponent, a related permutation matrix is an identity matrix if P = 0, and a related permutation matrix is a zero matrix if P = -1.

$$Q_{i,j} = \begin{bmatrix} 0 & 0 & 0 & \cdots & 0 \\ 0 & 0 & 0 & \cdots & 0 \\ \vdots & \vdots & \vdots & \ddots & \vdots \\ 0 & 0 & 0 & \cdots & 0 \\ 0 & 0 & 0 & \cdots & 0 \end{bmatrix} \quad \cdots (5)$$

For example, the parent parity check matrix Q may be expressed as shown in Equation (6).

$$\begin{bmatrix} 0 & -1 & 0 & -1 & 3 & -1 & 3 & -1 & -1 & -1 \\ -1 & 2 & -1 & 2 & -1 & 1 & -1 & 1 & -1 & 0 \\ -1 & 3 & 1 & -1 & 0 & -1 & -1 & 2 & 3 & -1 \\ 1 & -1 & -1 & -1 & -1 & 2 & 0 & -1 & -1 & 1 \end{bmatrix} \quad \cdots (6)$$

In Equation (6), each permutation matrix is expressed as shown in Equation (7).

$$-1 \le P_{i,j} < L \quad \cdots (7)$$

In Equation (7), $P_{i,j}$ denotes an exponent of a permutation matrix arrayed on a location at which the ith row included in the base matrix B and the jth column included in the base matrix B crosses.
A location and an exponent of each of permutation matrixes included in the parent parity check matrix expressed in Equation (6) may be expressed as a sequence, as shown in Equation (8).

$$T_i = \{(j, P_{j,i}) \mid 0 \le j < K, P_{j,i} > -1\} \qquad \ldots (8)$$

$$= \{(t_{i,0}, e_{i,0}), (t_{i,1}, e_{i,1}), \ldots, (t_{j, Di-1}, e_{j, Di-1})\}$$

In Equation (8), $T_i$ denotes a sequence indicating locations at which permutation matrixes are arrayed on the parent parity check matrix, $t_{i,Di-1}$ denotes a location of a permutation matrix included in the ith row among permutation matrixes included in the parent parity check matrix Q, and $e_{i,Di-1}$ denotes an exponent of a permutation matrix arrayed on a related location, i.e., a location which $t_{i,Di-1}$ indicates.

Each of $T_0$ to $T_3$ is expressed as shown in Equation (9).

$$T_0 = \{(0, 0), (2, 0), (4, 3), (6, 3)\} \qquad \ldots (9)$$
$$T_1 = \{(1, 2), (3, 2), (5, 1), (7, 1), (9, 0)\}$$
$$T_2 = \{(1, 3), (2, 1), (4, 0), (7, 2), (8, 3)\}$$
$$T_3 = \{(0, 1), (5, 2), (6, 0), (9, 1)\}$$

The parent parity check matrix generation unit 211 reads the base matrix B from an internal storage unit, or generates the base matrix B using a preset scheme.

As described above, the parent parity check matrix generated by the parent parity check matrix generation unit 211 only includes columns corresponding to an information symbol vector, i.e., an information part.

The conversion information generation unit 215 inputs control information, generates conversion information, and outputs the conversion information to the parity check matrix generation unit 213. The conversion information may include a scaling factor, a row separation factor, or a row merge factor, and a row separation pattern or a row merge pattern. If the conversion information includes the row separation factor, the row separation pattern is included in the conversion information.

If the conversion information includes the row merge factor, the row merge pattern is included in the conversion information. It will be understood by those of ordinary skill in the art that the row separation pattern and the merge pattern may be implemented in various formats.

A scaling factor S1 is used for determining a size of a parity check matrix to be generated by the parity check matrix generation unit 213. That is, the scaling factor S1 is used for changing a size of permutation matrixes and zero matrixes included in the parent parity check matrix Q. Here, S1 denotes a maximum integer satisfying $k \le (K \times L)/S1$, where $S1 = 2^a$, and "a" denotes a maximum integer satisfying $k \le (K \times L)/S1$.

If the size of the permutation matrixes and zero matrixes included in the parent parity check matrix Q is L x L, the size of the parity check matrix to be generated by the parity check matrix generation unit 213 is L' x L' according to the scaling factor S1. Here, L' = L/S1.

A row separation factor S2 is used for separating rows included in the parent parity check matrix, when the parity check matrix generation unit 213 generates the parity check matrix. Here, $S2 = \text{ceil}(m/((M \times L)/S1))$, where $S2 = 2^b$, and b denotes a maximum integer satisfying $2^b \ge \text{ceil}(m/((M \times L)/S1))$.

For example, each of the rows included in the parent parity check matrix is separated into 2 rows, if the row separation factor S2 is 2.

FIG. 3 illustrates a row separation process according to an embodiment of the present invention.

Referring to FIG. 3, for the parent parity check matrix expressed in Equation (6), when a row separation factor S2 is 2, the first row 311 included in the parent parity check matrix is separated into 2 rows 313. In FIG. 3, C0 to C9 are indexes of each row of elements included in the first row 311, and C'0 to C'9 are indexes of each row of elements included in the 2 rows 313.

A matrix generated by performing a row separation operation and a scaling operation on a base matrix is equal to a matrix generated by performing the row separation operation on a parent parity check matrix, which is generated by performing the scaling operation on the base matrix. Therefore, a row separation pattern may be expressed using a row separated-base matrix or a row separated-parent parity check matrix.

A criterion for separating one row into n rows is shown in Equation (10).

$$1)\ T_0 = T'_0\ \cup\ T'_1\ \cup\ ...\ \cup\ T'_{n-1} \qquad ...\ (10)$$
$$2)\ T'_i \cap T'_j\ =\ \{\}\ \text{for all } 0 \leq i \neq j < n$$

When Equation (10) is satisfied, one row is separated into n rows. That is, one row is separated into n rows expressed as shown in Equation (11).

$$T_0 \rightarrow T'_0,\ T'_1,\ ...,\ T'_{n-1} \qquad ...\ (11)$$

The row merge factor S3 is used for merging rows included in the parent parity check matrix, when the parity check matrix generation unit 213 generates the parity check matrix. Here, $S3 = ceil(((MxL)/S1)/m))$, $S3 = 2^c$, and c denotes a maximum integer satisfying $2^c \geq ceil(((MxL)/S1)/m))$.

For example, the rows included in the parent parity check matrix are merged on two-row basis, if the row merge factor S3 is 2.

FIG. 4 illustrates a row merge process according to an embodiment of the present invention.

Referring to FIG. 4, for the parent parity check matrix in Equation (6), when a row merge factor S3 is 3, the first row and the second row 411 included in the parent parity check matrix are merged into one row 413. In FIG. 4, C0 to C9 are indexes of each row of elements included in the first row and the second row 411, and C'0 to C'9 are indexes of each row of elements included in one row 413.

A matrix generated by performing a row merge operation and a scaling operation on a base matrix is equal to a matrix generated by performing the row merge operation on a parent parity check matrix, which is generated by performing the scaling operation on the base matrix. Therefore, a row merge pattern may be expressed using a row merged-base matrix or a row merged-parent parity check matrix.

A criterion for merging n rows into one row is expressed as shown in Equation (12).

$$T_i \cap T_j\ =\ \{\}\ \text{for all } 0 \leq i \neq j < n$$
$$T'_0 = T_0\ \cup\ T_1\ \cup\ ...\ \cup\ T_{n-1} \qquad ...\ (12)$$

When the criterion expressed in Equation (12) is satisfied, n rows are merged into one row. That is, n rows are merged into one row as shown in Equation (13).

$$T_0,\ T_1,\ ...,\ T_{n-1} \rightarrow T'_0 \qquad ...\ (13)$$

If a row separation operation according to a row separation factor is performed, a row merge operation according to a row merge factor is not performed. If a row merge operation according to a row merge factor is performed, a row separation operation according to a row separation factor is not performed.

If a parity check matrix is generated according to a row merge factor or a row separation factor, a location and an exponent of each permutation matrix included in the parity check matrix are expressed as shown in Equation (14).

$$(t'_{i,\,j},\ e'_{i,\,j}) = (t_{i,\,j},\ f(e_{i,\,j},\ L,\ S1)) \qquad ...\ (14)$$

The parity check matrix generation unit 213 converts the parent parity check matrix output from the parent parity check matrix generation unit 211 into a parity check matrix using the conversion information output from the conversion information generation unit 215.

If a parity check matrix generated by the parity check matrix generation unit 213 is H, the parity check matrix H includes $H_I$ and $H_P$, $H_I$ is a matrix corresponding to an information word vector, and $H_P$ is a matrix corresponding to a parity vector. $H_I$ is a parent parity check matrix generated by the parent parity check matrix generation unit 211, and a quasi-cyclic matrix. $H_P$ is an encoding matrix, and includes M' x L' columns and M' x L' rows. Here, $H_P$ need not be a quasi-cyclic matrix, and may be one of a bit-wise dual diagonal (accumulator) matrix as shown in Equation (15), a block-wise dual diagonal matrix as shown in Equation (16), and a quasi-cyclic Block LDPC (BLDPC) used in an IEEE 802.16e communication system as shown in Equation (17).

$$\begin{bmatrix} 1 & 0 & 0 & \cdots & 0 & 0 \\ 1 & 1 & 0 & \cdots & 0 & 0 \\ \vdots & \vdots & \vdots & \ddots & \vdots & \vdots \\ 0 & 0 & 0 & \cdots & 1 & 1 \\ 0 & 0 & 0 & \cdots & 0 & 1 \end{bmatrix} \quad \cdots (15)$$

$$\begin{bmatrix} 0 & -1 & -1 & \cdots & -1 & -1 \\ 0 & 0 & -1 & \cdots & -1 & -1 \\ \vdots & \vdots & \vdots & \ddots & \vdots & \vdots \\ -1 & -1 & -1 & \cdots & 0 & 0 \\ -1 & -1 & -1 & \cdots & -1 & 0 \end{bmatrix} \quad \cdots (16)$$

L' X L' matrix

$$\begin{bmatrix} a & 0 & -1 & \cdots & -1 & -1 \\ -1 & 0 & 0 & \cdots & -1 & -1 \\ \vdots & \vdots & \vdots & \ddots & \vdots & \vdots \\ b & -1 & -1 & \cdots & -1 & -1 \\ \vdots & \vdots & \vdots & \cdots & \vdots & \vdots \\ -1 & -1 & -1 & -1 & 0 & 0 \\ a & -1 & -1 & -1 & -1 & 0 \end{bmatrix} \quad \cdots (17)$$

L' X L' matrix

If an information word vector includes k symbols and a parity vector includes m parity symbols, the parity check matrix generation unit 213 substitutes l x l (l = L/S1) permutation matrixes and l x l (l = L/S1) zero matrixes for permutation matrixes and zero matrixes included in a parent parity check matrix Q. The substituted permutation matrix is shown in Equation (18).

$$p_{i,j} = f(P_{i,j}, L, S1) \cdots (18)$$

The parity check matrix generation unit 213 generates $H_I$ including M block rows by separating each block row included in a conversion parent parity check matrix including the substituted permutation and zero matrixes, based on a row separation factor S2, or merging block rows included in the conversion parent parity check matrix matrixes, based on a row merge factor S3.

The parity check matrix generation unit 213 generates a parity check matrix as shown in Equation (19) by concatenating $H_I$ and $H_P$.

$$H = [H_I \mid H_p] \cdots (19)$$

In Equation (19), $H_P$ includes M' x l rows and M' x l columns.

A permutation matrix is expressed in Equation (20).

$$1)\ f(P_{i,j},\ L,\ S1) = floor\ (P_{i,j}\ /S1)\quad \cdots (20)$$

$$2)\ f(P_{i,j},\ L,\ S1) = P_{i,j}\ mod\ (L/S1)$$

Although FIG. 2 illustrates the parent parity check matrix generation unit 211 generating the parent parity check matrix, the conversion information generation unit 215 generating the conversion information, and the parity check matrix generation unit 213 generating the parity check matrix using the parent parity check matrix and the conversion information, alternatively, the parity check matrix generation unit 213 may prestore the parent parity check matrix and the conversion information, and in this case, the parent parity check matrix generation unit 211 and the conversion information generation unit 215 are not utilized.

Additionally, Although FIG. 2 illustrates the parent parity check matrix generation unit 211, the parity check matrix generation unit 213, and the conversion information generation unit 215 as separate units, these components may be incorporated into a single unit.

Table 1

[Table 1]

| information word symbol number(k) | 10, 20, 40, 80 |
|---|---|
| code rate(k/n) | 10/12, 10/14, 10/16, 10/18 |

In Table 1, which shows design requirement criterion for an MMT system, the information word symbol number denotes a number of information word symbols that the MMT system should support. That is, the MMT system should support four types of information word symbol number, i.e., 10, 20, 40, and 80.

In Table 1, the code rate denotes the code rate that the MMT system should support. That is, the MMT system should support four types of code rate, i.e., 10/12, 10/14, 10/16, and 10/18.

The four types of code rate for each of the four types of information word symbol number should be supported, so 16 parity check matrixes will be used if the MMT system intends to design all of the quasi-cyclic LDPC codes satisfying the design requirement criterion described in Table 1.

The information word symbol number(k) 10, 20, 40, 80 described in Table 1 are in multiples one another, so a required parity symbol number for satisfying the code rate(k/n) 10/12, 10/14, 10/16, 10/18 descried in Table 1 are in multiples one another if the information word symbol number is determined.

In accordance with an embodiment of the present invention, the design requirement criterion in Table 1 is satisfied by performing a scaling operation and a row separation operation on a parent parity check matrix including 16(= 2 x 8) rows and 80(= 10 x 8) columns, which is generated by substituting an 8 x 8 permutation matrix for each element included in a base matrix including 2 rows and 10 columns.

For a base matrix expressed as in Equation (21), when the number of rows is 2 and the number of the columns is 10, a parent parity check matrix, which is generated by substituting an 8 x 8 permutation matrix for each element included in the base matrix in Equation (21), is expressed as shown in Equation (22).

$$R_0 = \{0, 1, 2, 3, 4\}$$
$$R_1 = \{5, 6, 7, 8, 9\} \dots (21)$$

$$T_0 = \{(0,0), (1,7), (2,4), (3,1), (4,6)\}$$
$$T_1 = \{(5,3), (6,0), (7,1), (8,6), (9,7)\} \dots (22)$$

A method for supporting various information word symbol numbers using a scaling scheme will be described with reference to a case in which a criterion 2) in Equation (20) is applied to the parent parity check matrix expressed in Equation (22).

information word symbol numbers 10, 20, and 40 may be supported by applying a permutation matrix substitution, in which a scaling factor S1 = 8, 4, and 2 is applied to the parent parity check matrix expressed in Equation (22), respectively.

Matrixes generated by applying a permutation matrix substitution, expressed as criterion 2) in Equation (20), in which a scaling factor S1 = 2 and 4 is applied to the parent parity check matrix expressed in Equation (22), respectively, are expressed as shown in Equations (23) to (24).

$$T_0 = \{(0,0), (1,3), (2,0), (3,1), (4,2)\}$$
$$T_1 = \{(5,3), (6,0), (7,1), (8,2), (9,3)\} \dots (23)$$

$$T_0 = \{(0,0), (1,1), (2,0), (3,1), (4,0)\}$$
$$T_1 = \{(5,1), (6,0), (7,1), (8,0), (9,1)\} \dots (24)$$

Parent parity check matrixes that support information word symbol numbers 40 and 20 are expressed in Equations (23) to (24), respectively. If the number of information word symbols is 10, L' = L / 8 = 1. Therefore, a parent parity check matrix is equal to a base matrix as expressed in Equation (21).

If the number of information word symbols is 80, parity symbol numbers that satisfy the design requirement criterion in Table 1 are 16, 32, 48, and 64 for 10/12, 10/14, 10/16, and 10/18, respectively. In an LDPC code, the number of parity symbols is equal to the number of parity check equations. Therefore, a code rate is 80/(80+16) = 10/12, if the parity check matrix in Equation (22) is used as a parent parity check matrix, and the code rates described in Table 1 are satisfied if each row included in the parity check matrix is separated into 2, 3, and 4 rows, respectively.

A row separation patter may be designed in various forms. However, in accordance with an embodiment of the present invention, a rule provided below is applied in order to provide a uniform degree of distribution for the columns in a parity check matrix, which is generated by applying a row separation scheme.

< row separation rule >

The jth row among rows that are generated by separating $T_i = \{(t_{i,0}, e_{i,0}), (t_{i,1}, e_{i,1}), \dots, (t_{i,D_i-1}, e_{i,D_i-1})\}$ into n rows corresponds to the (nxi +j)th row, and $T'_{n \times i+j} = \{(t_{i,k}, e_{i,k})|0 \leq k < D_i, k \bmod n = (n - 1 - j)\}$ if all rows included in a parent parity check matrix are separated into n rows, respectively.

Matrixes generated by applying a row separation factor S2 = 2, 3, and 4 to the parent parity check matrix as shown in Equation (22), respectively, are expressed as shown in Equations (25) to (27).

$$T'_0 = \{(1,1), (3,1)\}$$
$$T'_1 = \{(0,0), (2,0), (4,0)\}$$
$$T'_2 = \{(6,0), (8,0)\}$$
$$T'_3 = \{(5,1), (7,1), (9,1)\} \dots (25)$$

wherein Equation (25), $T'_0$, $T'_1$ denote columns that are generated by separating $T_0$ as shown in Equation (21), and $T'_2$ and $T'_3$ denote columns that are generated by separating $T_1$ as shown in Equation (22).

$$T'_0 = \{(2,4)\}$$
$$T'_1 = \{(1,7), (4,6)\}$$
$$T'_2 = \{(0,0), (3,1)\}$$
$$T'_3 = \{(7,1)\}$$
$$T'_4 = \{(6,0), (9,7)\}$$
$$T'_5 = \{(5,3), (8,6)\} \dots (26)$$

wherein Equation (26), $T'_0$, $T'_1$, and $T'_2$ denote columns that are generated by separating $T_0$ as shown in Equation (21),

and $T'_3$, $T'_4$, and $T'_5$ denote columns that are generated by separating $T_1$ as shown in Equation (22).

$$T'_0 = \{(3,1)\}$$
$$T'_1 = \{(2,4)\}$$
$$T'_2 = \{(1,7)\}$$
$$T'_3 = \{(0,0), (4,6)\}$$
$$T'_4 = \{(8,6)\}$$
$$T'_5 = \{(7,1)\}$$
$$T'_6 = \{(6,0)\}$$
$$T'7 = \{(5,3), (9,7)\} \dots (27)$$

wherein Equation (27), $T'_0$, $T'_1$, $T'_2$, and $T'_3$ denote columns that are generated by separating $T_0$ as shown in Equation (21), and $T'_4$, $T'_5$, $T'_6$, and $T'_7$ denote columns that are generated by separating $T_1$ as shown in Equation (22).

Table 2

[Table 2]

| information word symbol number (k) | 400, 800, 1600, 3200, 6400 |
| --- | --- |
| code rate(k/n) | 20/21, 20/22, 20/23, 20/24 |

In Table 2, which shows design requirement criterion for an MMT system, the information word symbol number denotes a number of information word symbols that the MMT system should support. That is, the MMT system should support five types of information word symbol numbers, i.e., 400, 800, 1600, 3200, and 6400.

In Table 2, the code rate denotes the code rate that the MMT system should support. That is, the MMT system should support five types of code rates, i.e., 20/21, 20/22, 20/23, and 20/24.

A base matrix including 20 rows and 400 columns, which is expressed using Equation (1), is expressed in Equation (28).

$$
\begin{aligned}
R_0 = \{&1, 2, 3, 5, 6, 7, 9, 12, 14, 15, 19, 20, 26, 34, 35, 38, 45, 46, 48, 56, 57, 62, 63, \\
&71, 75, 77, 78, 82, 83, 85, 88, 90, 92, 93, 97, 99, 104, 107, 110, 111, 116, 117, 120, \\
&121, 125, 127, 128, 129, 131, 134, 150, 152, 156, 158, 159, 161, 163, 164, 165, 168, \\
&171, 172, 175, 177, 180, 185, 193, 194, 195, 199, 200, 202, 204, 207, 212, 213, 214, \\
&217, 223, 224, 226, 227, 228, 232, 236, 240, 241, 245, 250, 251, 255, 260, 267, 268, \\
&272, 273, 275, 276, 278, 284, 288, 289, 291, 292, 297, 299, 302, 309, 310, 311, 312, \\
&326, 330, 334, 335, 337, 338, 340, 342, 343, 347, 349, 350, 351, 357, 361, 364, 365, \\
&367, 369, 373, 375, 376, 377, 379, 383, 384, 388, 389, 391\}
\end{aligned}
$$

$R_1 = \{$2, 5, 8, 10, 12, 13, 14, 17, 23, 24, 29, 30, 33, 37, 45, 46, 47, 56, 60, 65, 73, 77, 78, 81, 89, 94, 99, 100, 102, 107, 111, 112, 117, 125, 127, 128, 133, 134, 136, 137, 138, 141, 143, 155, 157, 158, 160, 161, 163, 169, 170, 174, 176, 177, 178, 180, 182, 186, 187, 188, 189, 191, 192, 196, 198, 199, 200, 202, 204, 207, 210, 214, 217, 221, 224, 226, 228, 233, 236, 239, 241, 246, 249, 251, 256, 257, 259, 263, 264, 266, 267, 270, 271, 280, 282, 285, 286, 291, 292, 295, 302, 305, 306, 308, 309, 311, 312, 315, 316, 321, 322, 323, 324, 327, 328, 338, 342, 343, 346, 347, 349, 356, 361, 363, 367, 369, 372, 373, 374, 376, 380, 382, 387, 389, 390, 392, 393, 394, 395, 397$\}$

$R_2 = \{$1, 2, 3, 5, 6, 12, 13, 15, 19, 20, 21, 22, 33, 36, 38, 39, 40, 43, 44, 46, 47, 48, 53, 57, 58, 59, 61, 70, 71, 73, 74, 79, 85, 86, 88, 89, 90, 92, 95, 99, 103, 104, 105, 1 115, 128, 130, 133, 136, 139, 142, 145, 155, 156, 160, 168, 171, 176, 182, 183, 185, 186, 191, 193, 199, 204, 205, 207, 213, 217, 224, 226, 228, 230, 233, 234, 236, 238, 239, 240, 246, 247, 248, 249, 250, 251, 253, 254, 258, 262, 264, 268, 270, 271, 274, 277, 280, 286, 287, 293, 294, 296, 297, 299, 301, 302, 304, 306, 308, 309, 314, 315, 316, 317, 322, 325, 326, 327, 331, 333, 334, 335, 345, 348, 351, 358, 360, 362, 363, 371, 375, 376, 378, 379, 387, 389, 394, 396, 399$\}$

$R_3 = \{$2, 3, 4, 7, 9, 14, 15, 18, 22, 29, 30, 32, 36, 40, 50, 53, 54, 55, 60, 64, 68, 70, 71, 75, 77, 81, 85, 90, 91, 95, 96, 100, 101, 103, 104, 105, 107, 108, 109, 110, 111, 113, 116, 121, 123, 124, 131, 132, 133, 136, 137, 140, 144, 145, 149, 152, 155, 159, 162, 164, 166, 167, 168, 171, 174, 176, 180, 181, 182, 183, 184, 188, 189, 190, 197, 199, 203, 209, 213, 215, 223, 232, 234, 235, 240, 244, 247, 248, 253, 254, 255, 256, 257, 260, 265, 266, 274, 278, 280, 281, 286, 288, 291, 292, 294, 295, 297, 299, 301, 304, 306, 314, 321, 322, 325, 327, 334, 336, 338, 346, 348, 351, 352, 353, 355, 364, 366, 369, 370, 371, 373, 374, 376, 377, 382, 386, 387, 389, 396, 399$\}$

$R_4 = \{$0, 1, 5, 16, 17, 18, 19, 21, 26, 28, 29, 31, 34, 36, 37, 39, 40, 44, 50, 55, 56, 58, 67, 72, 73, 74, 76, 78, 80, 81, 84, 87, 89, 93, 96, 99, 107, 108, 110, 114, 117, 118, 119, 120, 123, 125, 128, 132, 138, 140, 143, 147, 152, 155, 164, 167, 171, 173, 174, 175, 180, 181, 182, 188, 191, 195, 199, 200, 204, 206, 207, 208, 211, 212, 213, 217, 218, 222, 223, 228, 230, 231, 241, 242, 249, 253, 254, 255, 256, 257, 259, 261, 262, 264, 265, 268, 269, 275, 277, 278, 280, 285, 286, 289, 293, 295, 297, 298, 300, 307, 311, 315, 316, 318, 320, 324, 326, 338, 339, 342, 346, 347, 348, 356, 357, 358, 359, 360, 361, 363, 364, 365, 368, 371, 375, 385, 388, 389, 393, 398$\}$

$R_5$ = {1, 6, 8, 12, 18, 19, 21, 24, 25, 31, 34, 35, 37, 38, 40, 41, 43, 44, 45, 49, 53, 59, 61, 65, 72, 76, 83, 84, 86, 88, 101, 105, 108, 109, 113, 114, 115, 117, 119, 121, 122, 124, 129, 131, 132, 135, 136, 137, 139, 141, 142, 144, 148, 151, 154, 159, 166, 169, 175, 176, 183, 184, 186, 193, 194, 195, 196, 197, 205, 209, 210, 214, 217, 218, 219, 222, 223, 225, 227, 228, 229, 232, 235, 236, 241, 243, 245, 247, 248, 250, 262, 263, 266, 267, 272, 274, 275, 278, 281, 282, 287, 288, 291, 294, 298, 300, 303, 308, 309, 313, 317, 319, 325, 327, 329, 332, 333, 335, 336, 338, 350, 351, 353, 354, 355, 356, 359, 360, 362, 363, 366, 368, 373, 376, 378, 379, 383, 385, 388, 398}

$R_6$ = {4, 6, 7, 11, 13, 15, 16, 22, 27, 28, 31, 33, 34, 36, 38, 42, 43, 44, 54, 55, 57, 69, 70, 71, 73, 75, 76, 78, 80, 81, 84, 86, 87, 88, 93, 95, 101, 102, 103, 104, 107, 110, 111, 112, 114, 117, 119, 120, 122, 130, 131, 134, 135, 138, 139, 147, 149, 150, 153, 155, 165, 168, 170, 171, 173, 180, 185, 188, 193, 196, 198, 201, 203, 205, 207, 208, 211, 215, 216, 217, 220, 227, 229, 231, 233, 234, 237, 241, 242, 248, 258, 261, 262, 263, 264, 266, 268, 269, 273, 279, 283, 287, 288, 290, 292, 294, 295, 296, 300, 302, 308, 313, 317, 321, 325, 326, 332, 336, 341, 342, 343, 355, 356, 358, 365, 369, 370, 371, 377, 385, 387, 388, 390, 391, 392, 395, 396, 397, 398, 399}

$R_7$ = {0, 1, 3, 4, 10 15 17 18 20 22 25 27 31 33 36 38 41 45 48 52 55 59 62 63 64 66 69 74 77 80 82 84 87 99 103 107 108 110 118 121 122 125 129 131 132 137 138 139 142 145 146 147 148 151 153 154 157 165 168 173 175 179 183 184 185 186 187 189 194 196 203 204 205 206 209 215 219 222 224 225 226 229 231 232 234 237 238 242 243 245 247 248 250 251 253 255 256 259 262 263 267 268 269 270 271 276 281 285 286 289 290 292 293 297 306 308 309 314 317 318 320 322 324 328 336 339 340 341 346 347 348 360 367 368 372 375 378 382 390 396}

$R_8$ = {2, 3, 8, 11, 16, 24, 25, 26, 28, 31, 33, 34, 39, 44, 50, 51, 52, 54, 56, 57, 58, 60, 63, 64, 66, 67, 68, 69, 70, 72, 80, 83, 90, 95, 97, 98, 99, 100, 101, 103, 105, 108, 109, 118, 119, 126, 127, 130, 133, 138, 140, 145, 147, 149, 151, 152, 156, 158, 161, 162, 163, 166, 169, 170, 177, 178, 179, 181, 186, 190, 193, 196, 201, 202, 203, 205, 207, 209, 211, 214, 227, 231, 233, 239, 241, 242, 243, 244, 245, 247, 251, 254, 257, 268, 276, 277, 282, 284, 285, 288, 292, 295, 304, 305, 307, 308, 310, 312, 314, 317, 318, 323, 324, 328, 329, 330, 335, 340, 344, 345, 346, 347, 350, 352, 354, 355, 357, 361, 365, 367, 370, 372, 376, 377, 380, 382, 386, 389, 392, 394}

$R_9 = \{1, 3, 4, 5, 9, 10, 20, 21, 25, 26, 32, 33, 37, 46, 53, 54, 58, 62, 68, 70, 72, 73, 74, 80, 81, 82, 84, 86, 89, 91, 92, 96, 97, 99, 102, 111, 115, 116, 118, 123, 132, 138, 139, 141, 143, 146, 149, 152, 154, 157, 158, 159, 162, 167, 170, 171, 172, 174, 175, 177, 178, 181, 184, 190, 195, 196, 198, 199, 200, 201, 202, 204, 207, 208, 216, 220, 226, 229, 230, 233, 235, 237, 246, 247, 248, 252, 255, 257, 258, 263, 264, 265, 267, 269, 270, 271, 272, 275, 279, 286, 293, 296, 298, 302, 307, 311, 313, 316, 319, 320, 330, 331, 332, 333, 335, 339, 340, 344, 345, 346, 350, 351, 362, 363, 366, 367, 368, 369, 373, 375, 377, 378, 380, 384, 387, 390, 392, 394, 395, 397\}$

$R_{10} = \{0, 3, 4, 6, 8, 9, 10, 11, 13, 16, 17, 18, 30, 31, 34, 38, 42, 43, 45, 49, 50, 51, 52, 53, 58, 60, 61, 62, 67, 69, 74, 79, 87, 88, 91, 92, 93, 97, 98, 101, 104, 108, 111, 112, 115, 116, 122, 124, 126, 129, 130, 133, 135, 143, 144, 145, 150, 151, 156, 157, 158, 159, 161, 165, 170, 171, 173, 174, 182, 184, 191, 192, 198, 204, 206, 209, 216, 219, 220, 222, 226, 228, 232, 237, 240, 244, 245, 252, 253, 255, 257, 258, 259, 262, 267, 273, 278, 279, 290, 292, 296, 299, 301, 303, 310, 315, 319, 320, 323, 324, 326, 330, 331, 332, 333, 336, 337, 339, 340, 343, 344, 349, 352, 358, 366, 367, 372, 376, 377, 378, 379, 381, 383, 388, 389, 391, 393, 394, 397, 399\}$

$R_{11} = \{4, 6, 10, 13, 15, 16, 18, 20, 23, 30, 32, 37, 39, 42, 45, 48, 49, 51, 52, 57, 59, 61, 66, 73, 75, 78, 82, 83, 87, 90, 92, 93, 95, 96, 97, 98, 106, 108, 109, 113, 115, 116, 119, 126, 130, 131, 135, 138, 142, 144, 146, 147, 148, 149, 150, 151, 153, 154, 159, 164, 166, 167, 168, 169, 170, 178, 180, 181, 183, 186, 192, 193, 197, 198, 202, 203, 210, 212, 213, 215, 217, 218, 219, 220, 221, 225, 226, 227, 229, 230, 231, 233, 235, 238, 239, 244, 246, 249, 250, 256, 262, 265, 275, 276, 279, 280, 283, 286, 291, 296, 300, 303, 309, 311, 312, 317, 318, 319, 323, 327, 329, 336, 345, 348, 354, 358, 359, 360, 364, 367, 371, 373, 374, 375, 388, 390, 391, 394, 397, 398\}$

$R_{12} = \{1, 7, 8, 11, 14, 16, 22, 23, 24, 27, 28, 30, 44, 45, 46, 48, 50, 59, 62, 63, 64, 65, 66, 70, 76, 80, 82, 83, 84, 85, 86, 94, 97, 98, 100, 101, 102, 109, 112, 113, 114, 117, 120, 121, 123, 124, 127, 128, 134, 140, 141, 142, 152, 160, 162, 163, 165, 167, 172, 176, 177, 178, 179, 180, 181, 185, 187, 189, 190, 192, 198, 202, 206, 208, 218, 219, 221, 224, 225, 227, 233, 239, 240, 241, 242, 243, 249, 250, 251, 252, 254, 256, 259, 260, 263, 265, 270, 272, 273, 277, 278, 284, 287, 290, 293, 301, 307, 311, 312, 313, 316, 321, 322, 323, 324, 325, 330, 331, 334, 335, 336, 337, 341, 344, 347, 349, 350, 353, 355, 358, 359, 360, 369, 380, 383, 384, 391, 392, 393, 397\}$

$R_{13}$= {5, 7, 9, 11, 12, 13, 15, 23, 24, 25, 27, 31, 33, 35, 36, 41, 42, 43, 47, 48, 49, 51, 52, 53, 58, 65, 69, 71, 81, 85, 86, 88, 94, 96, 97, 102, 104, 106, 113, 114, 115, 120, 122, 123, 125, 127, 129, 130, 140, 142, 144, 146, 147, 148, 152, 154, 156, 157, 160, 162, 165, 166, 173, 175, 176, 179, 183, 190, 192, 193, 195, 199, 205, 206, 208, 209, 210, 212, 213, 214, 216, 218, 221, 222, 223, 224, 229, 230, 231, 236, 243, 246, 249, 261, 266, 271, 273, 276, 281, 282, 283, 284, 289, 290, 293, 298, 300, 304, 305, 307, 312, 314, 315, 316, 318, 319, 320, 325, 329, 334, 338, 342, 347, 350, 351, 352, 353, 354, 361, 364, 365, 368, 371, 372, 380, 382, 384, 385, 386, 399}

$R_{14}$= {0, 6, 12, 19, 20, 25, 26, 29, 30, 32, 34, 40, 41, 47, 49, 51, 52, 54, 55, 58, 60, 63, 64, 66, 69, 72, 75, 77, 78, 79, 81, 82, 87, 90, 91, 92, 94, 95, 100, 105, 106, 109, 110, 112, 115, 118, 120, 124, 125, 126, 132, 133, 135, 140, 141, 143, 145, 146, 153, 155, 161, 163, 167, 172, 175, 178, 183, 184, 186, 187, 194, 197, 201, 206, 208, 211, 216, 219, 223, 225, 235, 237, 238, 240, 246, 252, 259, 264, 273, 274, 275, 276, 277, 280, 282, 287, 289, 293, 294, 298, 300, 301, 310, 313, 315, 316, 318, 319, 320, 321, 322, 327, 328, 330, 331, 334, 337, 339, 340, 359, 362, 365, 368, 370, 371, 372, 374, 379, 381, 382, 384, 386, 387, 388, 391, 393, 395, 396, 398, 399}

$R_{15}$ = {2, 4, 8, 11, 13, 16, 21, 26, 27, 28, 29, 32, 36, 38, 39, 42, 51, 54, 56, 59, 61, 63, 65, 67, 68, 71, 72, 74, 79, 82, 84, 87, 88, 94, 102, 106, 112, 116, 118, 121, 124, 126, 127, 131, 132, 134, 135, 136, 139, 140, 142, 149, 150, 156, 157, 158, 159, 162, 163, 165, 166, 172, 173, 174, 179, 181, 184, 185, 189, 191, 194, 195, 197, 201, 203, 208, 209, 212, 214, 215, 218, 219, 221, 227, 230, 232, 234, 243, 244, 252, 253, 260, 261, 265, 271, 272, 273, 281, 282, 283, 285, 288, 289, 291, 294, 303, 306, 310, 317, 318, 319, 323, 329, 330, 333, 337, 338, 339, 341, 342, 343, 344, 345, 349, 350, 353, 356, 359, 362, 366, 370, 374, 377, 379, 381, 383, 384, 390, 391, 395}

$R_{16}$ = {7, 11, 17, 19, 22, 27, 29, 30, 35, 42, 47, 54, 55, 56, 63, 64, 66, 67, 71, 72, 73, 75, 76, 77, 79, 80, 85, 89, 90, 93, 94, 96, 98, 100, 106, 113, 116, 118, 122, 126, 128, 133, 136, 137, 141, 144, 147, 148, 150, 151, 153, 155, 157, 162, 163, 164, 167, 169, 176, 182, 185, 187, 189, 190, 191, 197, 203, 210, 211, 212, 216, 218, 220, 224, 225, 228, 232, 235, 236, 237, 238, 244, 245, 252, 256, 258, 260, 261, 265, 266, 269, 270, 275, 276, 277, 279, 280, 284, 285, 288, 290, 295, 297, 298, 299, 300, 301, 302, 303, 304, 305, 308, 311, 313, 315, 321, 325, 326, 328, 331, 332, 334, 335, 337, 341, 344, 355, 356, 357, 358, 362, 366, 373, 374, 381, 385, 386, 395, 397, 398}

$R_{17}$ = {0, 2, 7, 12, 14, 19, 21, 22, 23, 24, 27, 28, 32, 35, 37, 39, 40, 41, 43, 44, 46, 47, 53, 57, 62, 64, 65, 68, 77, 79, 83, 85, 86, 91, 92, 94, 95, 103, 104, 105, 106, 107, 109, 112, 113, 119, 120, 126, 135, 143, 144, 145, 146, 153, 154, 160, 164, 168, 169, 172, 177, 178, 179, 188, 190, 192, 194, 195, 196, 200, 201, 213, 215, 229, 230, 231, 235, 242, 243, 244, 246, 247, 249, 252, 253, 254, 258, 264, 266, 269, 271, 272, 274, 281, 283, 284, 287, 289, 298, 299, 304, 305, 306, 307, 309, 320, 321, 322, 327, 328, 329, 331, 333, 343, 345, 346, 351, 352, 353, 354, 357, 359, 362, 363, 364, 365, 368, 369, 374, 378, 381, 382, 383, 384, 385, 386, 390, 393, 396, 399}

$R_{18}$ = {0, 9, 10, 14, 17, 23, 24, 26, 28, 29, 35, 39, 41, 43, 47, 48, 49, 50, 60, 61, 62, 65, 66, 67, 68, 69, 70, 74, 75, 76, 79, 89, 91, 93, 98, 100, 103, 106, 114, 122, 123, 124, 125, 128, 129, 130, 134, 136, 137, 143, 146, 148, 150, 154, 160, 161, 164, 170, 173, 174, 177, 182, 187, 188, 191, 192, 200, 202, 210, 211, 215, 216, 220, 221, 222, 223, 225, 234, 238, 239, 254, 255, 257, 260, 261, 267, 268, 272, 274, 277, 278, 279, 281, 283, 285, 287, 290, 294, 296, 297, 303, 304, 305, 307, 310, 313, 314, 323, 326, 328, 329, 332, 337, 341, 342, 343, 344, 348, 349, 352, 353, 354, 356, 357, 360, 361, 363, 366, 370, 375, 378, 380, 381, 385, 386, 387, 392, 393, 396, 398}

$R_{19}$ = {0, 5, 8, 9, 10, 14, 17, 18, 20, 21, 23, 25, 32, 35, 37, 40, 41, 42, 46, 49, 50, 52, 55, 56, 57, 59, 60, 61, 67, 68, 76, 78, 83, 89, 91, 96, 98, 101, 102, 105, 110, 114, 117, 119, 121, 123, 127, 129, 134, 137, 139, 141, 148, 149, 151, 153, 156, 158, 160, 161, 166, 169, 172, 179, 187, 188, 189, 194, 197, 198, 200, 201, 205, 206, 210, 211, 212, 214, 220, 221, 222, 234, 236, 237, 238, 239, 240, 242, 245, 248, 250, 251, 258, 259, 260, 261, 263, 269, 270, 274, 279, 282, 283, 284, 291, 295, 296, 299, 301, 302, 303, 305, 306, 310, 312, 314, 324, 332, 333, 339, 340, 341, 345, 348, 349, 352, 354, 355, 357, 361, 364, 370, 372, 379, 380, 381, 383, 392, 394, 395} … (28)

In Table 2, when the maximum information word symbol number is 6400 and the number of columns included in the base matrix as shown in Equation (28) is 400, a required minimum parity symbol number is 320. Accordingly, a parent parity check matrix Q includes 400 x 16 columns and 20 x 16 rows.

A parent parity check matrix Q, which is expressed using Equation (8), is shown in Equation (29).

$T_0$ = {(1,8), (2,8), (3,10), (5,12), (6,8), (7,12), (9,8), (12,4), (14,12), (15,0), (19,0), (20,9), (26,4), (34,8), (35,1), (38,0), (45,13), (46,0), (48,13), (56,9), (57,3), (62,1), (63,8), (71,12), (75,8), (77,3), (78,2), (82,13), (83,13), (85,9), (88,1), (90,15), (92,4), (93,12), (97,0), (99,15), (104,5), (107,14), (110,13), (111,15), (116,9), (117,7), (120,9), (121,8), (125,15), (127,14), (128,15), (129,9), (131,5), (134,12), (150,12), (152,13),

(156,1), (158,9), (159,13), (161,7), (163,5), (164,4), (165,13), (168,11), (171,9), (172,12), (175,12), (177,13), (180,5), (185,9), (193,1), (194,8), (195,9), (199,3), (200,9), (202,9), (204,3), (207,13), (212,13), (213,1), (214,13), (217,3), (223,13), (224,14), (226,10), (227,5), (228,7), (232,5), (236,14), (240,7), (241,7), (245,9), (250,12), (251,5), (255,5), (260,5), (267,4), (268,4), (272,4), (273,4), (275,9), (276,6), (278,5), (284,8), (288,1), (289,6), (291,2), (292,4), (297,12), (299,4), (302,4), (309,5), (310,4), (311,3), (312,5), (326,0), (330,10), (334,9), (335,4), (337,1), (338,6), (340,14), (342,10), (343,1), (347,4), (349,9), (350,1), (351,4), (357,14), (361,8), (364,0), (365,12), (367,6), (369,2), (373,4), (375,12), (376,12), (377,0), (379,0), (383,0), (384,1), (388,4), (389,0), (391,3)}

$T_1 = \{$(2,4), (5,0), (8,9), (10,8), (12,8), (13,4), (14,8), (17,1), (23,12), (24,13), (29,9), (30,12), (33,9), (37,4), (45,0), (46,12), (47,8), (56,4), (60,0), (65,13), (73,13), (77,13), (78,12), (81,13), (89,12), (94,5), (99,5), (100,9), (102,9), (107,4), (111,5), (112,13), (117,4), (125,0), (127,12), (128,5), (133,12), (134,1), (136,1), (137,0), (138,12), (141,12), (143,4), (155,0), (157,12), (158,9), (160,0), (161,0), (163,8), (169,9), (170,12), (174,8), (176,4), (177,4), (178,8), (180,8), (182,8), (186,12), (187,8), (188,8), (189,8), (191,8), (192,1), (196,0), (198,8), (199,8), (200,0), (202,1), (204,4), (207,8), (210,1), (214,4), (217,2), (221,9), (224,0), (226,12), (228,9), (233,1), (236,8), (239,0), (241,0), (246,1), (249,1), (251,5), (256,8), (257,9), (259,9), (263,0), (264,1), (266,0), (267,1), (270,5), (271,9), (280,8), (282,0), (285,12), (286,1), (291,0), (292,8), (295,5), (302,12), (305,12), (306,9), (308,5), (309,4), (311,1), (312,13), (315,13), (316,1), (321,12), (322,5), (323,1), (324,5), (327,13), (328,5), (338,1), (342,12), (343,5), (346,13), (347,5), (349,0), (356,13), (361,1), (363,5), (367,5), (369,5), (372,5), (373,13), (374,4), (376,1), (380,4), (382,1), (387,5), (389,13), (390,5), (392,5), (393,1), (394,8), (395,9), (397,5)}

$T_2 = \{(1,2), (2,14), (3,3), (5,3), (6,10), (12,11), (13,3), (15,0), (19,13), (20,13), (21,6), (22,11), (33,10), (36,13), (38,6), (39,5), (40,12), (43,0), (44,3), (46,15), (47,3), (48,13), (51,7), (53,14), (57,15), (58,8), (59,6), (61,11), (70,7), (71,10), (73,10), (74,14), (79,1), (85,7), (86,14), (88,5), (89,5), (90,2), (92,10), (95,6), (99,14), (103,4), (104,6), (105,6), (111,10), (115,8), (128,3), (130,12), (133,4), (136,2), (139,6), (142,11), (145,14), (155,0), (156,14), (160,7), (168,5), (171,10), (176,12), (182,12), (183,8), (185,12), (186,9), (191,6), (193,15), (199,10), (204,0), (205,8), (207,5), (213,1), (217,4), (224,0), (226,0), (228,0), (230,4), (233,0), (234,12), (236,1), (238,8), (239,1), (240,3), (246,13), (247,12), (248,1), (249,8), (250,4), (251,1), (253,9), (254,0), (258,5), (262,3), (264,7), (268,6), (270,4), (271,1), (274,8), (277,5), (280,2), (286,11), (287,1), (293,3), (294,12), (296,7), (297,5), (299,7), (301,7), (302,11), (304,11), (306,3), (308,11), (309,15), (314,15), (315,8), (316,14), (317,10), (322,10), (325,11), (326,8), (327,15), (331,11), (333,1), (334,5), (335,9), (345,0), (348,13), (351,9), (358,9), (360,1), (362,15), (363,3),$

$(371,3), (375,9), (376,7), (378,2), (379,1), (387,1), (389,11), (394,13), (396,15), (399,13)\}$

$T_3 = \{(2,4), (3,15), (4,7), (7,13), (9,8), (14,6), (15,5), (18,3), (22,4), (29,12), (30,7), (32,4), (36,14), (40,5), (50,5), (53,1), (54,11), (55,8), (60,8), (64,15), (68,12), (70,5), (71,9), (75,14), (77,2), (81,5), (85,10), (90,8), (91,11), (95,9), (96,11), (100,8), (101,5), (103,0), (104,4), (105,15), (107,13), (108,13), (109,13), (110,5), (111,9), (113,9), (116,0), (121,12), (123,12), (124,13), (131,9), (132,11), (133,1), (136,12), (137,11), (140,9), (144,12), (145,9), (149,0), (152,6), (155,7), (159,5), (162,0), (164,12), (166,6), (167,1), (168,9), (171,12), (174,5), (176,0), (180,5), (181,6), (182,0), (183,10), (184,11), (188,1), (189,1), (190,9), (197,6), (199,15), (203,6), (209,11), (213,15), (215,6), (223,3), (232,0), (234,6), (235,2), (240,10), (244,2), (247,6), (248,0), (253,6), (254,2), (255,2), (256,0), (257,10), (260,7), (265,2), (266,4), (274,0), (278,0), (280,4), (281,2), (286,2), (288,10), (291,2), (292,10), (294,1), (295,4), (297,0), (299,15), (301,2), (304,2), (306,3), (314,7), (321,1), (322,11), (325,10), (327,0), (334,11), (336,6), (338,8), (346,3), (348,3), (351,9), (352,8), (353,1), (355,11), (364,10), (366,10), (369,15), (370,14), (371,15), (373,13), (374,6), (376,15), (377,14), (382,5), (386,3), (387,2), (389,7), (396,8), (399,10)\}$

$T_4 = \{(0,0), (1,5), (5,9), (16,9), (17,1), (18,0), (19,0), (21,1), (26,0), (28,9), (29,8), (31,1), (34,7), (36,1), (37,5), (39,0), (40,15), (44,13), (50,9), (55,0), (56,0), (58,7), (67,15), (72,11), (73,1), (74,11), (76,5), (78,3), (80,3), (81,2), (84,0), (87,8), (89,5), (93,7), (96,2), (99,7), (107,14), (108,2), (110,0), (114,3), (117,1), (118,10), (119,10), (120,15), (123,11), (125,11), (128,10), (132,0), (138,10), (140,3), (143,2), (147,2), (152,14), (155,13), (164,13), (167,6), (171,2), (173,11), (174,8), (175,10), (180,7), (181,4), (182,14), (188,10), (191,2), (195,10), (199,9), (200,3), (204,14), (206,15), (207,0), (208,12), (211,6), (212,7), (213,7), (217,0), (218,15), (222,4), (223,2), (228,12), (230,9), (231,12), (241,6), (242,14), (249,15), (253,6), (254,1), (255,8), (256,1), (257,6), (259,11), (261,7), (262,12), (264,7), (265,15), (268,8), (269,12), (275,15), (277,11), (278,15), (280,11), (285,3), (286,13), (289,11), (293,13), (295,0), (297,3), (298,4), (300,12), (307,11), (311,1), (315,1), (316,6), (318,5), (320,4), (324,5), (326,9), (338,8), (339,13), (342,13), (346,5), (347,13), (348,7), (356,4), (357,2), (358,13), (359,2), (360,5), (361,0), (363,1), (364,8), (365,0), (368,13), (371,3), (375,8), (385,1), (388,3), (389,0), (393,5), (398,11)\}$

$T_5 = \{(1,14), (6,9), (8,11), (12,3), (18,10), (19,14), (21,9), (24,15), (25,10), (31,14), (34,11), (35,10), (37,8), (38,6), (40,7), (41,9), (43,3), (44,4), (45,14), (49,7), (53,7), (59,5), (61,13), (65,0), (72,11), (76,10), (83,15), (84,5), (86,11), (88,12), (101,5), (105,14), (108,5), (109,6), (113,6), (114,14), (115,13), (117,3), (119,0), (121,8), (122,7), (124,4), (129,1), (131,14), (132,1), (135,9), (136,8), (137,10), (139,3), (141,8), (142,15), (144,0), (148,12), (151,7), (154,11), (159,12), (166,1), (169,15), (175,3), (176,0), (183,13), (184,1), (186,3), (193,13), (194,3), (195,4), (196,3), (197,4), (205,4), (209,15), (210,0), (214,5), (217,10), (218,14), (219,4), (222,3), (223,0), (225,5), (227,9), (228,9), (229,9), (232,5), (235,5), (236,3), (241,1), (243,8), (245,0), (247,4), (248,5), (250,0), (262,8), (263,8), (266,5), (267,1), (272,1), (274,10), (275,1), (278,15), (281,0), (282,8), (287,15), (288,14), (291,14), (294,10), (298,1), (300,11), (303,10), (308,2), (309,10), (313,8), (317,0), (319,0), (325,2), (327,1), (329,2), (332,4), (333,2), (335,2), (336,0), (338,11), (350,10), (351,4), (353,3), (354,5), (355,5), (356,10), (359,6), (360,1), (362,15), (363,2), (366,2), (368,14), (373,6), (376,10), (378,12), (379,6), (383,1), (385,7), (388,14), (398,15)\}$

$T_6 = \{(4,8), (6,3), (7,10), (11,15), (13,11), (15,3), (16,11), (22,5), (27,3), (28,12),$
$(31,12), (33,1), (34,13), (36,13), (38,13), (42,8), (43,12), (44,1), (54,14), (55,11),$
$(57,12), (69,9), (70,1), (71,9), (73,14), (75,9), (76,8), (78,10), (80,8), (81,1), (84,9),$
$(86,10), (87,13), (88,13), (93,0), (95,11), (101,0), (102,1), (103,1), (104,9), (107,1),$
$(110,4), (111,1), (112,9), (114,9), (117,2), (119,1), (120,1), (122,8), (130,1), (131,1),$
$(134,4), (135,10), (138,9), (139,15), (147,0), (149,3), (150,11), (153,2), (155,10),$
$(165,13), (168,7), (170,11), (171,3), (173,8), (180,11), (185,3), (188,0), (193,10),$
$(196,3), (198,1), (201,10), (203,11), (205,7), (207,14), (208,13), (211,4), (215,2),$
$(216,7), (217,8), (220,3), (227,14), (229,5), (231,5), (233,14), (234,0), (237,6), (241,6),$
$(242,6), (248,0), (258,6), (261,3), (262,14), (263,5), (264,2), (266,1), (268,12), (269,6),$
$(273,14), (279,2), (283,14), (287,15), (288,0), (290,6), (292,2), (294,1), (295,10),$
$(296,4), (300,4), (302,11), (308,12), (313,10), (317,6), (321,14), (325,1), (326,0),$
$(332,10), (336,4), (341,10), (342,7), (343,7), (355,13), (356,1), (358,11), (365,7),$
$(369,9), (370,3), (371,3), (377,2), (385,2), (387,4), (388,2), (390,7), (391,8), (392,5),$
$(395,2), (396,1), (397,5), (398,7), (399,3)\}$

$T_7 = \{(0,15), (1,1), (3,6), (4,8), (10,9), (15,15), (17,10), (18,14), (20,9), (22,8),$
$(25,14), (27,14), (31,4), (33,10), (36,3), (38,14), (41,10), (45,11), (48,0), (52,14),$
$(55,10), (59,3), (62,12), (63,14), (64,3), (66,14), (69,0), (74,6), (77,5), (80,2), (82,4),$
$(84,0), (87,6), (99,8), (103,2), (107,13), (108,10), (110,1), (118,12), (121,2), (122,7),$
$(125,3), (129,6), (131,7), (132,7), (137,10), (138,6), (139,1), (142,15), (145,7), (146,3),$
$(147,5), (148,11), (151,2), (153,9), (154,10), (157,0), (165,3), (168,0), (173,11),$
$(175,15), (179,9), (183,8), (184,3), (185,1), (186,2), (187,2), (189,6), (194,9), (196,4),$
$(203,11), (204,3), (205,11), (206,5), (209,1), (215,6), (219,1), (222,1), (224,0), (225,1),$
$(226,1), (229,3), (231,7), (232,13), (234,0), (237,2), (238,2), (242,10), (243,11),$
$(245,5), (247,1), (248,9), (250,2), (251,3), (253,0), (255,9), (256,4), (259,1), (262,9),$
$(263,0), (267,3), (268,1), (269,0), (270,9), (271,8), (276,9), (281,9), (285,9), (286,10),$
$(289,11), (290,8), (292,5), (293,10), (297,1), (306,0), (308,1), (309,1), (314,0), (317,3),$
$(318,12), (320,13), (322,12), (324,12), (328,9), (336,12), (339,13), (340,7), (341,0),$
$(346,15), (347,15), (348,11), (360,10), (367,0), (368,5), (372,11), (375,3), (378,6),$

$(382,4), (390,6), (396,11)\}$

$T_8 = \{(2,8), (3,13), (8,11), (11,9), (16,14), (24,3), (25,1), (26,4), (28,12), (31,4), (33,5), (34,2), (39,4), (44,0), (50,3), (51,8), (52,14), (54,8), (56,7), (57,2), (58,8), (60,1), (63,12), (64,2), (66,3), (67,1), (68,12), (69,5), (70,7), (72,7), (80,9), (83,12), (90,9), (95,13), (97,3), (98,4), (99,12), (100,8), (101,2), (103,8), (105,2), (108,8), (109,5), (118,4), (119,5), (126,11), (127,5), (130,2), (133,0), (138,9), (140,4), (145,0), (147,1), (149,6), (151,6), (152,14), (156,1), (158,14), (161,4), (162,2), (163,1), (166,1), (169,1), (170,10), (177,2), (178,8), (179,0), (181,2), (186,4), (190,0), (193,3), (196,14), (201,2), (202,1), (203,0), (205,0), (207,11), (209,2), (211,2), (214,3), (227,3), (231,9), (233,9), (239,10), (241,2), (242,6), (243,8), (244,14), (245,13), (247,9), (251,0), (254,8), (257,0), (268,7), (276,10), (277,8), (282,10), (284,10), (285,3), (288,7), (292,4), (295,0), (304,12), (305,14), (307,13), (308,10), (310,7), (312,6), (314,12), (317,14), (318,13), (323,11), (324,11), (328,6), (329,10), (330,11), (335,11), (340,13), (344,14), (345,5), (346,7), (347,6), (350,13), (352,7), (354,3), (355,4), (357,3), (361,14), (365,5), (367,3), (370,12), (372,9), (376,4), (377,7), (380,12), (382,6), (386,2), (389,9), (392,0), (394,7)\}$

$T_9 = \{(1,2), (3,11), (4,1), (5,15), (9,7), (10,0), (20,2), (21,2), (25,8), (26,1), (32,6), (33,10), (37,4), (46,2), (53,7), (54,8), (58,3), (62,5), (68,0), (70,0), (72,0), (73,9), (74,3), (80,10), (81,2), (82,10), (84,13), (86,6), (89,0), (91,4), (92,5), (96,10), (97,5), (99,2), (102,13), (111,1), (115,5), (116,5), (118,4), (123,10), (132,6), (138,8), (139,2), (141,7), (143,7), (146,14), (149,2), (152,4), (154,4), (157,3), (158,1), (159,13), (162,0), (167,0), (170,6), (171,4), (172,4), (174,1), (175,1), (177,9), (178,14), (181,4), (184,12), (190,9), (195,8), (196,0), (198,12), (199,0), (200,0), (201,0), (202,12), (204,14), (207,3), (208,5), (216,15), (220,8), (226,0), (229,15), (230,12), (233,6), (235,8), (237,8), (246,15), (247,1), (248,7), (252,10), (255,12), (257,7), (258,3), (263,2), (264,14), (265,11), (267,2), (269,0), (270,8), (271,11), (272,8), (275,10), (279,6), (286,2), (293,0), (296,10), (298,14), (302,2), (307,7), (311,3), (313,15), (316,8), (319,14), (320,2), (330,10), (331,13), (332,8), (333,2), (335,6), (339,9), (340,2), (344,6), (345,10), (346,6), (350,10), (351,10), (362,14), (363,4), (366,14), (367,4), (368,1), (369,2), (373,0), (375,1), (377,3), (378,11), (380,0), (384,11), (387,4), (390,10), (392,3), (394,1), (395,0), (397,11)\}$

$T_{10} = \{(0,10), (3,2), (4,6), (6,11), (8,0), (9,10), (10,0), (11,4), (13,12), (16,14), (17,0), (18,2), (30,10), (31,6), (34,8), (38,2), (42,7), (43,0), (45,2), (49,0), (50,8), (51,12), (52,6), (53,6), (58,10), (60,2), (61,8), (62,6), (67,0), (69,8), (74,2), (79,2), (87,4), (88,0), (91,6), (92,8), (93,2), (97,0), (98,10), (101,14), (104,2), (108,10), (111,10), (112,2), (115,2), (116,10), (122,2), (124,14), (126,8), (129,8), (130,0), (133,10), (135,2), (143,0), (144,8), (145,8), (150,8), (151,10), (156,10), (157,0), (158,10), (159,10), (161,0), (165,8), (170,2), (171,8), (173,4), (174,2), (182,14), (184,2),$

$(191,14), (192,14), (198,4), (204,0), (206,15), (209,2), (216,12), (219,6), (220,6), (222,2), (226,6), (228,2), (232,8), (237,2), (240,14), (244,12), (245,0), (252,14), (253,10), (255,8), (257,10), (258,14), (259,4), (262,8), (267,2), (273,14), (278,6), (279,8), (290,10), (292,2), (296,6), (299,10), (301,2), (303,14), (310,6), (315,0), (319,6), (320,6), (323,8), (324,2), (326,6), (330,4), (331,4), (332,0), (333,8), (336,8), (337,10), (339,0), (340,0), (343,4), (344,4), (349,0), (352,8), (358,8), (366,8), (367,14), (372,0), (376,4), (377,14), (378,12), (379,4), (381,10), (383,12), (388,0), (389,8), (391,8), (393,6), (394,0), (397,12), (399,4), (400,0)\}$

$T_{11} = \{(4,2), (6,8), (10,10), (13,10), (15,10), (16,2), (18,10), (20,10), (23,6), (30,0), (32,10), (37,2), (39,14), (42,14), (45,0), (48,12), (49,2), (51,7), (52,6), (57,11), (59,11), (61,1), (66,0), (73,3), (75,14), (78,11), (82,3), (83,2), (87,13), (90,10), (92,11), (93,11), (95,1), (96,15), (97,3), (98,5), (106,7), (108,0), (109,3), (113,4), (115,7), (116,1), (119,1), (126,7), (130,14), (131,3), (135,5), (138,1), (142,7), (144,5), (146,9), (147,11), (148,0), (149,1), (150,3), (151,3), (153,3), (154,3), (159,1), (164,9), (166,11), (167,3), (168,3), (169,7), (170,9), (178,3), (180,1), (181,5), (183,1), (186,5), (192,3), (193,3), (197,3), (198,5), (202,3), (203,13), (210,9), (212,9), (213,3), (215,1), (217,1), (218,15), (219,5), (220,3), (221,1), (225,1), (226,3), (227,6), (229,12), (230,8), (231,2), (233,2), (235,10), (238,2), (239,1), (244,6), (246,5), (249,11), (250,9), (256,1), (262,7), (265,2), (275,2), (276,8), (279,14), (280,0), (283,8), (286,1), (291,0), (296,2), (300,2), (303,2), (309,0), (311,0), (312,0), (317,0), (318,12), (319,0), (323,0), (327,0), (329,0), (336,0), (345,8), (348,8), (354,8), (358,8), (359,12), (360,8), (364,0), (367,10), (371,4), (373,0), (374,0), (375,8), (388,1), (390,10), (391,10), (394,2), (397,0), (398,10)\}$

$T_{12}$ = {(1,3), (7,3), (8,1), (11,13), (14,2), (16,1), (22,11), (23,0), (24,15), (27,8), (28,9), (30,11), (44,9), (45,7), (46,3), (48,7), (50,3), (59,1), (62,3), (63,3), (64,3), (65,7), (66,7), (70,2), (76,1), (80,3), (82,5), (83,7), (84,9), (85,11), (86,5), (94,11), (97,5), (98,9), (100,15), (101,1), (102,3), (109,0), (112,9), (113,9), (114,7), (117,5), (120,1), (121,1), (123,1), (124,3), (127,11), (128,1), (134,3), (140,9), (141,9), (142,5), (152,1), (160,5), (162,3), (163,9), (165,1), (167,11), (172,5), (176,1), (177,0), (178,1), (179,6), (180,2), (181,1), (185,0), (187,7), (189,0), (190,2), (192,15), (198,6), (202,8), (206,2), (208,10), (218,0), (219,2), (221,4), (224,3), (225,0), (227,6), (233,6), (239,3), (240,2), (241,0), (242,0), (243,6), (249,4), (250,4), (251,8), (252,8), (254,8), (256,0), (259,1), (260,1), (263,4), (265,0), (270,1), (272,0), (273,4), (277,2), (278,2), (284,4), (287,2), (290,2), (293,6), (301,10), (307,10), (311,2), (312,6), (313,12), (316,10), (321,10), (322,12), (323,12), (324,0), (325,0), (330,8), (331,2), (334,10), (335,10), (336,8), (337,10), (341,14), (344,10), (347,10), (349,6), (350,4), (353,8), (355,0), (358,2), (359,12), (360,1), (369,2), (380,4), (383,14), (384,11), (391,3), (392,2), (393,13), (397,3)}

$T_{13}$ = {(5,3), (7,0), (9,1), (11,11), (12,3), (13,1), (15,1), (23,3), (24,3), (25,3), (27,1), (31,9), (33,9), (35,9), (36,9), (41,11), (42,3), (43,3), (47,1), (48,7), (49,11), (51,13), (52,1), (53,3), (58,5), (65,15), (69,13), (71,1), (81,3), (85,9), (86,9), (88,7), (94,11), (96,3), (97,2), (102,7), (104,15), (106,7), (113,10), (114,2), (115,3), (120,2), (122,1), (123,3), (125,5), (127,1), (129,1), (130,4), (140,3), (142,11), (144,1), (146,3), (147,5), (148,15), (152,3), (154,0), (156,2), (157,9), (160,10), (162,6), (165,12), (166,14), (173,8), (175,8), (176,2), (179,11), (183,6), (190,9), (192,10), (193,4), (195,7), (199,0), (205,2), (206,1), (208,6), (209,0), (210,10), (212,2), (213,8), (214,0), (216,10), (218,1), (221,10), (222,0), (223,8), (224,10), (229,10), (230,0), (231,2), (236,2), (243,9), (246,0), (249,13), (261,10), (266,4), (271,0), (273,6), (276,10), (281,6), (282,0), (283,0), (284,8), (289,12), (290,0), (293,2), (298,10), (300,0), (304,8), (305,8), (307,4), (312,0), (314,4), (315,0), (316,2), (318,10), (319,12), (320,8), (325,12), (329,0), (334,1), (338,3), (342,4), (347,9), (350,1), (351,2), (352,2), (353,0), (354,11), (361,9), (364,13), (365,11), (368,9), (371,3), (372,0), (380,3), (382,4), (384,0), (385,1), (386,1), (399,4)}

$T_{14} = \{(0,8), (6,0), (12,0), (19,2), (20,0), (25,8), (26,10), (29,0), (30,2), (32,0), (34,0), (40,8), (41,0), (47,0), (49,0), (51,2), (52,2), (54,8), (55,0), (58,2), (60,0), (63,0), (64,0), (66,3), (69,1), (72,8), (75,9), (77,0), (78,0), (79,5), (81,9), (82,12), (87,4), (90,1), (91,15), (92,11), (94,1), (95,0), (100,11), (105,10), (106,10), (109,11), (110,2), (112,15), (115,1), (118,9), (120,3), (124,13), (125,0), (126,15), (132,3), (133,11), (135,3), (140,11), (141,2), (143,9), (145,9), (146,11), (153,7), (155,1), (161,11), (163,7), (167,8), (172,1), (175,15), (178,1), (183,0), (184,8), (186,1), (187,11), (194,3), (197,11), (201,3), (206,3), (208,13), (211,3), (216,3), (219,1), (223,3), (225,11), (235,9), (237,9), (238,3), (240,3), (246,11), (252,9), (259,1), (264,3), (273,2), (274,9), (275,9), (276,5), (277,11), (280,9), (282,9), (287,1), (289,5), (293,9), (294,0), (298,2), (300,3), (301,1), (310,1), (313,0), (315,10), (316,12), (318,0), (319,12), (320,8), (321,10), (322,1), (327,1), (328,2), (330,0), (331,0), (334,2), (337,4), (339,0), (340,2), (359,1), (362,8), (365,5), (368,8), (370,10), (371,1), (372,2), (374,2), (379,1), (381,8), (382,8), (384,4), (386,4), (387,0), (388,4), (391,3), (393,0), (395,2), (396,2), (398,10), (399,0)\}$

$T_{15} = \{(2,2), (4,10), (8,8), (11,0), (13,0), (16,0), (21,8), (26,2), (27,10), (28,2), (29,0), (32,3), (36,0), (38,2), (39,11), (42,1), (51,2), (54,10), (56,0), (59,0), (61,0), (63,1), (65,3), (67,11), (68,0), (71,3), (72,3), (74,10), (79,1), (82,0), (84,8), (87,1), (88,3), (94,8), (102,1), (106,9), (112,11), (116,8), (118,0), (121,11), (124,3), (126,9), (127,1), (131,9), (132,0), (134,1), (135,1), (136,1), (139,1), (140,1), (142,1), (149,1), (150,1), (156,1), (157,1), (158,3), (159,1), (162,11), (163,1), (165,9), (166,2), (172,0), (173,1), (174,3), (179,1), (181,1), (184,1), (185,1), (189,1), (191,3), (194,9), (195,9), (197,0), (201,1), (203,3), (208,1), (209,8), (212,8), (214,3), (215,11), (218,11), (219,8), (221,1), (227,11), (230,3), (232,3), (234,3), (243,9), (244,11), (252,2), (253,1), (260,0), (261,11), (265,9), (271,11), (272,1), (273,1), (281,10), (282,2), (283,9), (285,8), (288,10), (289,8), (291,11), (294,2), (303,3), (306,10), (310,2), (317,2), (318,11), (319,9), (323,3), (329,1), (330,1), (333,2), (337,8), (338,2), (339,2), (341,10), (342,0), (343,2), (344,0), (345,0), (349,10), (350,0), (353,8), (356,0), (359,0), (362,3), (366,8), (370,0), (374,10), (377,0), (379,10), (381,8), (383,8), (384,0), (390,2), (391,8), (395,0)\}$

T$_{16}$ = {(7,4), (11,5), (17,3), (19,6), (22,5), (27,6), (29,6), (30,7), (35,14), (42,6), (47,14), (54,4), (55,4), (56,2), (63,1), (64,6), (66,0), (67,2), (71,13), (72,0), (73,0), (75,12), (76,10), (77,4), (79,0), (80,0), (85,7), (89,6), (90,4), (93,6), (94,3), (96,5), (98,4), (100,0), (106,2), (113,14), (116,4), (118,2), (122,2), (126,12), (128,6), (133,6), (136,10), (137,14), (141,2), (144,14), (147,4), (148,2), (150,0), (151,0), (153,14), (155,2), (157,2), (162,2), (163,7), (164,2), (167,1), (169,3), (176,1), (182,12), (185,4), (187,3), (189,0), (190,1), (191,11), (197,1), (203,5), (210,12), (211,0), (212,0), (216,0), (218,3), (220,11), (224,4), (225,7), (228,10), (232,3), (235,8), (236,0), (237,1), (238,9), (244,7), (245,1), (252,0), (256,1), (258,3), (260,7), (261,1), (265,7), (266,1), (269,5), (270,1), (275,3), (276,2), (277,5), (279,0), (280,7), (284,7), (285,9), (288,1), (290,1), (295,7), (297,9), (298,1), (299,3), (300,3), (301,0), (302,1), (303,1), (304,3), (305,1), (308,1), (311,0), (313,1), (315,1), (321,5), (325,2), (326,5), (328,5), (331,10), (332,13), (334,1), (335,7), (337,5), (341,5), (344,4), (355,4), (356,5), (357,5), (358,4), (362,6), (366,5), (373,4), (374,4), (381,1), (385,1), (386,13), (395,4), (397,5), (398,6)}

T$_{17}$ = {(0,1), (2,5), (7,2), (12,1), (14,5), (19,1), (21,5), (22,5), (23,7), (24,3), (27,2), (28,9), (32,1), (35,13), (37,1), (39,1), (40,1), (41,0), (43,1), (44,10), (46,1), (47,0), (53,5), (57,1), (62,11), (64,5), (65,5), (68,5), (77,7), (79,1), (83,2), (85,1), (86,4), (91,1), (92,3), (94,4), (95,4), (103,3), (104,0), (105,4), (106,8), (107,5), (109,7), (112,7), (113,2), (119,5), (120,7), (126,1), (135,1), (143,2), (144,4), (145,12), (146,13), (153,5), (154,5), (160,4), (164,6), (168,0), (169,2), (172,0), (177,13), (178,4), (179,7), (188,0), (190,4), (192,8), (194,8), (195,4), (196,0), (200,0), (201,5), (213,11), (215,4), (229,1), (230,4), (231,0), (235,0), (242,4), (243,0), (244,4), (246,6), (247,4), (249,4), (252,4), (253,4), (254,4), (258,0), (264,0), (266,4), (269,7), (271,0), (272,0), (274,4), (281,2), (283,0), (284,0), (287,6), (289,2), (298,7), (299,10), (304,1), (305,3), (306,4), (307,7), (309,6), (320,14), (321,1), (322,7), (327,7), (328,6), (329,2), (331,10), (333,6), (343,0), (345,3), (346,0), (351,1), (352,11), (353,5), (354,2), (357,2), (359,1), (362,0), (363,3), (364,7), (365,6), (368,5), (369,5), (374,0), (378,5), (381,2), (382,7), (383,3), (384,12), (385,6), (386,0), (390,3), (393,3), (396,1), (399,1)}

T$_{18}$ = {(0,2), (9,3), (10,6), (14,2), (17,6), (23,7), (24,7), (26,2), (28,5), (29,12), (35,5), (39,4), (41,5), (43,3), (47,7), (48,3), (49,4), (50,0), (60,2), (61,2), (62,4), (65,0), (66,5), (67,14), (68,2), (69,4), (70,4), (74,4), (75,6), (76,2), (79,2), (89,6), (91,4), (93,6), (98,7), (100,4), (103,4), (106,1), (114,0), (122,4), (123,6), (124,14), (125,14), (128,0),

(129,4), (130,4), (134,6), (136,4), (137,4), (143,5), (146,5), (148,4), (150,5), (154,0),
(160,4), (161,4), (164,0), (170,4), (173,0), (174,1), (177,4), (182,5), (187,1), (188,6),
(191,0), (192,1), (200,7), (202,0), (210,3), (211,9), (215,1), (216,1), (220,0), (221,1),
(222,5), (223,3), (225,0), (234,5), (238,0), (239,5), (254,0), (255,5), (257,1), (260,13),
(261,7), (267,7), (268,1), (272,5), (274,3), (277,3), (278,5), (279,1), (281,1), (283,6),
(285,3), (287,0), (290,1), (294,1), (296,1), (297,1), (303,1), (304,0), (305,5), (307,5),
(310,0), (313,2), (314,1), (323,3), (326,1), (328,2), (329,0), (332,1), (337,0), (341,0),
(342,3), (343,3), (344,1), (348,1), (349,1), (352,1), (353,2), (354,1), (356,9), (357,0),
(360,1), (361,13), (363,1), (366,0), (370,5), (375,0), (378,5), (380,1), (381,4), (385,0),
(386,5), (387,4), (392,6), (393,7), (396,5), (398,5)}

$T_{19}$ = {(0,4), (5,12), (8,4), (9,8), (10,12), (14,8), (17,0), (18,10), (20,4), (21,9),
(23,13), (25,5), (32,9), (35,12), (37,0), (40,12), (41,8), (42,0), (46,1), (49,1), (50,13),
(52,12), (55,9), (56,0), (57,6), (59,14), (60,4), (61,10), (67,0), (68,0), (76,4), (78,6),
(83,0), (89,6), (91,8), (96,0), (98,0), (101,8), (102,6), (105,1), (110,2), (114,5),
(117,15), (119,1), (121,10), (123,5), (127,15), (129,0), (134,7), (137,9), (139,10),
(141,1), (148,13), (149,4), (151,9), (153,4), (156,10), (158,11), (160,1), (161,11),
(166,1), (169,12), (172,2), (179,11), (187,6), (188,9), (189,2), (194,5), (197,0), (198,1),
(200,7), (201,13), (205,2), (206,13), (210,9), (211,1), (212,3), (214,11), (220,1),
(221,2), (222,1), (234,1), (236,7), (237,8), (238,1), (239,3), (240,1), (242,7), (245,13),
(248,13), (250,5), (251,7), (258,5), (259,3), (260,7), (261,14), (263,13), (269,5),
(270,9), (274,0), (279,5), (282,6), (283,4), (284,0), (291,5), (295,3), (296,11), (299,5),
(301,6), (302,2), (303,5), (305,4), (306,5), (310,9), (312,4), (314,13), (324,5), (332,12),
(333,6), (339,7), (340,13), (341,14), (345,13), (348,12), (349,0), (352,12), (354,0),
(355,1), (357,8), (361,0), (364,13), (370,13), (372,14), (379,12), (380,4), (381,11),
(383,5), (392,10), (394,10), (395,8)}
… (29)

As described in Table 1, the MMT system may support the number of information word symbols 3200, 1600, 800, and 400 by performing a scaling factor S1 = 2, 4, 8, and 16 on the parent parity check matrix as shown in Equation (29).

If each row included in the parent parity check matrix as shown in Equation (29) is separated into 2, 3, and 4 rows, respectively, the design requirement criterion described in Table 2 may be satisfied.

Matrixes that are generated by applying the row separation rule (n = 2, 3, and 4) described with reference to Table 1 to the parent parity check matrix as shown in Equation (29) are as shown in Equation (30) to Equation (32).

Therefore, code rates that the matrixes expressed as Equation (30) to Equation (32), i.e., the separated parent parity check matrixes, support are 20/22, 20/23, and 20/24, respectively.

$T'_0$ = {(2,8), (5,12), (7,12), (12,4), (15,0), (20,9), (34,8), (38,0), (46,0), (56,9), (62,1), (71,12), (77,3), (82,13), (85,9), (90,15), (93,12), (99,15), (107,14), (111,15), (117,7), (121,8), (127,14), (129,9), (134,12), (152,13), (158,9), (161,7), (164,4), (168,11), (172,12), (177,13), (185,9), (194,8), (199,3), (202,9), (207,13), (213,1), (217,3), (224,14), (227,5), (232,5), (240,7), (245,9), (251,5), (260,5), (268,4), (273,4), (276,6), (284,8), (289,6), (292,4), (299,4), (309,5), (311,3), (326,0), (334,9), (337,1), (340,14), (343,1), (349,9), (351,4), (361,8), (365,12), (369,2), (375,12), (377,0), (383,0), (388,4), (391,3)}

$T'_1$ = {(1,8), (3,10), (6,8), (9,8), (14,12), (19,0), (26,4), (35,1), (45,13), (48,13), (57,3), (63,8), (75,8), (78,2), (83,13), (88,1), (92,4), (97,0), (104,5), (110,13), (116,9), (120,9), (125,15), (128,15), (131,5), (150,12), (156,1), (159,13), (163,5), (165,13), (171,9), (175,12), (180,5), (193,1), (195,9), (200,9), (204,3), (212,13), (214,13), (223,13), (226,10), (228,7), (236,14), (241,7), (250,12), (255,5), (267,4), (272,4), (275,9), (278,5), (288,1), (291,2), (297,12), (302,4), (310,4), (312,5), (330,10), (335,4), (338,6), (342,10), (347,4), (350,1), (357,14), (364,0), (367,6), (373,4), (376,12), (379,0), (384,1), (389,0)}

$T'_2$ = {(5,0), (10,8), (13,4), (17,1), (24,13), (30,12), (37,4), (46,12), (56,4), (65,13), (77,13), (81,13), (94,5), (100,9), (107,4), (112,13), (125,0), (128,5), (134,1), (137,0), (141,12), (155,0), (158,9), (161,0), (169,9), (174,8), (177,4), (180,8), (186,12), (188,8), (191,8), (196,0), (199,8), (202,1), (207,8), (214,4), (221,9), (226,12), (233,1), (239,0), (246,1), (251,5), (257,9), (263,0), (266,0), (270,5), (280,8), (285,12), (291,0), (295,5), (305,12), (308,5), (311,1), (315,13), (321,12), (323,1), (327,13), (338,1), (343,5), (347,5), (356,13), (363,5), (369,5), (373,13), (376,1), (382,1), (389,13), (392,5), (394,8), (397,5)}

$T'_3$ = {(2,4), (8,9), (12,8), (14,8), (23,12), (29,9), (33,9), (45,0), (47,8), (60,0), (73,13), (78,12), (89,12), (99,5), (102,9), (111,5), (117,4), (127,12), (133,12), (136,1), (138,12), (143,4), (157,12), (160,0), (163,8), (170,12), (176,4), (178,8), (182,8), (187,8), (189,8), (192,1), (198,8), (200,0), (204,4), (210,1), (217,2), (224,0), (228,9), (236,8), (241,0), (249,1), (256,8), (259,9), (264,1), (267,1), (271,9), (282,0), (286,1), (292,8), (302,12), (306,9), (309,4), (312,13), (316,1), (322,5), (324,5), (328,5), (342,12), (346,13), (349,0), (361,1), (367,5), (372,5), (374,4), (380,4), (387,5), (390,5), (393,1), (395,9)}

T'$_4$ = {(2,14), (5,3), (12,11), (15,0), (20,13), (22,11), (36,13), (39,5), (43,0), (46,15), (48,13), (53,14), (58,8), (61,11), (71,10), (74,14), (85,7), (88,5), (90,2), (95,6), (103,4), (105,6), (115,8), (130,12), (136,2), (142,11), (155,0), (160,7), (171,10), (182,12), (185,12), (191,6), (199,10), (205,8), (213,1), (224,0), (228,0), (233,0), (236,1), (239,1), (246,13), (248,1), (250,4), (253,9), (258,5), (264,7), (270,4), (274,8), (280,2), (287,1), (294,12), (297,5), (301,7), (304,11), (308,11), (314,15), (316,14), (322,10), (326,8),

(331,11), (334,5), (345,0), (351,9), (360,1), (363,3), (375,9), (378,2), (387,1), (394,13), (399,13)}

T'$_5$ = {(1,2), (3,3), (6,10), (13,3), (19,13), (21,6), (33,10), (38,6), (40,12), (44,3), (47,3), (51,7), (57,15), (59,6), (70,7), (73,10), (79,1), (86,14), (89,5), (92,10), (99,14), (104,6), (111,10), (128,3), (133,4), (139,6), (145,14), (156,14), (168,5), (176,12), (183,8), (186,9), (193,15), (204,0), (207,5), (217,4), (226,0), (230,4), (234,12), (238,8), (240,3), (247,12), (249,8), (251,1), (254,0), (262,3), (268,6), (271,1), (277,5), (286,11), (293,3), (296,7), (299,7), (302,11), (306,3), (309,15), (315,8), (317,10), (325,11), (327,15), (333,1), (335,9), (348,13), (358,9), (362,15), (371,3), (376,7), (379,1), (389,11), (396,15)}

T'$_6$ = {(3,15), (7,13), (14,6), (18,3), (29,12), (32,4), (40,5), (53,1), (55,8), (64,15), (70,5), (75,14), (81,5), (90,8), (95,9), (100,8), (103,0), (105,15), (108,13), (110,5), (113,9), (121,12), (124,13), (132,11), (136,12), (140,9), (145,9), (152,6), (159,5), (164,12), (167,1), (171,12), (176,0), (181,6), (183,10), (188,1), (190,9), (199,15), (209,11), (215,6), (232,0), (235,2), (244,2), (248,0), (254,2), (256,0), (260,7), (266,4), (278,0), (281,2), (288,10), (292,10), (295,4), (299,15), (304,2), (314,7), (322,11), (327,0), (336,6), (346,3), (351,9), (353,1), (364,10), (369,15), (371,15), (374,6), (377,14), (386,3), (389,7), (399,10)}

T'$_7$ = {(2,4), (4,7), (9,8), (15,5), (22,4), (30,7), (36,14), (50,5), (54,11), (60,8), (68,12), (71,9), (77,2), (85,10), (91,11), (96,11), (101,5), (104,4), (107,13), (109,13), (111,9), (116,0), (123,12), (131,9), (133,1), (137,11), (144,12), (149,0), (155,7), (162,0), (166,6), (168,9), (174,5), (180,5), (182,0), (184,11), (189,1), (197,6), (203,6), (213,15), (223,3), (234,6), (240,10), (247,6), (253,6), (255,2), (257,10), (265,2), (274,0), (280,4), (286,2), (291,2), (294,1), (297,0), (301,2), (306,3), (321,1), (325,10), (334,11), (338,8), (348,3), (352,8), (355,11), (366,10), (370,14), (373,13), (376,15), (382,5), (387,2), (396,8)}

T'$_8$ = {(1,5), (16,9), (18,0), (21,1), (28,9), (31,1), (36,1), (39,0), (44,13), (55,0), (58,7), (72,11), (74,11), (78,3), (81,2), (87,8), (93,7), (99,7), (108,2), (114,3), (118,10), (120,15), (125,11), (132,0), (140,3), (147,2), (155,13), (167,6), (173,11), (175,10), (181,4), (188,10), (195,10), (200,3), (206,15), (208,12), (212,7), (217,0), (222,4), (228,12), (231,12), (242,14), (253,6), (255,8), (257,6), (261,7), (264,7), (268,8), (275,15), (278,15), (285,3), (289,11), (295,0), (298,4), (307,11), (315,1), (318,5), (324,5), (338,8), (342,13), (347,13), (356,4), (358,13), (360,5), (363,1), (365,0), (371,3), (385,1), (389,0), (398,11)}

T'$_9$ = {(0,0), (5,9), (17,1), (19,0), (26,0), (29,8), (34,7), (37,5), (40,15), (50,9), (56,0), (67,15), (73,1), (76,5), (80,3), (84,0), (89,5), (96,2), (107,14), (110,0), (117,1), (119,10), (123,11), (128,10), (138,10), (143,2), (152,14), (164,13), (171,2), (174,8), (180,7), (182,14), (191,2), (199,9), (204,14), (207,0), (211,6), (213,7), (218,15), (223,2), (230,9), (241,6), (249,15), (254,1), (256,1), (259,11), (262,12), (265,15), (269,12), (277,11), (280,11), (286,13), (293,13), (297,3), (300,12), (311,1), (316,6), (320,4), (326,9), (339,13), (346,5), (348,7), (357,2), (359,2), (361,0), (364,8), (368,13), (375,8), (388,3), (393,5)}

T'$_{10}$ = {(6,9), (12,3), (19,14), (24,15), (31,14), (35,10), (38,6), (41,9), (44,4), (49,7), (59,5), (65,0), (76,10), (84,5), (88,12), (105,14), (109,6), (114,14), (117,3), (121,8), (124,4), (131,14), (135,9), (137,10), (141,8), (144,0), (151,7), (159,12), (169,15), (176,0), (184,1), (193,13), (195,4), (197,4), (209,15), (214,5), (218,14), (222,3), (225,5), (228,9), (232,5), (236,3), (243,8), (247,4), (250,0), (263,8), (267,1), (274,10), (278,15), (282,8), (288,14), (294,10), (300,11), (308,2), (313,8), (319,0), (327,1), (332,4), (335,2), (338,11), (351,4), (354,5), (356,10), (360,1), (363,2), (368,14), (376,10), (379,6), (385,7), (398,15)}

T'$_{11}$ = {(1,14), (8,11), (18,10), (21,9), (25,10), (34,11), (37,8), (40,7), (43,3), (45,14), (53,7), (61,13), (72,11), (83,15), (86,11), (101,5), (108,5), (113,6), (115,13), (119,0), (122,7), (129,1), (132,1), (136,8), (139,3), (142,15), (148,12), (154,11), (166,1), (175,3), (183,13), (186,3), (194,3), (196,3), (205,4), (210,0), (217,10), (219,4), (223,0), (227,9), (229,9), (235,5), (241,1), (245,0), (248,5), (262,8), (266,5), (272,1), (275,1), (281,0), (287,15), (291,14), (298,1), (303,10), (309,10), (317,0), (325,2), (329,2), (333,2), (336,0), (350,10), (353,3), (355,5), (359,6), (362,15), (366,2), (373,6), (378,12), (383,1), (388,14)}

T'₁₂ = {(6,3), (11,15), (15,3), (22,5), (28,12), (33,1), (36,13), (42,8), (44,1), (55,11), (69,9), (71,9), (75,9), (78,10), (81,1), (86,10), (88,13), (95,11), (102,1), (104,9), (110,4), (112,9), (117,2), (120,1), (130,1), (134,4), (138,9), (147,0), (150,11), (155,10), (168,7), (171,3), (180,11), (188,0), (196,3), (201,10), (205,7), (208,13), (215,2), (217,8), (227,14), (231,5), (234,0), (241,6), (248,0), (261,3), (263,5), (266,1), (269,6), (279,2), (287,15), (290,6), (294,1), (296,4), (302,11), (313,10), (321,14), (326,0), (336,4), (342,7), (355,13), (358,11), (369,9), (371,3), (385,2), (388,2), (391,8), (395,2), (397,5), (399,3)}

T'₁₃ = {(4,8), (7,10), (13,11), (16,11), (27,3), (31,12), (34,13), (38,13), (43,12), (54,14), (57,12), (70,1), (73,14), (76,8), (80,8), (84,9), (87,13), (93,0), (101,0), (103,1), (107,1), (111,1), (114,9), (119,1), (122,8), (131,1), (135,10), (139,15), (149,3), (153,2), (165,13), (170,11), (173,8), (185,3), (193,10), (198,1), (203,11), (207,14), (211,4), (216,7), (220,3), (229,5), (233,14), (237,6), (242,6), (258,6), (262,14), (264,2), (268,12), (273,14), (283,14), (288,0), (292,2), (295,10), (300,4), (308,12), (317,6), (325,1), (332,10), (341,10), (343,7), (356,1), (365,7), (370,3), (377,2), (387,4), (390,7), (392,5), (396,1), (398,7)}

T'₁₄ = {(1,1), (4,8), (15,15), (18,14), (22,8), (27,14), (33,10), (38,14), (45,11), (52,14), (59,3), (63,14), (66,14), (74,6), (80,2), (84,0), (99,8), (107,13), (110,1), (121,2), (125,3), (131,7), (137,10), (139,1), (145,7), (147,5), (151,2), (154,10), (165,3), (173,11), (179,9), (184,3), (186,2), (189,6), (196,4), (204,3), (206,5), (215,6), (222,1), (225,1), (229,3), (232,13), (237,2), (242,10), (245,5), (248,9), (251,3), (255,9), (259,1), (263,0), (268,1), (270,9), (276,9), (285,9), (289,11), (292,5), (297,1), (308,1), (314,0), (318,12), (322,12), (328,9), (339,13), (341,0), (347,15), (360,10), (368,5), (375,3), (382,4), (396,11)}

T'₁₅ = {(0,15), (3,6), (10,9), (17,10), (20,9), (25,14), (31,4), (36,3), (41,10), (48,0), (55,10), (62,12), (64,3), (69,0), (77,5), (82,4), (87,6), (103,2), (108,10), (118,12), (122,7), (129,6), (132,7), (138,6), (142,15), (146,3), (148,11), (153,9), (157,0), (168,0), (175,15), (183,8), (185,1), (187,2), (194,9), (203,11), (205,11), (209,1), (219,1), (224,0), (226,1), (231,7), (234,0), (238,2), (243,11), (247,1), (250,2), (253,0), (256,4), (262,9), (267,3), (269,0), (271,8), (281,9), (286,10), (290,8), (293,10), (306,0), (309,1), (317,3), (320,13), (324,12), (336,12), (340,7), (346,15), (348,11), (367,0), (372,11), (378,6), (390,6)}

T'$_{16}$ = {(3,13), (11,9), (24,3), (26,4), (31,4), (34,2), (44,0), (51,8), (54,8), (57,2), (60,1), (64,2), (67,1), (69,5), (72,7), (83,12), (95,13), (98,4), (100,8), (103,8), (108,8), (118,4), (126,11), (130,2), (138,9), (145,0), (149,6), (152,14), (158,14), (162,2), (166,1), (170,10), (178,8), (181,2), (190,0), (196,14), (202,1), (205,0), (209,2), (214,3), (231,9), (239,10), (242,6), (244,14), (247,9), (254,8), (268,7), (277,8), (284,10), (288,7), (295,0), (305,14), (308,10), (312,6), (317,14), (323,11), (328,6), (330,11), (340,13), (345,5), (347,6), (352,7), (355,4), (361,14), (367,3), (372,9), (377,7), (382,6), (389,9), (394,7)}

T'$_{17}$ = {(2,8), (8,11), (16,14), (25,1), (28,12), (33,5), (39,4), (50,3), (52,14), (56,7), (58,8), (63,12), (66,3), (68,12), (70,7), (80,9), (90,9), (97,3), (99,12), (101,2), (105,2), (109,5), (119,5), (127,5), (133,0), (140,4), (147,1), (151,6), (156,1), (161,4), (163,1), (169,1), (177,2), (179,0), (186,4), (193,3), (201,2), (203,0), (207,11), (211,2), (227,3), (233,9), (241,2), (243,8), (245,13), (251,0), (257,0), (276,10), (282,10), (285,3), (292,4), (304,12), (307,13), (310,7), (314,12), (318,13), (324,11), (329,10), (335,11), (344,14), (346,7), (350,13), (354,3), (357,3), (365,5), (370,12), (376,4), (380,12), (386,2), (392,0)}

T'$_{18}$ = {(3,11), (5,15), (10,0), (21,2), (26,1), (33,10), (46,2), (54,8), (62,5), (70,0), (73,9), (80,10), (82,10), (86,6), (91,4), (96,10), (99,2), (111,1), (116,5), (123,10), (138,8), (141,7), (146,14), (152,4), (157,3), (159,13), (167,0), (171,4), (174,1), (177,9), (181,4), (190,9), (196,0), (199,0), (201,0), (204,14), (208,5), (220,8), (229,15), (233,6), (237,8), (247,1), (252,10), (257,7), (263,2), (265,11), (269,0), (271,11), (275,10), (286,2), (296,10), (302,2), (311,3), (316,8), (320,2), (331,13), (333,2), (339,9), (344,6), (346,6), (351,10), (363,4), (367,4), (369,2), (375,1), (378,11), (384,11), (390,10), (394,1), (397,11)}

T'$_{19}$ = {(1,2), (4,1), (9,7), (20,2), (25,8), (32,6), (37,4), (53,7), (58,3), (68,0), (72,0), (74,3), (81,2), (84,13), (89,0), (92,5), (97,5), (102,13), (115,5), (118,4), (132,6), (139,2), (143,7), (149,2), (154,4), (158,1), (162,0), (170,6), (172,4), (175,1), (178,14), (184,12), (195,8), (198,12), (200,0), (202,12), (207,3), (216,15), (226,0), (230,12), (235,8), (246,15), (248,7), (255,12), (258,3), (264,14), (267,2), (270,8), (272,8), (279,6), (293,0), (298,14), (307,7), (313,15), (319,14), (330,10), (332,8), (335,6), (340,2), (345,10), (350,10), (362,14), (366,14), (368,1), (373,0), (377,3), (380,0), (387,4), (392,3), (395,0)}

T'$_{20}$ = {(3,2), (6,11), (9,10), (11,4), (16,14), (18,2), (31,6), (38,2), (43,0), (49,0), (51,12), (53,6), (60,2), (62,6), (69,8), (79,2), (88,0), (92,8), (97,0), (101,14), (108,10), (112,2), (116,10), (124,14), (129,8), (133,10), (143,0), (145,8), (151,10), (157,0), (159,10), (165,8), (171,8), (174,2), (184,2), (192,14), (204,0), (209,2), (219,6), (222,2), (228,2), (237,2), (244,12), (252,14), (255,8), (258,14), (262,8), (273,14), (279,8), (292,2), (299,10), (303,14), (315,0), (320,6), (324,2), (330,4), (332,0), (336,8), (339,0), (343,4), (349,0), (358,8), (367,14), (376,4), (378,12), (381,10), (388,0), (391,8), (394,0), (399,4)}

T'$_{21}$ = {(0,10), (4,6), (8,0), (10,0), (13,12), (17,0), (30,10), (34,8), (42,7), (45,2), (50,8), (52,6), (58,10), (61,8), (67,0), (74,2), (87,4), (91,6), (93,2), (98,10), (104,2), (111,10), (115,2), (122,2), (126,8), (130,0), (135,2), (144,8), (150,8), (156,10), (158,10), (161,0), (170,2), (173,4), (182,14), (191,14), (198,4), (206,15), (216,12), (220,6), (226,6), (232,8), (240,14), (245,0), (253,10), (257,10), (259,4), (267,2), (278,6), (290,10), (296,6), (301,2), (310,6), (319,6), (323,8), (326,6), (331,4), (333,8), (337,10), (340,0), (344,4), (352,8), (366,8), (372,0), (377,14), (379,4), (383,12), (389,8), (393,6), (397,12)}

T'$_{22}$ = {(6,8), (13,10), (16,2), (20,10), (30,0), (37,2), (42,14), (48,12), (51,7), (57,11), (61,1), (73,3), (78,11), (83,2), (90,10), (93,11), (96,15), (98,5), (108,0), (113,4), (116,1), (126,7), (131,3), (138,1), (144,5), (147,11), (149,1), (151,3), (154,3), (164,9), (167,3), (169,7), (178,3), (181,5), (186,5), (193,3), (198,5), (203,13), (212,9), (215,1), (218,15), (220,3), (225,1), (227,6), (230,8), (233,2), (238,2), (244,6), (249,11), (256,1), (265,2), (276,8), (280,0), (286,1), (296,2), (303,2), (311,0), (317,0), (319,0), (327,0), (336,0), (348,8), (358,8), (360,8), (367,10), (373,0), (375,8), (390,10), (394,2), (398,10)}

T'$_{23}$ = {(4,2), (10,10), (15,10), (18,10), (23,6), (32,10), (39,14), (45,0), (49,2), (52,6), (59,11), (66,0), (75,14), (82,3), (87,13), (92,11), (95,1), (97,3), (106,7), (109,3), (115,7), (119,1), (130,14), (135,5), (142,7), (146,9), (148,0), (150,3), (153,3), (159,1), (166,11), (168,3), (170,9), (180,1), (183,1), (192,3), (197,3), (202,3), (210,9), (213,3), (217,1), (219,5), (221,1), (226,3), (229,12), (231,2), (235,10), (239,1), (246,5), (250,9), (262,7), (275,2), (279,14), (283,8), (291,0), (300,2), (309,0), (312,0), (318,12), (323,0), (329,0), (345,8), (354,8), (359,12), (364,0), (371,4), (374,0), (388,1), (391,10), (397,0)}

T'$_{24}$ = {(7,3), (11,13), (16,1), (23,0), (27,8), (30,11), (45,7), (48,7), (59,1), (63,3), (65,7), (70,2), (80,3), (83,7), (85,11), (94,11), (98,9), (101,1), (109,0), (113,9), (117,5), (121,1), (124,3), (128,1), (140,9), (142,5), (160,5), (163,9), (167,11), (176,1), (178,1), (180,2), (185,0), (189,0), (192,15), (202,8), (208,10), (219,2), (224,3), (227,6), (239,3), (241,0), (243,6), (250,4), (252,8), (256,0), (260,1), (265,0), (272,0), (277,2), (284,4), (290,2), (301,10), (311,2), (313,12), (321,10), (323,12), (325,0), (331,2), (335,10), (337,10), (344,10), (349,6), (353,8), (358,2), (360,1), (380,4), (384,11), (392,2), (397,3)}

T'$_{25}$ = {(1,3), (8,1), (14,2), (22,11), (24,15), (28,9), (44,9), (46,3), (50,3), (62,3), (64,3), (66,7), (76,1), (82,5), (84,9), (86,5), (97,5), (100,15), (102,3), (112,9), (114,7), (120,1), (123,1), (127,11), (134,3), (141,9), (152,1), (162,3), (165,1), (172,5), (177,0), (179,6), (181,1), (187,7), (190,2), (198,6), (206,2), (218,0), (221,4), (225,0), (233,6), (240,2), (242,0), (249,4), (251,8), (254,8), (259,1), (263,4), (270,1), (273,4), (278,2), (287,2), (293,6), (307,10), (312,6), (316,10), (322,12), (324,0), (330,8), (334,10), (336,8), (341,14), (347,10), (350,4), (355,0), (359,12), (369,2), (383,14), (391,3), (393,13)}

T'$_{26}$ = {(7,0), (11,11), (13,1), (23,3), (25,3), (31,9), (35,9), (41,11), (43,3), (48,7), (51,13), (53,3), (65,15), (71,1), (85,9), (88,7), (96,3), (102,7), (106,7), (114,2), (120,2), (123,3), (127,1), (130,4), (142,11), (146,3), (148,15), (154,0), (157,9), (162,6), (166,14), (175,8), (179,11), (190,9), (193,4), (199,0), (206,1), (209,0), (212,2), (214,0), (218,1), (222,0), (224,10), (230,0), (236,2), (246,0), (261,10), (271,0), (276,10), (282,0), (284,8), (290,0), (298,10), (304,8), (307,4), (314,4), (316,2), (319,12), (325,12), (334,1), (342,4), (350,1), (352,2), (354,11), (364,13), (368,9), (372,0), (382,4), (385,1), (399,4)}

T'$_{27}$ = {(5,3), (9,1), (12,3), (15,1), (24,3), (27,1), (33,9), (36,9), (42,3), (47,1), (49,11), (52,1), (58,5), (69,13), (81,3), (86,9), (94,11), (97,2), (104,15), (113,10), (115,3), (122,1), (125,5), (129,1), (140,3), (144,1), (147,5), (152,3), (156,2), (160,10), (165,12), (173,8), (176,2), (183,6), (192,10), (195,7), (205,2), (208,6), (210,10), (213,8), (216,10), (221,10), (223,8), (229,10), (231,2), (243,9), (249,13), (266,4), (273,6), (281,6), (283,0), (289,12), (293,2), (300,0), (305,8), (312,0), (315,0), (318,10), (320,8), (329,0), (338,3), (347,9), (351,2), (353,0), (361,9), (365,11), (371,3), (380,3), (384,0), (386,1)}

$T'_{28}$ = {(6,0), (19,2), (25,8), (29,0), (32,0), (40,8), (47,0), (51,2), (54,8), (58,2), (63,0), (66,3), (72,8), (77,0), (79,5), (82,12), (90,1), (92,11), (95,0), (105,10), (109,11), (112,15), (118,9), (124,13), (126,15), (133,11), (140,11), (143,9), (146,11), (155,1), (163,7), (172,1), (178,1), (184,8), (187,11), (197,11), (206,3), (211,3), (219,1),

(225,11), (237,9), (240,3), (252,9), (264,3), (274,9), (276,5), (280,9), (287,1), (293,9), (298,2), (301,1), (313,0), (316,12), (319,12), (321,10), (327,1), (330,0), (334,2), (339,0), (359,1), (365,5), (370,10), (372,2), (379,1), (382,8), (386,4), (388,4), (393,0), (396,2), (399,0)}

$T'_{29}$ = {(0,8), (12,0), (20,0), (26,10), (30,2), (34,0), (41,0), (49,0), (52,2), (55,0), (60,0), (64,0), (69,1), (75,9), (78,0), (81,9), (87,4), (91,15), (94,1), (100,11), (106,10), (110,2), (115,1), (120,3), (125,0), (132,3), (135,3), (141,2), (145,9), (153,7), (161,11), (167,8), (175,15), (183,0), (186,1), (194,3), (201,3), (208,13), (216,3), (223,3), (235,9), (238,3), (246,11), (259,1), (273,2), (275,9), (277,11), (282,9), (289,5), (294,0), (300,3), (310,1), (315,10), (318,0), (320,8), (322,1), (328,2), (331,0), (337,4), (340,2), (362,8), (368,8), (371,1), (374,2), (381,8), (384,4), (387,0), (391,3), (395,2), (398,10)}

$T'_{30}$ = {(4,10), (11,0), (16,0), (26,2), (28,2), (32,3), (38,2), (42,1), (54,10), (59,0), (63,1), (67,11), (71,3), (74,10), (82,0), (87,1), (94,8), (106,9), (116,8), (121,11), (126,9), (131,9), (134,1), (136,1), (140,1), (149,1), (156,1), (158,3), (162,11), (165,9), (172,0), (174,3), (181,1), (185,1), (191,3), (195,9), (201,1), (208,1), (212,8), (215,11), (219,8), (227,11), (232,3), (243,9), (252,2), (260,0), (265,9), (272,1), (281,10), (283,9), (288,10), (291,11), (303,3), (310,2), (318,11), (323,3), (330,1), (337,8), (339,2), (342,0), (344,0), (349,10), (353,8), (359,0), (366,8), (374,10), (379,10), (383,8), (390,2), (395,0)}

$T'_{31}$ = {(2,2), (8,8), (13,0), (21,8), (27,10), (29,0), (36,0), (39,11), (51,2), (56,0), (61,0), (65,3), (68,0), (72,3), (79,1), (84,8), (88,3), (102,1), (112,11), (118,0), (124,3), (127,1), (132,0), (135,1), (139,1), (142,1), (150,1), (157,1), (159,1), (163,1), (166,2), (173,1), (179,1), (184,1), (189,1), (194,9), (197,0), (203,3), (209,8), (214,3), (218,11), (221,1), (230,3), (234,3), (244,11), (253,1), (261,11), (271,11), (273,1), (282,2), (285,8), (289,8), (294,2), (306,10), (317,2), (319,9), (329,1), (333,2), (338,2), (341,10), (343,2), (345,0), (350,0), (356,0), (362,3), (370,0), (377,0), (381,8), (384,0), (391,8)}

$T'_{32}$ = {(11,5), (19,6), (27,6), (30,7), (42,6), (54,4), (56,2), (64,6), (67,2), (72,0), (75,12), (77,4), (80,0), (89,6), (93,6), (96,5), (100,0), (113,14), (118,2), (126,12), (133,6), (137,14), (144,14), (148,2), (151,0), (155,2), (162,2), (164,2), (169,3), (182,12), (187,3), (190,1), (197,1), (210,12), (212,0), (218,3), (224,4), (228,10), (235,8), (237,1), (244,7), (252,0), (258,3), (261,1), (266,1), (270,1), (276,2), (279,0), (284,7), (288,1), (295,7), (298,1), (300,3), (302,1), (304,3), (308,1), (313,1), (321,5), (326,5), (331,10), (334,1), (337,5), (344,4), (356,5), (358,4), (366,5), (374,4), (385,1), (395,4), (398,6)}

$T'_{33}$ = {(7,4), (17,3), (22,5), (29,6), (35,14), (47,14), (55,4), (63,1), (66,0), (71,13), (73,0), (76,10), (79,0), (85,7), (90,4), (94,3), (98,4), (106,2), (116,4), (122,2), (128,6), (136,10), (141,2), (147,4), (150,0), (153,14), (157,2), (163,7), (167,1), (176,1), (185,4), (189,0), (191,11), (203,5), (211,0), (216,0), (220,11), (225,7), (232,3), (236,0), (238,9),

(245,1), (256,1), (260,7), (265,7), (269,5), (275,3), (277,5), (280,7), (285,9), (290,1), (297,9), (299,3), (301,0), (303,1), (305,1), (311,0), (315,1), (325,2), (328,5), (332,13), (335,7), (341,5), (355,4), (357,5), (362,6), (373,4), (381,1), (386,13), (397,5)}

$T'_{34}$ = {(2,5), (12,1), (19,1), (22,5), (24,3), (28,9), (35,13), (39,1), (41,0), (44,10), (47,0), (57,1), (64,5), (68,5), (79,1), (85,1), (91,1), (94,4), (103,3), (105,4), (107,5), (112,7), (119,5), (126,1), (143,2), (145,12), (153,5), (160,4), (168,0), (172,0), (178,4), (188,0), (192,8), (195,4), (200,0), (213,11), (229,1), (231,0), (242,4), (244,4), (247,4), (252,4), (254,4), (264,0), (269,7), (272,0), (281,2), (284,0), (289,2), (299,10), (305,3), (307,7), (320,14), (322,7), (328,6), (331,10), (343,0), (346,0), (352,11), (354,2), (359,1), (363,3), (365,6), (369,5), (378,5), (382,7), (384,12), (386,0), (393,3), (399,1)}

$T'_{35}$ = {(0,1), (7,2), (14,5), (21,5), (23,7), (27,2), (32,1), (37,1), (40,1), (43,1), (46,1), (53,5), (62,11), (65,5), (77,7), (83,2), (86,4), (92,3), (95,4), (104,0), (106,8), (109,7), (113,2), (120,7), (135,1), (144,4), (146,13), (154,5), (164,6), (169,2), (177,13), (179,7), (190,4), (194,8), (196,0), (201,5), (215,4), (230,4), (235,0), (243,0), (246,6), (249,4), (253,4), (258,0), (266,4), (271,0), (274,4), (283,0), (287,6), (298,7), (304,1), (306,4), (309,6), (321,1), (327,7), (329,2), (333,6), (345,3), (351,1), (353,5), (357,2), (362,0), (364,7), (368,5), (374,0), (381,2), (383,3), (385,6), (390,3), (396,1)}

$T'_{36}$ = {(9,3), (14,2), (23,7), (26,2), (29,12), (39,4), (43,3), (48,3), (50,0), (61,2), (65,0), (67,14), (69,4), (74,4), (76,2), (89,6), (93,6), (100,4), (106,1), (122,4), (124,14), (128,0), (130,4), (136,4), (143,5), (148,4), (154,0), (161,4), (170,4), (174,1), (182,5), (188,6), (192,1), (202,0), (211,9), (216,1), (221,1), (223,3), (234,5), (239,5), (255,5), (260,13), (267,7), (272,5), (277,3), (279,1), (283,6), (287,0), (294,1), (297,1), (304,0), (307,5), (313,2), (323,3), (328,2), (332,1), (341,0), (343,3), (348,1), (352,1), (354,1), (357,0), (361,13), (366,0), (375,0), (380,1), (385,0), (387,4), (393,7), (398,5)}

$T'_{37}$ = {(0,2), (10,6), (17,6), (24,7), (28,5), (35,5), (41,5), (47,7), (49,4), (60,2), (62,4), (66,5), (68,2), (70,4), (75,6), (79,2), (91,4), (98,7), (103,4), (114,0), (123,6), (125,14), (129,4), (134,6), (137,4), (146,5), (150,5), (160,4), (164,0), (173,0), (177,4), (187,1), (191,0), (200,7), (210,3), (215,1), (220,0), (222,5), (225,0), (238,0), (254,0), (257,1), (261,7), (268,1), (274,3), (278,5), (281,1), (285,3), (290,1), (296,1), (303,1), (305,5), (310,0), (314,1), (326,1), (329,0), (337,0), (342,3), (344,1), (349,1), (353,2), (356,9), (360,1), (363,1), (370,5), (378,5), (381,4), (386,5), (392,6), (396,5)}

$T'_{38}$ = {(5,12), (9,8), (14,8), (18,10), (21,9), (25,5), (35,12), (40,12), (42,0), (49,1), (52,12), (56,0), (59,14), (61,10), (68,0), (78,6), (89,6), (96,0), (101,8), (105,1), (114,5), (119,1), (123,5), (129,0), (137,9), (141,1), (149,4), (153,4), (158,11), (161,11), (169,12), (179,11), (188,9), (194,5), (198,1), (201,13), (206,13), (211,1), (214,11), (221,2), (234,1), (237,8), (239,3), (242,7), (248,13), (251,7), (259,3), (261,14), (269,5), (274,0), (282,6), (284,0), (295,3), (299,5), (302,2), (305,4), (310,9), (314,13), (332,12), (339,7), (341,14), (348,12), (352,12), (355,1), (361,0), (370,13), (379,12), (381,11),

(392,10), (395,8)}

$T'_{39}$ = {(0,4), (8,4), (10,12), (17,0), (20,4), (23,13), (32,9), (37,0), (41,8), (46,1), (50,13), (55,9), (57,6), (60,4), (67,0), (76,4), (83,0), (91,8), (98,0), (102,6), (110,2), (117,15), (121,10), (127,15), (134,7), (139,10), (148,13), (151,9), (156,10), (160,1), (166,1), (172,2), (187,6), (189,2), (197,0), (200,7), (205,2), (210,9), (212,3), (220,1), (222,1), (236,7), (238,1), (240,1), (245,13), (250,5), (258,5), (260,7), (263,13), (270,9), (279,5), (283,4), (291,5), (296,11), (301,6), (303,5), (306,5), (312,4), (324,5), (333,6), (340,13), (345,13), (349,0), (354,0), (357,8), (364,13), (372,14), (380,4), (383,5), (394,10)} ... (30)

$T'_0 = \{(3,10), (7,12), (14,12), (20,9), (35,1), (46,0), (57,3), (71,12), (78,2), (85,9),$
$(92,4), (99,15), (110,13), (117,7), (125,15), (129,9), (150,12), (158,9), (163,5),$
$(168,11), (175,12), (185,9), (195,9), (202,9), (212,13), (217,3), (226,10), (232,5),$
$(241,7), (251,5), (267,4), (273,4), (278,5), (289,6), (297,12), (309,5), (312,5), (334,9),$
$(338,6), (343,1), (350,1), (361,8), (367,6), (375,12), (379,0), (388,4)\}$

$T'_1 = \{(2,8), (6,8), (12,4), (19,0), (34,8), (45,13), (56,9), (63,8), (77,3), (83,13),$
$(90,15), (97,0), (107,14), (116,9), (121,8), (128,15), (134,12), (156,1), (161,7),$
$(165,13), (172,12), (180,5), (194,8), (200,9), (207,13), (214,13), (224,14), (228,7),$
$(240,7), (250,12), (260,5), (272,4), (276,6), (288,1), (292,4), (302,4), (311,3), (330,10),$
$(337,1), (342,10), (349,9), (357,14), (365,12), (373,4), (377,0), (384,1), (391,3) \}$

$T'_2 = \{(1,8), (5,12), (9,8), (15,0), (26,4), (38,0), (48,13), (62,1), (75,8), (82,13),$
$(88,1), (93,12), (104,5), (111,15), (120,9), (127,14), (131,5), (152,13), (159,13),$
$(164,4), (171,9), (177,13), (193,1), (199,3), (204,3), (213,1), (223,13), (227,5),$
$(236,14), (245,9), (255,5), (268,4), (275,9), (284,8), (291,2), (299,4), (310,4), (326,0),$
$(335,4), (340,14), (347,4), (351,4), (364,0), (369,2), (376,12), (383,0), (389,0) \}$

$T'_3 = \{(8,9), (13,4), (23,12), (30,12), (45,0), (56,4), (73,13), (81,13), (99,5), (107,4),$
$(117,4), (128,5), (136,1), (141,12), (157,12), (161,0), (170,12), (177,4), (182,8),$
$(188,8), (192,1), (199,8), (204,4), (214,4), (224,0), (233,1), (241,0), (251,5), (259,9),$
$(266,0), (271,9), (285,12), (292,8), (305,12), (309,4), (315,13), (322,5), (327,13),$
$(342,12), (347,5), (361,1), (369,5), (374,4), (382,1), (390,5), (394,8)\}$

$T'_4 = \{(5,0), (12,8), (17,1), (29,9), (37,4), (47,8), (65,13), (78,12), (94,5), (102,9),$
$(112,13), (127,12), (134,1), (138,12), (155,0), (160,0), (169,9), (176,4), (180,8),$
$(187,8), (191,8), (198,8), (202,1), (210,1), (221,9), (228,9), (239,0), (249,1), (257,9),$
$(264,1), (270,5), (282,0), (291,0), (302,12), (308,5), (312,13), (321,12), (324,5),$
$(338,1), (346,13), (356,13), (367,5), (373,13), (380,4), (389,13), (393,1), (397,5)\}$

$T'_5 = \{(2,4), (10,8), (14,8), (24,13), (33,9), (46,12), (60,0), (77,13), (89,12), (100,9),$
$(111,5), (125,0), (133,12), (137,0), (143,4), (158,9), (163,8), (174,8), (178,8), (186,12),$
$(189,8), (196,0), (200,0), (207,8), (217,2), (226,12), (236,8), (246,1), (256,8), (263,0),$
$(267,1), (280,8), (286,1), (295,5), (306,9), (311,1), (316,1), (323,1), (328,5), (343,5),$

$(349,0), (363,5), (372,5), (376,1), (387,5), (392,5), (395,9)\}$

$T'_6$ = {(3,3), (12,11), (19,13), (22,11), (38,6), (43,0), (47,3), (53,14), (59,6), (71,10), (79,1), (88,5), (92,10), (103,4), (111,10), (130,12), (139,6), (155,0), (168,5), (182,12), (186,9), (199,10), (207,5), (224,0), (230,4), (236,1), (240,3), (248,1), (251,1), (258,5), (268,6), (274,8), (286,11), (294,12), (299,7), (304,11), (309,15), (316,14), (325,11), (331,11), (335,9), (351,9), (362,15), (375,9), (379,1), (394,13)}

$T'_7$ = {(2,14), (6,10), (15,0), (21,6), (36,13), (40,12), (46,15), (51,7), (58,8), (70,7), (74,14), (86,14), (90,2), (99,14), (105,6), (128,3), (136,2), (145,14), (160,7), (176,12), (185,12), (193,15), (205,8), (217,4), (228,0), (234,12), (239,1), (247,12), (250,4), (254,0), (264,7), (271,1), (280,2), (293,3), (297,5), (302,11), (308,11), (315,8), (322,10), (327,15), (334,5), (348,13), (360,1), (371,3), (378,2), (389,11), (399,13)}

$T'_8$ = {(1,2), (5,3), (13,3), (20,13), (33,10), (39,5), (44,3), (48,13), (57,15), (61,11), (73,10), (85,7), (89,5), (95,6), (104,6), (115,8), (133,4), (142,11), (156,14), (171,10), (183,8), (191,6), (204,0), (213,1), (226,0), (233,0), (238,8), (246,13), (249,8), (253,9), (262,3), (270,4), (277,5), (287,1), (296,7), (301,7), (306,3), (314,15), (317,10), (326,8), (333,1), (345,0), (358,9), (363,3), (376,7), (387,1), (396,15) }

$T'_9$ = {(4,7), (14,6), (22,4), (32,4), (50,5), (55,8), (68,12), (75,14), (85,10), (95,9), (101,5), (105,15), (109,13), (113,9), (123,12), (132,11), (137,11), (145,9), (155,7), (164,12), (168,9), (176,0), (182,0), (188,1), (197,6), (209,11), (223,3), (235,2), (247,6), (254,2), (257,10), (266,4), (280,4), (288,10), (294,1), (299,15), (306,3), (322,11), (334,11), (346,3), (352,8), (364,10), (370,14), (374,6), (382,5), (389,7)}

(100,8), (104,4), (108,13), (111,9), (121,12), (131,9), (136,12), (144,12), (152,6), (162,0), (167,1), (174,5), (181,6), (184,11), (190,9), (203,6), (215,6), (234,6), (244,2), (253,6), (256,0), (265,2), (278,0), (286,2), (292,10), (297,0), (304,2), (321,1), (327,0), (338,8), (351,9), (355,11), (369,15), (373,13), (377,14), (387,2), (399,10)}

$T'_{11}$ = {(2,4), (7,13), (15,5), (29,12), (36,14), (53,1), (60,8), (70,5), (77,2), (90,8), (96,11), (103,0), (107,13), (110,5), (116,0), (124,13), (133,1), (140,9), (149,0), (159,5), (166,6), (171,12), (180,5), (183,10), (189,1), (199,15), (213,15), (232,0), (240,10), (248,0), (255,2), (260,7), (274,0), (281,2), (291,2), (295,4), (301,2), (314,7), (325,10), (336,6), (348,3), (353,1), (366,10), (371,15), (376,15), (386,3), (396,8)}

$T'_{12} = \{(5,9), (18,0), (26,0), (31,1), (37,5), (44,13), (56,0), (72,11), (76,5), (81,2),$
$(89,5), (99,7), (110,0), (118,10), (123,11), (132,0), (143,2), (155,13), (171,2), (175,10),$
$(182,14), (195,10), (204,14), (208,12), (213,7), (222,4), (230,9), (242,14), (254,1),$
$(257,6), (262,12), (268,8), (277,11), (285,3), (293,13), (298,4), (311,1), (318,5),$
$(326,9), (342,13), (348,7), (358,13), (361,0), (365,0), (375,8), (389,0)\}$

$T'_{13} = \{(1,5), (17,1), (21,1), (29,8), (36,1), (40,15), (55,0), (67,15), (74,11), (80,3),$
$(87,8), (96,2), (108,2), (117,1), (120,15), (128,10), (140,3), (152,14), (167,6), (174,8),$

$(181,4), (191,2), (200,3), (207,0), (212,7), (218,15), (228,12), (241,6), (253,6), (256,1),$
$(261,7), (265,15), (275,15), (280,11), (289,11), (297,3), (307,11), (316,6), (324,5),$
$(339,13), (347,13), (357,2), (360,5), (364,8), (371,3), (388,3), (398,11)\}$

$T'_{14} = \{(0,0), (16,9), (19,0), (28,9), (34,7), (39,0), (50,9), (58,7), (73,1), (78,3), (84,0),$
$(93,7), (107,14), (114,3), (119,10), (125,11), (138,10), (147,2), (164,13), (173,11),$
$(180,7), (188,10), (199,9), (206,15), (211,6), (217,0), (223,2), (231,12), (249,15),$
$(255,8), (259,11), (264,7), (269,12), (278,15), (286,13), (295,0), (300,12), (315,1),$
$(320,4), (338,8), (346,5), (356,4), (359,2), (363,1), (368,13), (385,1), (393,5)\}$

$T'_{15} = \{(8,11), (19,14), (25,10), (35,10), (40,7), (44,4), (53,7), (65,0), (83,15),$
$(88,12), (108,5), (114,14), (119,0), (124,4), (132,1), (137,10), (142,15), (151,7),$
$(166,1), (176,0), (186,3), (195,4), (205,4), (214,5), (219,4), (225,5), (229,9), (236,3),$
$(245,0), (250,0), (266,5), (274,10), (281,0), (288,14), (298,1), (308,2), (317,0), (327,1),$
$(333,2), (338,11), (353,3), (356,10), (362,15), (368,14), (378,12), (385,7)\}$

$T'_{16} = \{(6,9), (18,10), (24,15), (34,11), (38,6), (43,3), (49,7), (61,13), (76,10),$
$(86,11), (105,14), (113,6), (117,3), (122,7), (131,14), (136,8), (141,8), (148,12),$
$(159,12), (175,3), (184,1), (194,3), (197,4), (210,0), (218,14), (223,0), (228,9), (235,5),$
$(243,8), (248,5), (263,8), (272,1), (278,15), (287,15), (294,10), (303,10), (313,8),$
$(325,2), (332,4), (336,0), (351,4), (355,5), (360,1), (366,2), (376,10), (383,1),$
$(398,15)\}$

$T'_{17} = \{(1,14), (12,3), (21,9), (31,14), (37,8), (41,9), (45,14), (59,5), (72,11), (84,5),$
$(101,5), (109,6), (115,13), (121,8), (129,1), (135,9), (139,3), (144,0), (154,11),$
$(169,15), (183,13), (193,13), (196,3), (209,15), (217,10), (222,3), (227,9), (232,5),$
$(241,1), (247,4), (262,8), (267,1), (275,1), (282,8), (291,14), (300,11), (309,10),$
$(319,0), (329,2), (335,2), (350,10), (354,5), (359,6), (363,2), (373,6), (379,6),$
$(388,14)\}$

$T'_{18} = \{(7,10), (15,3), (27,3), (33,1), (38,13), (44,1), (57,12), (71,9), (76,8), (81,1),$
$(87,13), (95,11), (103,1), (110,4), (114,9), (120,1), (131,1), (138,9), (149,3), (155,10),$
$(170,11), (180,11), (193,10), (201,10), (207,14), (215,2), (220,3), (231,5), (237,6),$
$(248,0), (262,14), (266,1), (273,14), (287,15), (292,2), (296,4), (308,12), (321,14),$
$(332,10), (342,7), (356,1), (369,9), (377,2), (388,2), (392,5), (397,5)\}$

$T'_{19} = \{(6,3), (13,11), (22,5), (31,12), (36,13), (43,12), (55,11), (70,1), (75,9), (80,8),$
$(86,10), (93,0), (102,1), (107,1), (112,9), (119,1), (130,1), (135,10), (147,0), (153,2),$
$(168,7), (173,8), (188,0), (198,1), (205,7), (211,4), (217,8), (229,5), (234,0), (242,6),$
$(261,3), (264,2), (269,6), (283,14), (290,6), (295,10), (302,11), (317,6), (326,0),$
$(341,10), (355,13), (365,7), (371,3), (387,4), (391,8), (396,1), (399,3)\}$

$T'_{20} = \{(4,8), (11,15), (16,11), (28,12), (34,13), (42,8), (54,14), (69,9), (73,14),$
$(78,10), (84,9), (88,13), (101,0), (104,9), (111,1), (117,2), (122,8), (134,4), (139,15),$
$(150,11), (165,13), (171,3), (185,3), (196,3), (203,11), (208,13), (216,7), (227,14),$

$(233,14), (241,6), (258,6), (263,5), (268,12), (279,2), (288,0), (294,1), (300,4),$
$(313,10), (325,1), (336,4), (343,7), (358,11), (370,3), (385,2), (390,7), (395,2),$
$(398,7)\}$

$T'_{21} = \{(3,6), (15,15), (20,9), (27,14), (36,3), (45,11), (55,10), (63,14), (69,0), (80,2),$
$(87,6), (107,13), (118,12), (125,3), (132,7), (139,1), (146,3), (151,2), (157,0), (173,11),$
$(183,8), (186,2), (194,9), (204,3), (209,1), (222,1), (226,1), (232,13), (238,2), (245,5),$
$(250,2), (255,9), (262,9), (268,1), (271,8), (285,9), (290,8), (297,1), (309,1), (318,12),$
$(324,12), (339,13), (346,15), (360,10), (372,11), (382,4)\}$

$T'_{22} = \{(1,1), (10,9), (18,14), (25,14), (33,10), (41,10), (52,14), (62,12), (66,14),$
$(77,5), (84,0), (103,2), (110,1), (122,7), (131,7), (138,6), (145,7), (148,11), (154,10),$
$(168,0), (179,9), (185,1), (189,6), (203,11), (206,5), (219,1), (225,1), (231,7), (237,2),$
$(243,11), (248,9), (253,0), (259,1), (267,3), (270,9), (281,9), (289,11), (293,10),$
$(308,1), (317,3), (322,12), (336,12), (341,0), (348,11), (368,5), (378,6), (396,11)\}$

T'$_{23}$ = {(0,15), (4,8), (17,10), (22,8), (31,4), (38,14), (48,0), (59,3), (64,3), (74,6), (82,4), (99,8), (108,10), (121,2), (129,6), (137,10), (142,15), (147,5), (153,9), (165,3), (175,15), (184,3), (187,2), (196,4), (205,11), (215,6), (224,0), (229,3), (234,0), (242,10), (247,1), (251,3), (256,4), (263,0), (269,0), (276,9), (286,10), (292,5), (306,0), (314,0), (320,13), (328,9), (340,7), (347,15), (367,0), (375,3), (390,6)}

T'$_{24}$ = {(8,11), (24,3), (28,12), (34,2), (50,3), (54,8), (58,8), (64,2), (68,12), (72,7), (90,9), (98,4), (101,2), (108,8), (119,5), (130,2), (140,4), (149,6), (156,1), (162,2), (169,1), (178,8), (186,4), (196,14), (203,0), (209,2), (227,3), (239,10), (243,8), (247,9), (257,0), (277,8), (285,3), (295,0), (307,13), (312,6), (318,13), (328,6), (335,11), (345,5), (350,13), (355,4), (365,5), (372,9), (380,12), (389,9)}

T'$_{25}$ = {(3,13), (16,14), (26,4), (33,5), (44,0), (52,14), (57,2), (63,12), (67,1), (70,7), (83,12), (97,3), (100,8), (105,2), (118,4), (127,5), (138,9), (147,1), (152,14), (161,4), (166,1), (177,2), (181,2), (193,3), (202,1), (207,11), (214,3), (233,9), (242,6), (245,13), (254,8), (276,10), (284,10), (292,4), (305,14), (310,7), (317,14), (324,11), (330,11), (344,14), (347,6), (354,3), (361,14), (370,12), (377,7), (386,2), (394,7)}

T'$_{26}$ = {(2,8), (11,9), (25,1), (31,4), (39,4), (51,8), (56,7), (60,1), (66,3), (69,5), (80,9), (95,13), (99,12), (103,8), (109,5), (126,11), (133,0), (145,0), (151,6), (158,14), (163,1), (170,10), (179,0), (190,0), (201,2), (205,0), (211,2), (231,9), (241,2), (244,14), (251,0), (268,7), (282,10), (288,7), (304,12), (308,10), (314,12), (323,11), (329,10), (340,13), (346,7), (352,7), (357,3), (367,3), (376,4), (382,6), (392,0)}

T'$_{27}$ = {(4,1), (10,0), (25,8), (33,10), (53,7), (62,5), (72,0), (80,10), (84,13), (91,4), (97,5), (111,1), (118,4), (138,8), (143,7), (152,4), (158,1), (167,0), (172,4), (177,9), (184,12), (196,0), (200,0), (204,14), (216,15), (229,15), (235,8), (247,1), (255,12), (263,2), (267,2), (271,11), (279,6), (296,10), (307,7), (316,8), (330,10), (333,2), (340,2), (346,6), (362,14), (367,4), (373,0), (378,11), (387,4), (394,1)}

T'$_{28}$ = {(3,11), (9,7), (21,2), (32,6), (46,2), (58,3), (70,0), (74,3), (82,10), (89,0), (96,10), (102,13), (116,5), (132,6), (141,7), (149,2), (157,3), (162,0), (171,4), (175,1), (181,4), (195,8), (199,0), (202,12), (208,5), (226,0), (233,6), (246,15), (252,10), (258,3), (265,11), (270,8), (275,10), (293,0), (302,2), (313,15), (320,2), (332,8), (339,9), (345,10), (351,10), (366,14), (369,2), (377,3), (384,11), (392,3), (397,11)}

$T'_{29}$ = {(1,2), (5,15), (20,2), (26,1), (37,4), (54,8), (68,0), (73,9), (81,2), (86,6), (92,5), (99,2), (115,5), (123,10), (139,2), (146,14), (154,4), (159,13), (170,6), (174,1), (178,14), (190,9), (198,12), (201,0), (207,3), (220,8), (230,12), (237,8), (248,7), (257,7), (264,14), (269,0), (272,8), (286,2), (298,14), (311,3), (319,14), (331,13), (335,6), (344,6), (350,10), (363,4), (368,1), (375,1), (380,0), (390,10), (395,0)}

$T'_{30}$ = {(4,6), (9,10), (13,12), (18,2), (34,8), (43,0), (50,8), (53,6), (61,8), (69,8), (87,4), (92,8), (98,10), (108,10), (115,2), (124,14), (130,0), (143,0), (150,8), (157,0), (161,0), (171,8), (182,14), (192,14), (206,15), (219,6), (226,6), (237,2), (245,0), (255,8), (259,4), (273,14), (290,10), (299,10), (310,6), (320,6), (326,6), (332,0), (337,10), (343,4), (352,8), (367,14), (377,14), (381,10), (389,8), (394,0)}

$T'_{31}$ = {(3,2), (8,0), (11,4), (17,0), (31,6), (42,7), (49,0), (52,6), (60,2), (67,0), (79,2), (91,6), (97,0), (104,2), (112,2), (122,2), (129,8), (135,2), (145,8), (156,10), (159,10), (170,2), (174,2), (191,14), (204,0), (216,12), (222,2), (232,8), (244,12), (253,10), (258,14), (267,2), (279,8), (296,6), (303,14), (319,6), (324,2), (331,4), (336,8), (340,0), (349,0), (366,8), (376,4), (379,4), (388,0), (393,6), (399,4)}

$T'_{32}$ = {(0,10), (6,11), (10,0), (16,14), (30,10), (38,2), (45,2), (51,12), (58,10), (62,6), (74,2), (88,0), (93,2), (101,14), (111,10), (116,10), (126,8), (133,10), (144,8), (151,10), (158,10), (165,8), (173,4), (184,2), (198,4), (209,2), (220,6), (228,2), (240,14), (252,14), (257,10), (262,8), (278,6), (292,2), (301,2), (315,0), (323,8), (330,4), (333,8), (339,0), (344,4), (358,8), (372,0), (378,12), (383,12), (391,8), (397,12)}

$T'_{33}$ = {(10,10), (16,2), (23,6), (37,2), (45,0), (51,7), (59,11), (73,3), (82,3), (90,10), (95,1), (98,5), (109,3), (116,1), (130,14), (138,1), (146,9), (149,1), (153,3), (164,9), (168,3), (178,3), (183,1), (193,3), (202,3), (212,9), (217,1), (220,3), (226,3), (230,8), (235,10), (244,6), (250,9), (265,2), (279,14), (286,1), (300,2), (311,0), (318,12), (327,0), (345,8), (358,8), (364,0), (373,0), (388,1), (394,2)}

$T'_{34}$ = {(6,8), (15,10), (20,10), (32,10), (42,14), (49,2), (57,11), (66,0), (78,11), (87,13), (93,11), (97,3), (108,0), (115,7), (126,7), (135,5), (144,5), (148,0), (151,3), (159,1), (167,3), (170,9), (181,5), (192,3), (198,5), (210,9), (215,1), (219,5), (225,1), (229,12), (233,2), (239,1), (249,11), (262,7), (276,8), (283,8), (296,2), (309,0), (317,0), (323,0), (336,0), (354,8), (360,8), (371,4), (375,8), (391,10), (398,10)}

$T'_{35}$ = {(4,2), (13,10), (18,10), (30,0), (39,14), (48,12), (52,6), (61,1), (75,14), (83,2), (92,11), (96,15), (106,7), (113,4), (119,1), (131,3), (142,7), (147,11), (150,3), (154,3), (166,11), (169,7), (180,1), (186,5), (197,3), (203,13), (213,3), (218,15), (221,1),

(227,6), (231,2), (238,2), (246,5), (256,1), (275,2), (280,0), (291,0), (303,2), (312,0), (319,0), (329,0), (348,8), (359,12), (367,10), (374,0), (390,10), (397,0)}

$T'_{36}$ = {(8,1), (16,1), (24,15), (30,11), (46,3), (59,1), (64,3), (70,2), (82,5), (85,11), (97,5), (101,1), (112,9), (117,5), (123,1), (128,1), (141,9), (160,5), (165,1), (176,1), (179,6), (185,0), (190,2), (202,8), (218,0), (224,3), (233,6), (241,0), (249,4), (252,8), (259,1), (265,0), (273,4), (284,4), (293,6), (311,2), (316,10), (323,12), (330,8), (335,10), (341,14), (349,6), (355,0), (360,1), (383,14), (392,2)}

$T'_{37}$ = {(7,3), (14,2), (23,0), (28,9), (45,7), (50,3), (63,3), (66,7), (80,3), (84,9), (94,11), (100,15), (109,0), (114,7), (121,1), (127,11), (140,9), (152,1), (163,9), (172,5), (178,1), (181,1), (189,0), (198,6), (208,10), (221,4), (227,6), (240,2), (243,6), (251,8), (256,0), (263,4), (272,0), (278,2), (290,2), (307,10), (313,12), (322,12), (325,0), (334,10), (337,10), (347,10), (353,8), (359,12), (380,4), (391,3), (397,3)}

$T'_{38}$ = {(1,3), (11,13), (22,11), (27,8), (44,9), (48,7), (62,3), (65,7), (76,1), (83,7), (86,5), (98,9), (102,3), (113,9), (120,1), (124,3), (134,3), (142,5), (162,3), (167,11), (177,0), (180,2), (187,7), (192,15), (206,2), (219,2), (225,0), (239,3), (242,0), (250,4), (254,8), (260,1), (270,1), (277,2), (287,2), (301,10), (312,6), (321,10), (324,0), (331,2), (336,8), (344,10), (350,4), (358,2), (369,2), (384,11), (393,13)}

$T'_{39}$ = {(9,1), (13,1), (24,3), (31,9), (36,9), (43,3), (49,11), (53,3), (69,13), (85,9), (94,11), (102,7), (113,10), (120,2), (125,5), (130,4), (144,1), (148,15), (156,2), (162,6), (173,8), (179,11), (192,10), (199,0), (208,6), (212,2), (216,10), (222,0), (229,10), (236,2), (249,13), (271,0), (281,6), (284,8), (293,2), (304,8), (312,0), (316,2), (320,8), (334,1), (347,9), (352,2), (361,9), (368,9), (380,3), (385,1)}

$T'_{40}$ = {(7,0), (12,3), (23,3), (27,1), (35,9), (42,3), (48,7), (52,1), (65,15), (81,3), (88,7), (97,2), (106,7), (115,3), (123,3), (129,1), (142,11), (147,5), (154,0), (160,10), (166,14), (176,2), (190,9), (195,7), (206,1), (210,10), (214,0), (221,10), (224,10), (231,2), (246,0), (266,4), (276,10), (283,0), (290,0), (300,0), (307,4), (315,0), (319,12), (329,0), (342,4), (351,2), (354,11), (365,11), (372,0), (384,0), (399,4)}

$T'_{41} = \{(5,3), (11,11), (15,1), (25,3), (33,9), (41,11), (47,1), (51,13), (58,5), (71,1),$
$(86,9), (96,3), (104,15), (114,2), (122,1), (127,1), (140,3), (146,3), (152,3), (157,9),$
$(165,12), (175,8), (183,6), (193,4), (205,2), (209,0), (213,8), (218,1), (223,8), (230,0),$
$(243,9), (261,10), (273,6), (282,0), (289,12), (298,10), (305,8), (314,4), (318,10),$
$(325,12), (338,3), (350,1), (353,0), (364,13), (371,3), (382,4), (386,1)\}$

$T'_{42} = \{(12,0), (25,8), (30,2), (40,8), (49,0), (54,8), (60,0), (66,3), (75,9), (79,5),$
$(87,4), (92,11), (100,11), (109,11), (115,1), (124,13), (132,3), (140,11), (145,9),$
$(155,1), (167,8), (178,1), (186,1), (197,11), (208,13), (219,1), (235,9), (240,3), (259,1),$
$(274,9), (277,11), (287,1), (294,0), (301,1), (315,10), (319,12), (322,1), (330,0),$
$(337,4), (359,1), (368,8), (372,2), (381,8), (386,4), (391,3), (396,2)\}$

$T'_{43} = \{(6,0), (20,0), (29,0), (34,0), (47,0), (52,2), (58,2), (64,0), (72,8), (78,0),$

$(82,12), (91,15), (95,0), (106,10), (112,15), (120,3), (126,15), (135,3), (143,9), (153,7),$
$(163,7), (175,15), (184,8), (194,3), (206,3), (216,3), (225,11), (238,3), (252,9), (273,2),$
$(276,5), (282,9), (293,9), (300,3), (313,0), (318,0), (321,10), (328,2), (334,2), (340,2),$
$(365,5), (371,1), (379,1), (384,4), (388,4), (395,2), (399,0)\}$

$T'_{44} = \{(0,8), (19,2), (26,10), (32,0), (41,0), (51,2), (55,0), (63,0), (69,1), (77,0),$
$(81,9), (90,1), (94,1), (105,10), (110,2), (118,9), (125,0), (133,11), (141,2), (146,11),$
$(161,11), (172,1), (183,0), (187,11), (201,3), (211,3), (223,3), (237,9), (246,11),$
$(264,3), (275,9), (280,9), (289,5), (298,2), (310,1), (316,12), (320,8), (327,1), (331,0),$
$(339,0), (362,8), (370,10), (374,2), (382,8), (387,0), (393,0), (398,10)\}$

$T'_{45} = \{(8,8), (16,0), (27,10), (32,3), (39,11), (54,10), (61,0), (67,11), (72,3), (82,0),$
$(88,3), (106,9), (118,0), (126,9), (132,0), (136,1), (142,1), (156,1), (159,1), (165,9),$
$(173,1), (181,1), (189,1), (195,9), (203,3), (212,8), (218,11), (227,11), (234,3), (252,2),$
$(261,11), (272,1), (282,2), (288,10), (294,2), (310,2), (319,9), (330,1), (338,2), (342,0),$
$(345,0), (353,8), (362,3), (374,10), (381,8), (390,2)\}$

$T'_{46} = \{(4,10), (13,0), (26,2), (29,0), (38,2), (51,2), (59,0), (65,3), (71,3), (79,1),$
$(87,1), (102,1), (116,8), (124,3), (131,9), (135,1), (140,1), (150,1), (158,3), (163,1),$
$(172,0), (179,1), (185,1), (194,9), (201,1), (209,8), (215,11), (221,1), (232,3), (244,11),$
$(260,0), (271,11), (281,10), (285,8), (291,11), (306,10), (318,11), (329,1), (337,8),$
$(341,10), (344,0), (350,0), (359,0), (370,0), (379,10), (384,0), (395,0)\}$

$T'_{47}$ = {(2,2), (11,0), (21,8), (28,2), (36,0), (42,1), (56,0), (63,1), (68,0), (74,10), (84,8), (94,8), (112,11), (121,11), (127,1), (134,1), (139,1), (149,1), (157,1), (162,11), (166,2), (174,3), (184,1), (191,3), (197,0), (208,1), (214,3), (219,8), (230,3), (243,9), (253,1), (265,9), (273,1), (283,9), (289,8), (303,3), (317,2), (323,3), (333,2), (339,2), (343,2), (349,10), (356,0), (366,8), (377,0), (383,8), (391,8)}

$T'_{48}$ = {(17,3), (27,6), (35,14), (54,4), (63,1), (67,2), (73,0), (77,4), (85,7), (93,6), (98,4), (113,14), (122,2), (133,6), (141,2), (148,2), (153,14), (162,2), (167,1), (182,12), (189,0), (197,1), (211,0), (218,3), (225,7), (235,8), (238,9), (252,0), (260,7), (266,1), (275,3), (279,0), (285,9), (295,7), (299,3), (302,1), (305,1), (313,1), (325,2), (331,10), (335,7), (344,4), (357,5), (366,5), (381,1), (395,4)}

$T'_{49}$ = {(11,5), (22,5), (30,7), (47,14), (56,2), (66,0), (72,0), (76,10), (80,0), (90,4), (96,5), (106,2), (118,2), (128,6), (137,14), (147,4), (151,0), (157,2), (164,2), (176,1), (187,3), (191,11), (210,12), (216,0), (224,4), (232,3), (237,1), (245,1), (258,3), (265,7), (270,1), (277,5), (284,7), (290,1), (298,1), (301,0), (304,3), (311,0), (321,5), (328,5), (334,1), (341,5), (356,5), (362,6), (374,4), (386,13), (398,6)}

$T'_{50}$ = {(7,4), (19,6), (29,6), (42,6), (55,4), (64,6), (71,13), (75,12), (79,0), (89,6), (94,3), (100,0), (116,4), (126,12), (136,10), (144,14), (150,0), (155,2), (163,7), (169,3), (185,4), (190,1), (203,5), (212,0), (220,11), (228,10), (236,0), (244,7), (256,1), (261,1), (269,5), (276,2), (280,7), (288,1), (297,9), (300,3), (303,1), (308,1), (315,1), (326,5),

(332,13), (337,5), (355,4), (358,4), (373,4), (385,1), (397,5)}

$T'_{51}$ = {(7,2), (19,1), (23,7), (28,9), (37,1), (41,0), (46,1), (57,1), (65,5), (79,1), (86,4), (94,4), (104,0), (107,5), (113,2), (126,1), (144,4), (153,5), (164,6), (172,0), (179,7), (192,8), (196,0), (213,11), (230,4), (242,4), (246,6), (252,4), (258,0), (269,7), (274,4), (284,0), (298,7), (305,3), (309,6), (322,7), (329,2), (343,0), (351,1), (354,2), (362,0), (365,6), (374,0), (382,7), (385,6), (393,3)}

$T'_{52}$ = {(2,5), (14,5), (22,5), (27,2), (35,13), (40,1), (44,10), (53,5), (64,5), (77,7), (85,1), (92,3), (103,3), (106,8), (112,7), (120,7), (143,2), (146,13), (160,4), (169,2), (178,4), (190,4), (195,4), (201,5), (229,1), (235,0), (244,4), (249,4), (254,4), (266,4), (272,0), (283,0), (289,2), (304,1), (307,7), (321,1), (328,6), (333,6), (346,0), (353,5), (359,1), (364,7), (369,5), (381,2), (384,12), (390,3), (399,1)}

T'$_{53}$ = {(0,1), (12,1), (21,5), (24,3), (32,1), (39,1), (43,1), (47,0), (62,11), (68,5), (83,2), (91,1), (95,4), (105,4), (109,7), (119,5), (135,1), (145,12), (154,5), (168,0), (177,13), (188,0), (194,8), (200,0), (215,4), (231,0), (243,0), (247,4), (253,4), (264,0), (271,0), (281,2), (287,6), (299,10), (306,4), (320,14), (327,7), (331,10), (345,3), (352,11), (357,2), (363,3), (368,5), (378,5), (383,3), (386,0), (396,1)}

T'$_{54}$ = {(10,6), (23,7), (28,5), (39,4), (47,7), (50,0), (62,4), (67,14), (70,4), (76,2), (91,4), (100,4), (114,0), (124,14), (129,4), (136,4), (146,5), (154,0), (164,0), (174,1), (187,1), (192,1), (210,3), (216,1), (222,5), (234,5), (254,0), (260,13), (268,1), (277,3), (281,1), (287,0), (296,1), (304,0), (310,0), (323,3), (329,0), (341,0), (344,1), (352,1), (356,9), (361,13), (370,5), (380,1), (386,5), (393,7)}

T'$_{55}$ = {(9,3), (17,6), (26,2), (35,5), (43,3), (49,4), (61,2), (66,5), (69,4), (75,6), (89,6), (98,7), (106,1), (123,6), (128,0), (134,6), (143,5), (150,5), (161,4), (173,0), (182,5), (191,0), (202,0), (215,1), (221,1), (225,0), (239,5), (257,1), (267,7), (274,3), (279,1), (285,3), (294,1), (303,1), (307,5), (314,1), (328,2), (337,0), (343,3), (349,1), (354,1), (360,1), (366,0), (378,5), (385,0), (392,6), (398,5)}

T'$_{56}$ = {(0,2), (14,2), (24,7), (29,12), (41,5), (48,3), (60,2), (65,0), (68,2), (74,4), (79,2), (93,6), (103,4), (122,4), (125,14), (130,4), (137,4), (148,4), (160,4), (170,4), (177,4), (188,6), (200,7), (211,9), (220,0), (223,3), (238,0), (255,5), (261,7), (272,5), (278,5), (283,6), (290,1), (297,1), (305,5), (313,2), (326,1), (332,1), (342,3), (348,1), (353,2), (357,0), (363,1), (375,0), (381,4), (387,4), (396,5)}

T'$_{57}$ = {(8,4), (14,8), (20,4), (25,5), (37,0), (42,0), (50,13), (56,0), (60,4), (68,0), (83,0), (96,0), (102,6), (114,5), (121,10), (129,0), (139,10), (149,4), (156,10), (161,11), (172,2), (188,9), (197,0), (201,13), (210,9), (214,11), (222,1), (237,8), (240,1), (248,13), (258,5), (261,14), (270,9), (282,6), (291,5), (299,5), (303,5), (310,9), (324,5), (339,7), (345,13), (352,12), (357,8), (370,13), (380,4), (392,10)}

T'$_{58}$ = {(5,12), (10,12), (18,10), (23,13), (35,12), (41,8), (49,1), (55,9), (59,14), (67,0), (78,6), (91,8), (101,8), (110,2), (119,1), (127,15), (137,9), (148,13), (153,4), (160,1), (169,12), (187,6), (194,5), (200,7), (206,13), (212,3), (221,2), (236,7), (239,3), (245,13), (251,7), (260,7), (269,5), (279,5), (284,0), (296,11), (302,2), (306,5), (314,13), (333,6), (341,14), (349,0), (355,1), (364,13), (379,12), (383,5), (395,8)}

$T'_{59}$ = {(0,4), (9,8), (17,0), (21,9), (32,9), (40,12), (46,1), (52,12), (57,6), (61,10), (76,4), (89,6), (98,0), (105,1), (117,15), (123,5), (134,7), (141,1), (151,9), (158,11), (166,1), (179,11), (189,2), (198,1), (205,2), (211,1), (220,1), (234,1), (238,1), (242,7), (250,5), (259,3), (263,13), (274,0), (283,4), (295,3), (301,6), (305,4), (312,4), (332,12), (340,13), (348,12), (354,0), (361,0), (372,14), (381,11), (394,10)} ... (31)

$T'_0$ = {(5,12), (12,4), (20,9), (38,0), (56,9), (71,12), (82,13), (90,15), (99,15), (111,15), (121,8), (129,9), (152,13), (161,7), (168,11), (177,13), (194,8), (202,9), (213,1), (224,14), (232,5), (245,9), (260,5), (273,4), (284,8), (292,4), (309,5), (326,0), (337,1), (343,1), (351,4), (365,12), (375,12), (383,0), (391,3)}

$T'_1$ = {(3,10), (9,8), (19,0), (35,1), (48,13), (63,8), (78,2), (88,1), (97,0), (110,13), (120,9), (128,15), (150,12), (159,13), (165,13), (175,12), (193,1), (200,9), (212,13), (223,13), (228,7), (241,7), (255,5), (272,4), (278,5), (291,2), (302,4), (312,5), (335,4), (342,10), (350,1), (364,0), (373,4), (379,0), (389,0)}

$T'_2$ = {(2,8), (7,12), (15,0), (34,8), (46,0), (62,1), (77,3), (85,9), (93,12), (107,14), (117,7), (127,14), (134,12), (158,9), (164,4), (172,12), (185,9), (199,3), (207,13), (217,3), (227,5), (240,7), (251,5), (268,4), (276,6), (289,6), (299,4), (311,3), (334,9), (340,14), (349,9), (361,8), (369,2), (377,0), (388,4)}

$T'_3$ = {(1,8), (6,8), (14,12), (26,4), (45,13), (57,3), (75,8), (83,13), (92,4), (104,5), (116,9), (125,15), (131,5), (156,1), (163,5), (171,9), (180,5), (195,9), (204,3), (214,13), (226,10), (236,14), (250,12), (267,4), (275,9), (288,1), (297,12), (310,4), (330,10), (338,6), (347,4), (357,14), (367,6), (376,12), (384,1)}

$T'_4$ = {(10,8), (17,1), (30,12), (46,12), (65,13), (81,13), (100,9), (112,13), (128,5), (137,0), (155,0), (161,0), (174,8), (180,8), (188,8), (196,0), (202,1), (214,4), (226,12), (239,0), (251,5), (263,0), (270,5), (285,12), (295,5), (308,5), (315,13), (323,1), (338,1), (347,5), (363,5), (373,13), (382,1), (392,5), (397,5)}

$T'_5$ = {(8,9), (14,8), (29,9), (45,0), (60,0), (78,12), (99,5), (111,5), (127,12), (136,1), (143,4), (160,0), (170,12), (178,8), (187,8), (192,1), (200,0), (210,1), (224,0), (236,8), (249,1), (259,9), (267,1), (282,0), (292,8), (306,9), (312,13), (322,5), (328,5), (346,13), (361,1), (372,5), (380,4), (390,5), (395,9)}

$T'_6 = \{(5,0), (13,4), (24,13), (37,4), (56,4), (77,13), (94,5), (107,4), (125,0), (134,1), (141,12), (158,9), (169,9), (177,4), (186,12), (191,8), (199,8), (207,8), (221,9), (233,1), (246,1), (257,9), (266,0), (280,8), (291,0), (305,12), (311,1), (321,12), (327,13), (343,5), (356,13), (369,5), (376,1), (389,13), (394,8)\}$

$T'_7 = \{(2,4), (12,8), (23,12), (33,9), (47,8), (73,13), (89,12), (102,9), (117,4), (133,12), (138,12), (157,12), (163,8), (176,4), (182,8), (189,8), (198,8), (204,4), (217,2), (228,9), (241,0), (256,8), (264,1), (271,9), (286,1), (302,12), (309,4), (316,1), (324,5), (342,12), (349,0), (367,5), (374,4), (387,5), (393,1)\}$

$T'_8 = \{(5,3), (15,0), (22,11), (39,5), (46,15), (53,14), (61,11), (74,14), (88,5), (95,6), (105,6), (130,12), (142,11), (160,7), (182,12), (191,6), (205,8), (224,0), (233,0), (239,1), (248,1), (253,9), (264,7), (274,8), (287,1), (297,5), (304,11), (314,15), (322,10), (331,11), (345,0), (360,1), (375,9), (387,1), (399,13)\}$

$T'_9 = \{(3,3), (13,3), (21,6), (38,6), (44,3), (51,7), (59,6), (73,10), (86,14), (92,10), (104,6), (128,3), (139,6), (156,14), (176,12), (186,9), (204,0), (217,4), (230,4), (238,8), (247,12), (251,1), (262,3), (271,1), (286,11), (296,7), (302,11), (309,15), (317,10), (327,15), (335,9), (358,9), (371,3), (379,1), (396,15)\}$

$T'_{10} = \{(2,14), (12,11), (20,13), (36,13), (43,0), (48,13), (58,8), (71,10), (85,7), (90,2), (103,4), (115,8), (136,2), (155,0), (171,10), (185,12), (199,10), (213,1), (228,0), (236,1), (246,13), (250,4), (258,5), (270,4), (280,2), (294,12), (301,7), (308,11), (316,14), (326,8), (334,5), (351,9), (363,3), (378,2), (394,13)\}$

$T'_{11} = \{(1,2), (6,10), (19,13), (33,10), (40,12), (47,3), (57,15), (70,7), (79,1), (89,5), (99,14), (111,10), (133,4), (145,14), (168,5), (183,8), (193,15), (207,5), (226,0), (234,12), (240,3), (249,8), (254,0), (268,6), (277,5), (293,3), (299,7), (306,3), (315,8), (325,11), (333,1), (348,13), (362,15), (376,7), (389,11)\}$

$T'_{12} = \{(7,13), (18,3), (32,4), (53,1), (64,15), (75,14), (90,8), (100,8), (105,15), (110,5), (121,12), (132,11), (140,9), (152,6), (164,12), (171,12), (181,6), (188,1), (199,15), (215,6), (235,2), (248,0), (256,0), (266,4), (281,2), (292,10), (299,15), (314,7), (327,0), (346,3), (353,1), (369,15), (374,6), (386,3), (399,10)\}$

T'$_{13}$ = {(4,7), (15,5), (30,7), (50,5), (60,8), (71,9), (85,10), (96,11), (104,4), (109,13), (116,0), (131,9), (137,11), (149,0), (162,0), (168,9), (180,5), (184,11), (197,6), (213,15), (234,6), (247,6), (255,2), (265,2), (280,4), (291,2), (297,0), (306,3), (325,10), (338,8), (352,8), (366,10), (373,13), (382,5), (396,8)}

T'$_{14}$ = {(3,15), (14,6), (29,12), (40,5), (55,8), (70,5), (81,5), (95,9), (103,0), (108,13), (113,9), (124,13), (136,12), (145,9), (159,5), (167,1), (176,0), (183,10), (190,9), (209,11), (232,0), (244,2), (254,2), (260,7), (278,0), (288,10), (295,4), (304,2), (322,11), (336,6), (351,9), (364,10), (371,15), (377,14), (389,7)}

T'$_{15}$ = {(2,4), (9,8), (22,4), (36,14), (54,11), (68,12), (77,2), (91,11), (101,5), (107,13), (111,9), (123,12), (133,1), (144,12), (155,7), (166,6), (174,5), (182,0), (189,1), (203,6), (223,3), (240,10), (253,6), (257,10), (274,0), (286,2), (294,1), (301,2), (321,1), (334,11), (348,3), (355,11), (370,14), (376,15), (387,2)}

T'$_{16}$ = {(16,9), (21,1), (31,1), (39,0), (55,0), (72,11), (78,3), (87,8), (99,7), (114,3), (120,15), (132,0), (147,2), (167,6), (175,10), (188,10), (200,3), (208,12), (217,0), (228,12), (242,14), (255,8), (261,7), (268,8), (278,15), (289,11), (298,4), (315,1), (324,5), (342,13), (356,4), (360,5), (365,0), (385,1), (398,11)}

T'$_{17}$ = {(5,9), (19,0), (29,8), (37,5), (50,9), (67,15), (76,5), (84,0), (96,2), (110,0), (119,10), (128,10), (143,2), (164,13), (174,8), (182,14), (199,9), (207,0), (213,7), (223,2), (241,6), (254,1), (259,11), (265,15), (277,11), (286,13), (297,3), (311,1), (320,4), (339,13), (348,7), (359,2), (364,8), (375,8), (393,5)}

T'$_{18}$ = {(1,5), (18,0), (28,9), (36,1), (44,13), (58,7), (74,11), (81,2), (93,7), (108,2), (118,10), (125,11), (140,3), (155,13), (173,11), (181,4), (195,10), (206,15), (212,7), (222,4), (231,12), (253,6), (257,6), (264,7), (275,15), (285,3), (295,0), (307,11), (318,5), (338,8), (347,13), (358,13), (363,1), (371,3), (389,0)}

T'$_{19}$ = {(0,0), (17,1), (26,0), (34,7), (40,15), (56,0), (73,1), (80,3), (89,5), (107,14), (117,1), (123,11), (138,10), (152,14), (171,2), (180,7), (191,2), (204,14), (211,6), (218,15), (230,9), (249,15), (256,1), (262,12), (269,12), (280,11), (293,13), (300,12), (316,6), (326,9), (346,5), (357,2), (361,0), (368,13), (388,3)}

$T'_{20}$ = {(12,3), (24,15), (35,10), (41,9), (49,7), (65,0), (84,5), (105,14), (114,14), (121,8), (131,14), (137,10), (144,0), (159,12), (176,0), (193,13), (197,4), (214,5), (222,3), (228,9), (236,3), (247,4), (263,8), (274,10), (282,8), (294,10), (308,2), (319,0), (332,4), (338,11), (354,5), (360,1), (368,14), (379,6), (398,15)}

$T'_{21}$ = {(8,11), (21,9), (34,11), (40,7), (45,14), (61,13), (83,15), (101,5), (113,6), (119,0), (129,1), (136,8), (142,15), (154,11), (175,3), (186,3), (196,3), (210,0), (219,4), (227,9), (235,5), (245,0), (262,8), (272,1), (281,0), (291,14), (303,10), (317,0), (329,2), (336,0), (353,3), (359,6), (366,2), (378,12), (388,14)}

$T'_{22}$ = {(6,9), (19,14), (31,14), (38,6), (44,4), (59,5), (76,10), (88,12), (109,6), (117,3), (124,4), (135,9), (141,8), (151,7), (169,15), (184,1), (195,4), (209,15), (218,14), (225,5), (232,5), (243,8), (250,0), (267,1), (278,15), (288,14), (300,11), (313,8), (327,1), (335,2), (351,4), (356,10), (363,2), (376,10), (385,7)}

$T'_{23}$ = {(1,14), (18,10), (25,10), (37,8), (43,3), (53,7), (72,11), (86,11), (108,5), (115,13), (122,7), (132,1), (139,3), (148,12), (166,1), (183,13), (194,3), (205,4), (217,10), (223,0), (229,9), (241,1), (248,5), (266,5), (275,1), (287,15), (298,1), (309,10), (325,2), (333,2), (350,10), (355,5), (362,15), (373,6), (383,1)}

$T'_{24}$ = {(11,15), (22,5), (33,1), (42,8), (55,11), (71,9), (78,10), (86,10), (95,11), (104,9), (112,9), (120,1), (134,4), (147,0), (155,10), (171,3), (188,0), (201,10), (208,13), (217,8), (231,5), (241,6), (261,3), (266,1), (279,2), (290,6), (296,4), (313,10), (326,0), (342,7), (358,11), (371,3), (388,2), (395,2), (399,3)}

$T'_{25}$ = {(7,10), (16,11), (31,12), (38,13), (54,14), (70,1), (76,8), (84,9), (93,0), (103,1), (111,1), (119,1), (131,1), (139,15), (153,2), (170,11), (185,3), (198,1), (207,14), (216,7), (229,5), (237,6), (258,6), (264,2), (273,14), (288,0), (295,10), (308,12), (325,1), (341,10), (356,1), (370,3), (387,4), (392,5), (398,7)}

$T'_{26}$ = {(6,3), (15,3), (28,12), (36,13), (44,1), (69,9), (75,9), (81,1), (88,13), (102,1), (110,4), (117,2), (130,1), (138,9), (150,11), (168,7), (180,11), (196,3), (205,7), (215,2), (227,14), (234,0), (248,0), (263,5), (269,6), (287,15), (294,1), (302,11), (321,14), (336,4), (355,13), (369,9), (385,2), (391,8), (397,5)}

$T'_{27} = \{(4,8), (13,11), (27,3), (34,13), (43,12), (57,12), (73,14), (80,8), (87,13),$
$(101,0), (107,1), (114,9), (122,8), (135,10), (149,3), (165,13), (173,8), (193,10),$
$(203,11), (211,4), (220,3), (233,14), (242,6), (262,14), (268,12), (283,14), (292,2),$
$(300,4), (317,6), (332,10), (343,7), (365,7), (377,2), (390,7), (396,1)\}$

$T'_{28} = \{(4,8), (18,14), (27,14), (38,14), (52,14), (63,14), (74,6), (84,0), (107,13),$
$(121,2), (131,7), (139,1), (147,5), (154,10), (173,11), (184,3), (189,6), (204,3), (215,6),$
$(225,1), (232,13), (242,10), (248,9), (255,9), (263,0), (270,9), (285,9), (292,5), (308,1),$
$(318,12), (328,9), (341,0), (360,10), (375,3), (396,11)\}$

$T'_{29} = \{(3,6), (17,10), (25,14), (36,3), (48,0), (62,12), (69,0), (82,4), (103,2),$
$(118,12), (129,6), (138,6), (146,3), (153,9), (168,0), (183,8), (187,2), (203,11), (209,1),$
$(224,0), (231,7), (238,2), (247,1), (253,0), (262,9), (269,0), (281,9), (290,8), (306,0),$
$(317,3), (324,12), (340,7), (348,11), (372,11), (390,6)\}$

$T'_{30} = \{(1,1), (15,15), (22,8), (33,10), (45,11), (59,3), (66,14), (80,2), (99,8), (110,1),$
$(125,3), (137,10), (145,7), (151,2), (165,3), (179,9), (186,2), (196,4), (206,5), (222,1),$
$(229,3), (237,2), (245,5), (251,3), (259,1), (268,1), (276,9), (289,11), (297,1), (314,0),$
$(322,12), (339,13), (347,15), (368,5), (382,4)\}$

$T'_{31} = \{(0,15), (10,9), (20,9), (31,4), (41,10), (55,10), (64,3), (77,5), (87,6), (108,10),$
$(122,7), (132,7), (142,15), (148,11), (157,0), (175,15), (185,1), (194,9), (205,11),$
$(219,1), (226,1), (234,0), (243,11), (250,2), (256,4), (267,3), (271,8), (286,10),$
$(293,10), (309,1), (320,13), (336,12), (346,15), (367,0), (378,6)\}$

$T'_{32} = \{(11,9), (26,4), (34,2), (51,8), (57,2), (64,2), (69,5), (83,12), (98,4), (103,8),$
$(118,4), (130,2), (145,0), (152,14), (162,2), (170,10), (181,2), (196,14), (205,0),$
$(214,3), (239,10), (244,14), (254,8), (277,8), (288,7), (305,14), (312,6), (323,11),$
$(330,11), (345,5), (352,7), (361,14), (372,9), (382,6), (394,7)\}$

$T'_{33} = \{(8,11), (25,1), (33,5), (50,3), (56,7), (63,12), (68,12), (80,9), (97,3), (101,2),$
$(109,5), (127,5), (140,4), (151,6), (161,4), (169,1), (179,0), (193,3), (203,0), (211,2),$
$(233,9), (243,8), (251,0), (276,10), (285,3), (304,12), (310,7), (318,13), (329,10),$
$(344,14), (350,13), (357,3), (370,12), (380,12), (392,0)\}$

T'$_{34}$ = {(3,13), (24,3), (31,4), (44,0), (54,8), (60,1), (67,1), (72,7), (95,13), (100,8), (108,8), (126,11), (138,9), (149,6), (158,14), (166,1), (178,8), (190,0), (202,1), (209,2), (231,9), (242,6), (247,9), (268,7), (284,10), (295,0), (308,10), (317,14), (328,6), (340,13), (347,6), (355,4), (367,3), (377,7), (389,9)}

T'$_{35}$ = {(2,8), (16,14), (28,12), (39,4), (52,14), (58,8), (66,3), (70,7), (90,9), (99,12), (105,2), (119,5), (133,0), (147,1), (156,1), (163,1), (177,2), (186,4), (201,2), (207,11), (227,3), (241,2), (245,13), (257,0), (282,10), (292,4), (307,13), (314,12), (324,11), (335,11), (346,7), (354,3), (365,5), (376,4), (386,2)}

T'$_{36}$ = {(5,15), (21,2), (33,10), (54,8), (70,0), (80,10), (86,6), (96,10), (111,1), (123,10), (141,7), (152,4), (159,13), (171,4), (177,9), (190,9), (199,0), (204,14), (220,8), (233,6), (247,1), (257,7), (265,11), (271,11), (286,2), (302,2), (316,8), (331,13), (339,9), (346,6), (363,4), (369,2), (378,11), (390,10), (397,11)}

T'$_{37}$ = {(4,1), (20,2), (32,6), (53,7), (68,0), (74,3), (84,13), (92,5), (102,13), (118,4), (139,2), (149,2), (158,1), (170,6), (175,1), (184,12), (198,12), (202,12), (216,15), (230,12), (246,15), (255,12), (264,14), (270,8), (279,6), (298,14), (313,15), (330,10), (335,6), (345,10), (362,14), (368,1), (377,3), (387,4), (395,0)}

T'$_{38}$ = {(3,11), (10,0), (26,1), (46,2), (62,5), (73,9), (82,10), (91,4), (99,2), (116,5), (138,8), (146,14), (157,3), (167,0), (174,1), (181,4), (196,0), (201,0), (208,5), (229,15), (237,8), (252,10), (263,2), (269,0), (275,10), (296,10), (311,3), (320,2), (333,2), (344,6), (351,10), (367,4), (375,1), (384,11), (394,1)}

T'$_{39}$ = {(1,2), (9,7), (25,8), (37,4), (58,3), (72,0), (81,2), (89,0), (97,5), (115,5), (132,6), (143,7), (154,4), (162,0), (172,4), (178,14), (195,8), (200,0), (207,3), (226,0), (235,8), (248,7), (258,3), (267,2), (272,8), (293,0), (307,7), (319,14), (332,8), (340,2), (350,10), (366,14), (373,0), (380,0), (392,3)}

T'$_{40}$ = {(6,11), (11,4), (18,2), (38,2), (49,0), (53,6), (62,6), (79,2), (92,8), (101,14), (112,2), (124,14), (133,10), (145,8), (157,0), (165,8), (174,2), (192,14), (209,2), (222,2), (237,2), (252,14), (258,14), (273,14), (292,2), (303,14), (320,6), (330,4), (336,8), (343,4), (358,8), (376,4), (381,10), (391,8), (399,4) }

T'$_{41}$ = {(4,6), (10,0), (17,0), (34,8), (45,2), (52,6), (61,8), (74,2), (91,6), (98,10), (111,10), (122,2), (130,0), (144,8), (156,10), (161,0), (173,4), (191,14), (206,15), (220,6), (232,8), (245,0), (257,10), (267,2), (290,10), (301,2), (319,6), (326,6), (333,8), (340,0), (352,8), (372,0), (379,4), (389,8), (397,12)}

T'$_{42}$ = {(3,2), (9,10), (16,14), (31,6), (43,0), (51,12), (60,2), (69,8), (88,0), (97,0), (108,10), (116,10), (129,8), (143,0), (151,10), (159,10), (171,8), (184,2), (204,0), (219,6), (228,2), (244,12), (255,8), (262,8), (279,8), (299,10), (315,0), (324,2), (332,0), (339,0), (349,0), (367,14), (378,12), (388,0), (394,0)}

T'$_{43}$ = {(0,10), (8,0), (13,12), (30,10), (42,7), (50,8), (58,10), (67,0), (87,4), (93,2), (104,2), (115,2), (126,8), (135,2), (150,8), (158,10), (170,2), (182,14), (198,4), (216,12), (226,6), (240,14), (253,10), (259,4), (278,6), (296,6), (310,6), (323,8), (331,4), (337,10), (344,4), (366,8), (377,14), (383,12), (393,6)}

T'$_{44}$ = {(13,10), (20,10), (37,2), (48,12), (57,11), (73,3), (83,2), (93,11), (98,5), (113,4), (126,7), (138,1), (147,11), (151,3), (164,9), (169,7), (181,5), (193,3), (203,13), (215,1), (220,3), (227,6), (233,2), (244,6), (256,1), (276,8), (286,1), (303,2), (317,0), (327,0), (348,8), (360,8), (373,0), (390,10), (398,10)}

T'$_{45}$ = {(10,10), (18,10), (32,10), (45,0), (52,6), (66,0), (82,3), (92,11), (97,3), (109,3), (119,1), (135,5), (146,9), (150,3), (159,1), (168,3), (180,1), (192,3), (202,3), (213,3), (219,5), (226,3), (231,2), (239,1), (250,9), (275,2), (283,8), (300,2), (312,0), (323,0), (345,8), (359,12), (371,4), (388,1), (397,0)}

T'$_{46}$ = {(6,8), (16,2), (30,0), (42,14), (51,7), (61,1), (78,11), (90,10), (96,15), (108,0), (116,1), (131,3), (144,5), (149,1), (154,3), (167,3), (178,3), (186,5), (198,5), (212,9), (218,15), (225,1), (230,8), (238,2), (249,11), (265,2), (280,0), (296,2), (311,0), (319,0), (336,0), (358,8), (367,10), (375,8), (394,2)}

T'$_{47}$ = {(4,2), (15,10), (23,6), (39,14), (49,2), (59,11), (75,14), (87,13), (95,1), (106,7), (115,7), (130,14), (142,7), (148,0), (153,3), (166,11), (170,9), (183,1), (197,3), (210,9), (217,1), (221,1), (229,12), (235,10), (246,5), (262,7), (279,14), (291,0), (309,0), (318,12), (329,0), (354,8), (364,0), (374,0), (391,10)}

$T'_{48} = \{(11,13), (23,0), (30,11), (48,7), (63,3), (70,2), (83,7), (94,11), (101,1),$ $(113,9), (121,1), (128,1), (142,5), (163,9), (176,1), (180,2), (189,0), (202,8), (219,2),$ $(227,6), (241,0), (250,4), (256,0), (265,0), (277,2), (290,2), (311,2), (321,10), (325,0),$ $(335,10), (344,10), (353,8), (360,1), (384,11), (397,3)\}$

$T'_{49} = \{(8,1), (22,11), (28,9), (46,3), (62,3), (66,7), (82,5), (86,5), (100,15), (112,9),$ $(120,1), (127,11), (141,9), (162,3), (172,5), (179,6), (187,7), (198,6), (218,0), (225,0),$ $(240,2), (249,4), (254,8), (263,4), (273,4), (287,2), (307,10), (316,10), (324,0),$ $(334,10), (341,14), (350,4), (359,12), (383,14), (393,13)\}$

$T'_{50} = \{(7,3), (16,1), (27,8), (45,7), (59,1), (65,7), (80,3), (85,11), (98,9), (109,0),$ $(117,5), (124,3), (140,9), (160,5), (167,11), (178,1), (185,0), (192,15), (208,10),$ $(224,3), (239,3), (243,6), (252,8), (260,1), (272,0), (284,4), (301,10), (313,12),$ $(323,12), (331,2), (337,10), (349,6), (358,2), (380,4), (392,2)\}$

$T'_{51} = \{(1,3), (14,2), (24,15), (44,9), (50,3), (64,3), (76,1), (84,9), (97,5), (102,3),$ $(114,7), (123,1), (134,3), (152,1), (165,1), (177,0), (181,1), (190,2), (206,2), (221,4),$ $(233,6), (242,0), (251,8), (259,1), (270,1), (278,2), (293,6), (312,6), (322,12), (330,8),$ $(336,8), (347,10), (355,0), (369,2), (391,3)\}$

$T'_{52} = \{(11,11), (23,3), (31,9), (41,11), (48,7), (53,3), (71,1), (88,7), (102,7), (114,2),$ $(123,3), (130,4), (146,3), (154,0), (162,6), (175,8), (190,9), (199,0), (209,0), (214,0),$ $(222,0), (230,0), (246,0), (271,0), (282,0), (290,0), (304,8), (314,4), (319,12), (334,1),$ $(350,1), (354,11), (368,9), (382,4), (399,4)\}$

$T'_{53} = \{(9,1), (15,1), (27,1), (36,9), (47,1), (52,1), (69,13), (86,9), (97,2), (113,10),$ $(122,1), (129,1), (144,1), (152,3), (160,10), (173,8), (183,6), (195,7), (208,6), (213,8),$ $(221,10), (229,10), (243,9), (266,4), (281,6), (289,12), (300,0), (312,0), (318,10),$ $(329,0), (347,9), (353,0), (365,11), (380,3), (386,1)\}$

$T'_{54} = \{(7,0), (13,1), (25,3), (35,9), (43,3), (51,13), (65,15), (85,9), (96,3), (106,7),$ $(120,2), (127,1), (142,11), (148,15), (157,9), (166,14), (179,11), (193,4), (206,1),$ $(212,2), (218,1), (224,10), (236,2), (261,10), (276,10), (284,8), (298,10), (307,4),$ $(316,2), (325,12), (342,4), (352,2), (364,13), (372,0), (385,1)\}$

$T'_{55} = \{(5,3), (12,3), (24,3), (33,9), (42,3), (49,11), (58,5), (81,3), (94,11), (104,15),$
$(115,3), (125,5), (140,3), (147,5), (156,2), (165,12), (176,2), (192,10), (205,2),$
$(210,10), (216,10), (223,8), (231,2), (249,13), (273,6), (283,0), (293,2), (305,8),$
$(315,0), (320,8), (338,3), (351,2), (361,9), (371,3), (384,0)\}$

$T'_{56} = \{(19,2), (29,0), (40,8), (51,2), (58,2), (66,3), (77,0), (82,12), (92,11), (105,10),$
$(112,15), (124,13), (133,11), (143,9), (155,1), (172,1), (184,8), (197,11), (211,3),$
$(225,11), (240,3), (264,3), (276,5), (287,1), (298,2), (313,0), (319,12), (327,1), (334,2),$
$(359,1), (370,10), (379,1), (386,4), (393,0), (399,0)\}$

$T'_{57} = \{(12,0), (26,10), (34,0), (49,0), (55,0), (64,0), (75,9), (81,9), (91,15), (100,11),$
$(110,2), (120,3), (132,3), (141,2), (153,7), (167,8), (183,0), (194,3), (208,13), (223,3),$
$(238,3), (259,1), (275,9), (282,9), (294,0), (310,1), (318,0), (322,1), (331,0), (340,2),$
$(368,8), (374,2), (384,4), (391,3), (398,10)\}$

$T'_{58} = \{(6,0), (25,8), (32,0), (47,0), (54,8), (63,0), (72,8), (79,5), (90,1), (95,0),$
$(109,11), (118,9), (126,15), (140,11), (146,11), (163,7), (178,1), (187,11), (206,3),$
$(219,1), (237,9), (252,9), (274,9), (280,9), (293,9), (301,1), (316,12), (321,10), (330,0),$
$(339,0), (365,5), (372,2), (382,8), (388,4), (396,2)\}$

$T'_{59} = \{(0,8), (20,0), (30,2), (41,0), (52,2), (60,0), (69,1), (78,0), (87,4), (94,1),$
$(106,10), (115,1), (125,0), (135,3), (145,9), (161,11), (175,15), (186,1), (201,3),$
$(216,3), (235,9), (246,11), (273,2), (277,11), (289,5), (300,3), (315,10), (320,8),$
$(328,2), (337,4), (362,8), (371,1), (381,8), (387,0), (395,2)\}$

$T'_{60} = \{(11,0), (26,2), (32,3), (42,1), (59,0), (67,11), (74,10), (87,1), (106,9),$
$(121,11), (131,9), (136,1), (149,1), (158,3), (165,9), (174,3), (185,1), (195,9), (208,1),$
$(215,11), (227,11), (243,9), (260,0), (272,1), (283,9), (291,11), (310,2), (323,3),$
$(337,8), (342,0), (349,10), (359,0), (374,10), (383,8), (395,0)\}$

$T'_{61} = \{(8,8), (21,8), (29,0), (39,11), (56,0), (65,3), (72,3), (84,8), (102,1), (118,0),$
$(127,1), (135,1), (142,1), (157,1), (163,1), (173,1), (184,1), (194,9), (203,3), (214,3),$
$(221,1), (234,3), (253,1), (271,11), (282,2), (289,8), (306,10), (319,9), (333,2),$
$(341,10), (345,0), (356,0), (370,0), (381,8), (391,8)\}$

$T'_{62}$ = {(4,10), (16,0), (28,2), (38,2), (54,10), (63,1), (71,3), (82,0), (94,8), (116,8), (126,9), (134,1), (140,1), (156,1), (162,11), (172,0), (181,1), (191,3), (201,1), (212,8), (219,8), (232,3), (252,2), (265,9), (281,10), (288,10), (303,3), (318,11), (330,1), (339,2), (344,0), (353,8), (366,8), (379,10), (390,2)}

$T'_{63}$ = {(2,2), (13,0), (27,10), (36,0), (51,2), (61,0), (68,0), (79,1), (88,3), (112,11), (124,3), (132,0), (139,1), (150,1), (159,1), (166,2), (179,1), (189,1), (197,0), (209,8), (218,11), (230,3), (244,11), (261,11), (273,1), (285,8), (294,2), (317,2), (329,1), (338,2), (343,2), (350,0), (362,3), (377,0), (384,0)}

$T'_{64}$ = {(19,6), (30,7), (54,4), (64,6), (72,0), (77,4), (89,6), (96,5), (113,14), (126,12), (137,14), (148,2), (155,2), (164,2), (182,12), (190,1), (210,12), (218,3), (228,10), (237,1), (252,0), (261,1), (270,1), (279,0), (288,1), (298,1), (302,1), (308,1), (321,5), (331,10), (337,5), (356,5), (366,5), (385,1), (398,6)}

$T'_{65}$ = {(17,3), (29,6), (47,14), (63,1), (71,13), (76,10), (85,7), (94,3), (106,2), (122,2), (136,10), (147,4), (153,14), (163,7), (176,1), (189,0), (203,5), (216,0), (225,7), (236,0), (245,1), (260,7), (269,5), (277,5), (285,9), (297,9), (301,0), (305,1), (315,1), (328,5), (335,7), (355,4), (362,6), (381,1), (397,5)}

$T'_{66}$ = {(11,5), (27,6), (42,6), (56,2), (67,2), (75,12), (80,0), (93,6), (100,0), (118,2), (133,6), (144,14), (151,0), (162,2), (169,3), (187,3), (197,1), (212,0), (224,4), (235,8), (244,7), (258,3), (266,1), (276,2), (284,7), (295,7), (300,3), (304,3), (313,1), (326,5), (334,1), (344,4), (358,4), (374,4), (395,4)}

$T'_{67}$ = {(7,4), (22,5), (35,14), (55,4), (66,0), (73,0), (79,0), (90,4), (98,4), (116,4), (128,6), (141,2), (150,0), (157,2), (167,1), (185,4), (191,11), (211,0), (220,11), (232,3), (238,9), (256,1), (265,7), (275,3), (280,7), (290,1), (299,3), (303,1), (311,0), (325,2), (332,13), (341,5), (357,5), (373,4), (386,13)}

$T'_{68}$ = {(12,1), (22,5), (28,9), (39,1), (44,10), (57,1), (68,5), (85,1), (94,4), (105,4), (112,7), (126,1), (145,12), (160,4), (172,0), (188,0), (195,4), (213,11), (231,0), (244,4), (252,4), (264,0), (272,0), (284,0), (299,10), (307,7), (322,7), (331,10), (346,0), (354,2), (363,3), (369,5), (382,7), (386,0), (399,1)}

$T'_{69} = \{(7,2), (21,5), (27,2), (37,1), (43,1), (53,5), (65,5), (83,2), (92,3), (104,0),$
$(109,7), (120,7), (144,4), (154,5), (169,2), (179,7), (194,8), (201,5), (230,4), (243,0),$
$(249,4), (258,0), (271,0), (283,0), (298,7), (306,4), (321,1), (329,2), (345,3), (353,5),$
$(362,0), (368,5), (381,2), (385,6), (396,1)\}$

$T'_{70} = \{(2,5), (19,1), (24,3), (35,13), (41,0), (47,0), (64,5), (79,1), (91,1), (103,3),$
$(107,5), (119,5), (143,2), (153,5), (168,0), (178,4), (192,8), (200,0), (229,1), (242,4),$
$(247,4), (254,4), (269,7), (281,2), (289,2), (305,3), (320,14), (328,6), (343,0), (352,11),$
$(359,1), (365,6), (378,5), (384,12), (393,3)\}$

$T'_{71} = \{(0,1), (14,5), (23,7), (32,1), (40,1), (46,1), (62,11), (77,7), (86,4), (95,4),$
$(106,8), (113,2), (135,1), (146,13), (164,6), (177,13), (190,4), (196,0), (215,4), (235,0),$
$(246,6), (253,4), (266,4), (274,4), (287,6), (304,1), (309,6), (327,7), (333,6), (351,1),$
$(357,2), (364,7), (374,0), (383,3), (390,3)\}$

$T'_{72} = \{(14,2), (26,2), (39,4), (48,3), (61,2), (67,14), (74,4), (89,6), (100,4), (122,4),$
$(128,0), (136,4), (148,4), (161,4), (174,1), (188,6), (202,0), (216,1), (223,3), (239,5),$
$(260,13), (272,5), (279,1), (287,0), (297,1), (307,5), (323,3), (332,1), (343,3), (352,1),$
$(357,0), (366,0), (380,1), (387,4), (398,5)\}$

$T'_{73} = \{(10,6), (24,7), (35,5), (47,7), (60,2), (66,5), (70,4), (79,2), (98,7), (114,0),$
$(125,14), (134,6), (146,5), (160,4), (173,0), (187,1), (200,7), (215,1), (222,5), (238,0),$
$(257,1), (268,1), (278,5), (285,3), (296,1), (305,5), (314,1), (329,0), (342,3), (349,1),$
$(356,9), (363,1), (378,5), (386,5), (396,5)\}$

$T'_{74} = \{(9,3), (23,7), (29,12), (43,3), (50,0), (65,0), (69,4), (76,2), (93,6), (106,1),$
$(124,14), (130,4), (143,5), (154,0), (170,4), (182,5), (192,1), (211,9), (221,1), (234,5),$
$(255,5), (267,7), (277,3), (283,6), (294,1), (304,0), (313,2), (328,2), (341,0), (348,1),$
$(354,1), (361,13), (375,0), (385,0), (393,7)\}$

$T'_{75} = \{(0,2), (17,6), (28,5), (41,5), (49,4), (62,4), (68,2), (75,6), (91,4), (103,4),$
$(123,6), (129,4), (137,4), (150,5), (164,0), (177,4), (191,0), (210,3), (220,0), (225,0),$
$(254,0), (261,7), (274,3), (281,1), (290,1), (303,1), (310,0), (326,1), (337,0), (344,1),$
$(353,2), (360,1), (370,5), (381,4), (392,6)\}$

$$T'_{76} = \{(9,8), (18,10), (25,5), (40,12), (49,1), (56,0), (61,10), (78,6), (96,0), (105,1),$$
$$(119,1), (129,0), (141,1), (153,4), (161,11), (179,11), (194,5), (201,13), (211,1),$$
$$(221,2), (237,8), (242,7), (251,7), (261,14), (274,0), (284,0), (299,5), (305,4), (314,13),$$
$$(339,7), (348,12), (355,1), (370,13), (381,11), (395,8)\}$$

$$T'_{77} = \{(8,4), (17,0), (23,13), (37,0), (46,1), (55,9), (60,4), (76,4), (91,8), (102,6),$$
$$(117,15), (127,15), (139,10), (151,9), (160,1), (172,2), (189,2), (200,7), (210,9),$$
$$(220,1), (236,7), (240,1), (250,5), (260,7), (270,9), (283,4), (296,11), (303,5), (312,4),$$
$$(333,6), (345,13), (354,0), (364,13), (380,4), (394,10)\}$$

$$T'_{78} = \{(5,12), (14,8), (21,9), (35,12), (42,0), (52,12), (59,14), (68,0), (89,6), (101,8),$$
$$(114,5), (123,5), (137,9), (149,4), (158,11), (169,12), (188,9), (198,1), (206,13),$$
$$(214,11), (234,1), (239,3), (248,13), (259,3), (269,5), (282,6), (295,3), (302,2), (310,9),$$
$$(332,12), (341,14), (352,12), (361,0), (379,12), (392,10)\}$$

$$T'_{79} = \{(0,4), (10,12), (20,4), (32,9), (41,8), (50,13), (57,6), (67,0), (83,0), (98,0),$$
$$(110,2), (121,10), (134,7), (148,13), (156,10), (166,1), (187,6), (197,0), (205,2),$$
$$(212,3), (222,1), (238,1), (245,13), (258,5), (263,13), (279,5), (291,5), (301,6), (306,5),$$
$$(324,5), (340,13), (349,0), (357,8), (372,14), (383,5)\} \ldots (32)$$

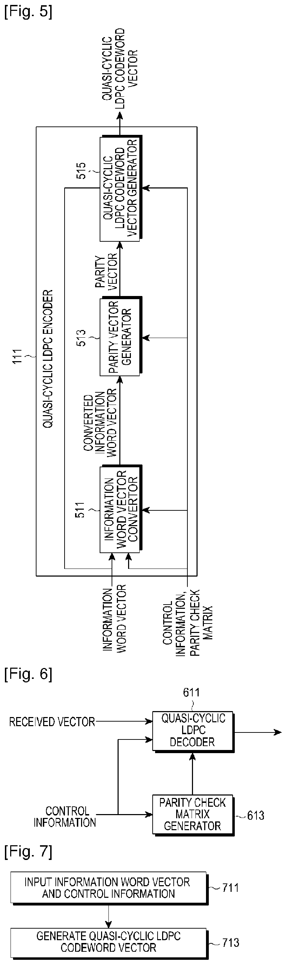

FIG. 5 is a block diagram illustrating a quasi-cyclic LDPC encoder according to an embodiment of the present invention.

Referring to FIG. 5, a quasi-cyclic LDPC encoder 111 includes an information word vector convertor 511, a parity vector generator 513, and a quasi-cyclic LDPC codeword vector generator 515.

Upon inputting an information word vector, the information word vector convertor 511 generates a converted information word vector by performing a conversion operation on the information word vector, based on control information and a parity check matrix, and outputs the converted information word vector to the parity vector generator 513. For example, the conversion operation may be a padding operation in which zeros are inserted into the information word vector, based on the control information and the parity check matrix.

The parity vector generator 513 converts the information word vector output from the information word vector convertor 511 into a parity vector based on the control information and the parity check matrix, and outputs the parity vector to the quasi-cyclic LDPC codeword vector generator 515. The quasi-cyclic LDPC codeword vector generator 515 generates a quasi-cyclic LDPC codeword vector by concatenating the parity vector and the information word vector, based on the control information.

Alternatively, the quasi-cyclic LDPC codeword vector generator 515 may generate the quasi-cyclic LDPC codeword vector by concatenating a converted parity vector and the information word vector. The converted parity vector is generated by puncturing the parity vector.

FIG. 6 is a block diagram illustrating a quasi-cyclic LDPC code decoder included in a signal reception apparatus in an MMT system according to an embodiment of the present invention.

Referring to FIG. 6, a quasi-cyclic LDPC code decoder includes a quasi-cyclic LDPC decoder 611 and a parity check matrix generator 613.

A received vector is input to the quasi-cyclic LDPC decoder 611. For example, the received vector may be a quasi-cyclic LDPC vector output from a quasi-cyclic LDPC encoder. Control information including (k,n,m) information is input to the quasi-cyclic LDPC decoder 111. The control information is described before, so the detailed description will be omitted herein.

The parity check matrix generator 613 also inputs the control information, converts a prestored base matrix into a parity check matrix, based on the control information, and outputs the parity check matrix to the quasi-cyclic LDPC decoder 611.

The quasi-cyclic LDPC decoder 611 generates a recovered information vector by quasi-cyclic LDPC decoding the received vector, based on the control information.

Although FIG. 6 illustrates the parity check matrix generator 613 generating the parity check matrix and outputting the parity check matrix to the quasi-cyclic LDPC decoder 611, alternatively, the quasi-cyclic LDPC decoder 611 may prestore the parity check matrix, and in this case, the parity check matrix generator 613 is not utilized.

Although FIG. 6 illustrates the control information being input from the outside to the quasi-cyclic LDPC decoder 611 and the parity check matrix generator 613, alternatively, the quasi-cyclic LDPC decoder 611 and the parity check matrix generator 613 may prestore the control information.

While the quasi-cyclic LDPC decoder 611 and the parity check matrix generator 613 are illustrated in FIG. 6 as separate units, alternatively, these components may be incorporated into a single unit.

Although not illustrated, the signal reception apparatus includes the quasi-cyclic LDPC code decoder and a receiver, and the quasi-cyclic LDPC code decoder and the receiver may be incorporated into a single unit.

FIG. 7 is a flow chart illustrating an operation process of a quasi-cyclic LDPC code generator included in a signal transmission apparatus in an MMT system according to an embodiment of the present invention.

Referring to FIG. 7, in step 711, a quasi-cyclic LDPC code generator receives an information word vector and control information. In step 713, the quasi-cyclic LDPC code generator generates a quasi-cyclic LDPC codeword vector by performing a quasi-cyclic LDPC encoding operation on the information word vector, based on the control information. The quasi-cyclic LDPC codeword vector includes an information word vector including k information word symbols and a parity vector including m parity symbols.

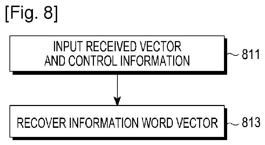

FIG. 8 is a flow chart illustrating an operation process of a quasi-cyclic LDPC code decoder included in a signal reception apparatus in an MMT system according to an embodiment of the present invention.

Referring to FIG. 8, in step 811, a quasi-cyclic LDPC code decoder receives a received vector and control information. In step 813, the quasi-cyclic LDPC code decoder recovers an information word vector by quasi-cyclic LDPC decoding the received vector using the control information and a parity check matrix.

While the present invention has been shown and described with reference to certain embodiments thereof, it will be understood by those skilled in the art that various changes in form and details may be made therein without departing from the scope of the present invention as defined by the appended claims and their equivalents.

**Claims**

1. A method for transmitting a low density parity check, LDPC, codeword by a signal transmission apparatus in a multimedia communication system, comprising:

   generating an LDPC codeword comprising k information symbols and m parity symbols; and
   transmitting the LDPC codeword ,
   wherein the LDPC codeword is generated using a resulting parity check matrix which is generated by performing a scaling operation and a row separation operation on a quasi-cyclic parent parity check matrix, wherein the parent parity check matrix includes K x L columns and M x L rows, and is generated by substituting one of an L x L permutation matrix and an L x L zero matrix for each element included in a base matrix including K columns corresponding to information symbol blocks and M rows,
   wherein the scaling operation is an operation in which the size of the permutation matrices and zero matrices included in the parent parity check matrix is changed using a scaling factor S1 to L/S1 x L/S1, wherein S1 is a maximum integer power of 2 satisfying $k \leq (K \times L/S1)$,
   wherein the row separation operation is an operation in which each block of L/S1 rows included in the scaled parent parity check matrix is separated into a number, indicated by separation factor S2, of blocks of L/S1 rows, wherein S2=ceil(m/((M x L)/S1)).

2. The method of claim 1, wherein the scaled parent parity check matrix is represented as a sequence of pairs ($t_{i,j}$, $e_{i,j}$), where $t_{ij}$ denotes a j-th location of a permutation matrix included in the i-th block of L/S1 rows among permutation matrices included in the scaled parent parity check matrix, and $e_{ij}$ is an exponent of the permutation matrix arrayed on a location which $t_{ij}$ denotes,
   wherein an $(S2 \times i + j)$-th block of L/S1 rows of the resulting parity check matrix is expressed as:

$$T'_{(S2\times i)+j} = \{(t_{i,k}, e_{i,k}) \mid k \bmod S2 = (S2 - 1 - j), 0 \le k < \mathrm{Di}\}$$

where Di denotes the number of permutation matrices included in the i-th block of L/S1 rows of the scaled parent parity check matrix.

3. A method for receiving a low density parity check, LDPC, codeword by a signal reception apparatus in a multimedia communication system, comprising:

receiving an LDPC codeword comprising k information symbols and m parity symbols; and
recovering an information word vector by decoding the LDPC codeword using a resulting parity check matrix, wherein the resulting parity check matrix is generated by performing a scaling operation and a row separation operation on a quasi-cyclic parent parity check matrix, wherein the parent parity check matrix includes K x L columns and M x L rows, and is generated by substituting one of an L x L permutation matrix and an L x L zero matrix for each element included in a base matrix including K columns corresponding to information symbol blocks and M rows,
wherein the scaling operation is an operation in which the size of the permutation matrices and zero matrices included in the parent parity check matrix is changed using a scaling factor S1 to L/S1 x L/S1, wherein S1 is a maximum integer power of 2 satisfying k $\le$ (K x L/S1),
wherein the row separation operation is an operation in which each block of L/S1 rows included in the scaled parent base parity check matrix is separated into a number, indicated by separation factor S2, of blocks of L/S1 rows,
wherein S2=ceil(m/((M x L)/S1)).

4. The method of claim 3, wherein the scaled parent parity check matrix is represented as a sequence of pairs ($t_{i,j}$, $e_{i,j}$), where $t_{i,j}$ denotes a j-th location of a permutation matrix included in the i-th block of L/S1 rows among permutation matrices included in the scaled parent parity check matrix, and $e_{i,j}$ is an exponent of the permutation matrix arrayed on a location which indicates $t_{i,j}$,
wherein an $(S2 \times i + j)$-th block of L/S1 rows of the resulting parity check matrix is expressed as:

$$T'_{(S2\times i)+j} = \{(t_{i,k}, e_{i,k}) \mid k \bmod S2 = (S2 - 1 - j), 0 \le k < \mathrm{Di}\}$$

where Di denotes the number of permutation matrices included in the i-th block of L/S1 rows of the parent parity check matrix.

5. A signal transmission apparatus adapted to perform the method of one of claims 1 to 2.

6. A signal reception apparatus adapted to perform the method of one of claims 3 to 4.

**Patentansprüche**

1. Verfahren zur Übertragung eines Low-Density-Parity-Check-, LDPC, -Codeworts durch eine Signalübertragungsvorrichtung in einem Multimedienkommunikationssystem, umfassend:

Erzeugen eines LDPC-Codeworts, umfassend k Informationssymbole und m Paritätssymbole; und
Übertragen des LDPC-Codeworts,
wobei das LDPC-Codewort unter Verwendung einer resultierenden Paritätsprüfmatrix generiert wird, die durch Ausführen einer Skalierungsoperation und einer Zeilenteilungsoperation auf einer quasizyklischen übergeordneten Prüfmatrix generiert wird, wobei die Paritätsprüfmatrix K x L Spalten und M x L Zeilen enthält und durch Substituieren einer von einer L x L Permutationsmatrix und einer L x L Nullmatrix für jedes Element, das in einer Basismatrix enthalten ist, die K Spalten entsprechend Informationssymbolblöcken und M Zeilen enthält, generiert wird,
wobei die Skalierungsoperation eine Operation ist, in der die Größe der Permutationsmatrizen und Nullmatrizen, die in der übergeordneten Paritätsprüfmatrix enthalten sind, unter Verwendung eines Skalierungsfaktors S1 bis L/S1 x L/S1 geändert wird, wobei S1 eine maximale ganzzahlige Potenz von 2 ist, die $k \le$ (K x L/S1) erfüllt,

wobei die Zeilenteilungsoperation eine Operation ist, in der jeder Block von L/S1 Zeilen, der in der skalierten übergeordneten Paritätsprüfmatrix enthalten ist, in eine Anzahl, die durch Teilungsfaktor S2 angezeigt ist, an Blöcken von L/S1 Zeilen geteilt wird,
wobei S2=ceil(m/((M x L)/S1)) ist.

2. Verfahren nach Anspruch 1, wobei die skalierte übergeordnete Paritätsprüfmatrix als eine Sequenz von Paaren ($t_{ij}$, $e_{ij}$) dargestellt ist, wo $t_{ij}$ eine j-te Stelle einer Permutationsmatrix bezeichnet, die im i-ten Block von L/S1 Zeilen unter Permutationsmatrizen, die in der skalierten übergeordneten Paritätsprüfmatrix enthalten sind, enthalten ist, und $e_{ij}$ ein Exponent der Permutationsmatrix ist, die an einer Stelle, die $t_{ij}$ bezeichnet, angeordnet ist,
wobei ein *(S2 $\times$ i + j)*-ter Block von L/S1 Zeilen der resultierenden Paritätsprüfmatrix ausgedrückt ist als:

$$T'_{(S2 \times i)+j} = \{(t_{i,k}, e_{i,k}) | k \bmod S2 = (S2 - 1 - j), 0 \leq k < Di\}$$

wo Di die Anzahl an Permutationsmatrizen bezeichnet, die im i-ten Block von L/S1 Zeilen der skalierten übergeordneten Paritätsprüfmatrix enthalten sind.

3. Verfahren zum Empfangen eines Low-Density-Parity-Check-, LDPC, -Codeworts durch eine Signalempfangsvorrichtung in einem Multimedienkommunikationssystem, umfassend:

Empfangen eines LDPC-Codeworts, umfassend k Informationssymbole und m Paritätssymbole; und
Wiederherstellen eines Informationswortvektors durch Entschlüsseln des LDPC-Codeworts unter Verwendung einer resultierenden Paritätsprüfmatrix,
wobei die resultierende Paritätsprüfmatrix durch Ausführen einer Skalierungsoperation und einer Zeilenteilungsoperation auf einer quasizyklischen übergeordneten Paritätsprüfmatrix generiert wird,
wobei die übergeordnete Paritätsprüfmatrix K x L Spalten und M x L Zeilen enthält und durch Substituieren einer von einer L x L Permutationsmatrix und einer L x L Nullmatrix für jedes Element, das in einer Basismatrix enthalten ist, die K Spalten entsprechend Informationssymbolblöcken und M Zeilen enthält, generiert wird,
wobei die Skalierungsoperation eine Operation ist, in der die Größe der Permutationsmatrizen und Nullmatrizen, die in der übergeordneten Paritätsprüfmatrix enthalten sind, unter Verwendung eines Skalierungsfaktors S1 bis L/S1 x L/S1 geändert wird, wobei S1 eine maximale ganzzahlige Potenz von 2 ist, die $k \leq$ (K x L/S1) erfüllt,
wobei die Zeilenteilungsoperation eine Operation ist, in der jeder Block von L/S1 Zeilen, der in der skalierten übergeordneten Paritätsprüfmatrix enthalten ist, in eine Anzahl, die durch Teilungsfaktor S2 angezeigt ist, an Blöcken von L/S1 Zeilen geteilt ist,
wobei S2=ceil(m/((M x L)/S1)) ist.

4. Verfahren nach Anspruch 3, wobei die skalierte übergeordnete Paritätsprüfmatrix als eine Sequenz von Paaren ($t_{ij}$, $e_{ij}$) dargestellt ist, wo $t_{ij}$ eine j-te Stelle einer Permutationsmatrix bezeichnet, die im i-ten Block von L/S1 Zeilen unter Permutationsmatrizen, die in der skalierten übergeordneten Paritätsprüfmatrix enthalten sind, enthalten ist, und $e_{ij}$ ein Exponent der Permutationsmatrix ist, die an einer Stelle, die $t_{ij}$ anzeigt, angeordnet ist,
wobei ein *(S2 $\times$ i + j)*-ter Block von L/S1 Zeilen der resultierenden Paritätsprüfmatrix ausgedrückt ist als:

$$T'_{(S2 \times i)+j} = \{(t_{i,k}, e_{i,k}) | k \bmod S2 = (S2 - 1 - j), 0 \leq k < Di\}$$

wo Di die Zahl an Permutationsmatrizen bezeichnet, die im i-ten Block von L/S1 Zeilen der skalierten übergeordneten Paritätsprüfmatrix enthalten sind.

5. Signalübertragungsvorrichtung, die angepasst ist, das Verfahren nach einem der Ansprüche 1 bis 2 auszuführen.

6. Signalempfangsvorrichtung, die angepasst ist, das Verfahren nach einem der Ansprüche 3 bis 4 auszuführen.

**Revendications**

1. Procédé de transmission d'un mot de code de vérification de parité à faible densité, LDPC, par un dispositif de transmission de signal dans un système de communication multimédia comprenant de :

générer un mot de code LDPC comprenant k symboles d'information et m symboles de parité ; et
transmettre le mot de code LDPC,
dans lequel le mot de code LDPC est généré en utilisant une matrice de vérification de parité de résultat qui est générée en effectuant une opération de mise à l'échelle et une opération de séparation de rangées sur une matrice de vérification de parité parente quasi cyclique, dans lequel la matrice de vérification de parité parente inclut KxL colonnes et MxL rangées et est générée en substituant une d'une matrice de permutation LxL et une matrice de zéro LxL pour chaque élément inclus dans une matrice de base incluant K colonnes correspondant aux blocs de symboles d'information et M rangées,
dans lequel l'opération de mise à l'échelle est une opération dans laquelle la taille des matrices de permutation et des matrices zéro incluses dans la matrice de vérification de parité parente est changée en utilisant un facteur de mise à l'échelle S1 à L/S1 à L/S1, dans lequel S1 et une puissance d'entier maximal de 2 satisfaisant k ≤ (KxL/S1),
dans lequel l'opération de séparation de rangées est une opération dans laquelle chaque bloc de rangées L/S1 incluses dans la matrice de vérification de parité parente mise à l'échelle est séparée en un nombre, indiqué par le facteur de séparation S2, de blocs de rangées L/S1,
dans lequel S2=ceil(m/((M x L)/S1))

2. Procédé selon la revendication 1, dans lequel la matrice de vérification de parité parentale mise à l'échelle est représentée comme une séquence de paires ($t_{i,j}$, $e_{i,j}$), où ti,j dénote un j-ème emplacement d'une matrice de permutation incluse dans le i-ème blocs de rangées de L/S1 parmi les matrices de permutation incluses dans la matrice de vérification de parité parente mise à l'échelle et ei,j est un exposant de la matrice de permutation déployée sur un emplacement que ti,j dénote,
dans lequel un *(S2* x *i + j)*-ème bloc de rangées L/S1 de la matrice de vérification de parité de résultat est exprimé comme :

```
T'(s2xi)+j = {(hk, ei,k) I kmod S2 = (S2 - 1 -y), 0 <
k< Di}
```

où Di dénote le nombre de matrices de permutation incluses dans le i-ème bloc de L/S1 rangées de la matrice de vérification de parité parente mise à l'échelle.

3. Procédé de réception d'un mot de code de vérification de parité à faible densité, LDPC, par un dispositif de réception de signal dans un système de communication multimédia, comprenant de :

recevoir un mot de code LDPC comprenant k symboles d'information et m symboles de parité ; et
récupérer un vecteur de mots d'information en décodant le mot de code LDPC en utilisant une matrice de vérification de parité de résultat,
dans lequel la matrice de vérification de parité de résultat est générée en effectuant une opération de mise à l'échelle et une opération de séparation de rangées sur une matrice de vérification de parité parente quasi cyclique, dans lequel la matrice de vérification de parité parente inclut K x L colonnes et M x L rangées et est générée en substituant une d'une matrice de permutation L x L et une matrice de zéro L x L pour chaque élément inclus dans une matrice de base incluant K colonnes correspondant aux blocs de symboles d'information et M rangées,
dans lequel l'opération de mise à l'échelle set une opération dans laquelle la taille des matrices de permutation et des matrices zéro incluses dans la matrice de vérification de parité parente est changée en utilisant un facteur de mise à l'échelle S1 à L/S1 à L/S1, dans lequel S1 et une puissance d'entier maximal de 2 satisfaisant k ≤ (KxL/S1),
dans lequel l'opération de séparation de rangées est une opération dans laquelle chaque bloc de rangées L/S1 incluses dans la matrice de vérification de parité parente mise à l'échelle est séparé en un nombre, indiqué par le facteur de séparation S2, de blocs de rangées L/S1,
dans lequel S2=ceil(m/((M x L)/S 1))

4. Procédé selon la revendication 3, dans lequel la matrice de vérification de parité parentale mise à l'échelle est représentée comme une séquence de paires ($t_{i,j}$, $e_{i,j}$), où ti,j dénote un j-ème emplacement d'une matrice de permutation incluse dans le i-ème bloc de rangées de L/S1 parmi les matrices de permutation incluses dans la matrice de vérification de parité parente mise à l'échelle et ei,j est un exposant de la matrice de permutation déployée sur un emplacement que ti,j dénote,

dans lequel un *(S2* x *i + j)*-ème bloc de rangées L/S1 de la matrice de vérification de parité de résultat est exprimé comme :

```
T'(s2xi)+j = {(hk, ei,k) I kmod S2 = (S2 - 1 -y), 0 <
k< Di}
```

où Di dénote le nombre de matrices de permutation incluses dans le i-ème bloc de L/S1 rangées de la matrice de vérification de parité parente mise à l'échelle.

5. Dispositif de transmission de signal adapté pour mettre en oeuvre le procédé selon une des revendications 1 à 2.

6. Dispositif de réception de signal adapté pour mettre en oeuvre le procédé selon une des revendications 3 à 4.

[Fig. 1]

[Fig. 2]

[Fig. 3]

$c_0$ $c_1$ $c_2$ $c_3$ $c_4$ $c_5$ $c_6$ $c_7$ $c_8$ $c_9$

0 −1 0 −1 3 −1 3 −1 −1 −1    $T_0 = \{(0, 0), (2, 0), (4, 3), (6, 3)\}$

$c'_0$ $c'_1$ $c'_2$ $c'_3$ $c'_4$ $c'_5$ $c'_6$ $c'_7$ $c'_8$ $c'_9$

0 −1 −1 −1 3 −1 −1 −1 −1 −1    $T'_0 = \{(0, 0), (4, 3)\}$
−1 −1 0 −1 −1 −1 3 −1 −1 −1    $T'_1 = \{(2, 0), (6, 3)\}$

[Fig. 4]

$c_0$ $c_1$ $c_2$ $c_3$ $c_4$ $c_5$ $c_6$ $c_7$ $c_8$ $c_9$

0 −1 0 −1 3 −1 3 −1 −1 −1    $T_0 = \{(0, 0), (2, 0), (4, 3), (6, 3)\}$
−1 2 −1 2 −1 1 −1 1 −1 0    $T_1 = \{(1, 2), (3, 2), (5, 1), (7, 1), (9, 0)\}$

$c'_0$ $c'_1$ $c'_2$ $c'_3$ $c'_4$ $c'_5$ $c'_6$ $c'_7$ $c'_8$ $c'_9$

0 2 0 2 3 1 3 1 −1 0    $T'_0 = \{(0, 0), (1, 2), (2, 0), (3, 2), (4, 3),$
                                    $(5, 1), (6, 3), (7, 1), (9, 0)\}$

[Fig. 5]

[Fig. 6]

[Fig. 7]

[Fig. 8]

| INPUT RECEIVED VECTOR AND CONTROL INFORMATION | ~811 |
|---|---|

↓

| RECOVER INFORMATION WORD VECTOR | ~813 |
|---|---|

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **HYEONG-GUN JOO et al.** New Construction of Rate-Compatible Block-Type Low-Density Parity-Check Codes Using Splitting. *PROC. IEEE 17TH INTERNATIONAL SYMPOSIUM ON PERSONAL, INDOOR AND MOBILE RADIO COMMUNICATIONS 2006,* 01 September 2006

- **JONG-EE OH et al.** Row-splitting design of Low-Density Parity-Check Codes for Gbps wireless transmission. *PROC. 2ND INTERNATIONAL CONFERENCE ON WIRELESS BROADBAND AND ULTRA WIDEBAND COMMUNICATIONS 2007,* 01 August 2007

- **NICOLA MOSCHINI et al.** STMicroelectronics LD-PCC Proposal for802.1 In CFP. *INTERNET CITATION,* 13 August 2004

- Multiple rate low-density parity-check codes with constant blocklength. **VILA CASADO A I et al.** CONFERENCE RECORD OF THE THIRTY- EIGHTH ASILOMAR CONFERENCE ON SIGNALS, SYSTEMS AND COMPUTERS, PACIFIC GROVE, CA, USA NOV. 7-10, 2004. IEEE, 07 November 2004, vol. 2